# EUROPÄISCHE PATENTSCHRIFT

(11) **EP 2 807 031 B1**
(45) Veröffentlichungstag und Bekanntmachung des Hinweises auf die Patenterteilung: **18.11.2015**
(21) Anmeldenummer: 13759133.5
(22) Anmeldetag: 19.07.2013
(51) Int. Cl.: B06B 1/06, B41J 2/14, H01L 27/20, H01L 41/047, H01L 41/083, H02N 2/02

(54) **AKTUATORVORRICHTUNG**
ACTUATOR DEVICE
DISPOSITIF ACTIONNEUR

(30) Priorität: 19.07.2012 DE 102012014247; 20.07.2012 DE 102012014442; 30.11.2012 DE 102012023521
(43) Veröffentlichungstag der Anmeldung: 03.12.2014
(73) Patentinhaber: Pi Ceramic GmbH Keramische Technologien und Bauelemente, 07589 Lederhose (DE)
(72) Erfinder: HENNIG, Eberhard, 07646 Mörsdorf (DE); KOPSCH, Daniel, 07570 Weida (DE)
(74) Vertreter: Schatt, Markus F.
(86) Internationale Anmeldenummer: PCT/EP2013/002149
(87) Internationale Veröffentlichungsnummer: WO 2014/012672

(56) Entgegenhaltungen:
- WO-A1-2013/171972
- US-A1- 2004 227 432
- US-A1- 2010 245 490

## Beschreibung

Die Erfindung betrifft eine Aktuatorvorrichtung.

Aus der US 5 144 342 A, der US 2919/245490 A1 und der US 2004/227432 A1 ist jeweils eine Aktuatorvorrichtung mit aus einem piezoelektrischen Material gebildeten Aktuatoren bekannt.

Die Aufgabe der Erfindung ist, eine Aktuatorvorrichtung mit aus einem piezoelektrischen Material gebildeten Aktuatoren bereitzustellen, die mit verschiedenen Herstellungsarten auf einfache und effektive Weise herstellbar ist und eine hohe Fertigungsqualität sowie Funktions-Sicherheit gewährleistet.

Diese Aufgabe wird mit den Merkmalen des Anspruchs 1 gelöst. Weitere Ausführungsformen sind in den auf diesen rückbezogenen Unteransprüchen angegeben.

Erfindungsgemäß ist insbesondere vorgesehen: eine Aktuatorvorrichtung mit einem Grundkörper aufweisend einen Basiskörper und einen Aufbaukörper, und sich der Grundkörper in einer Längsrichtung X, einer quer zur Längsrichtung X verlaufenden Tiefenrichtung Z und einer quer zu der Längsrichtung X und quer zu der Tiefenrichtung Z gerichteten Dickenrichtung Y erstreckt und der eine Vorderseite, eine in Bezug auf eine Längsrichtung X der Aktuatorvorrichtung entgegen gesetzt zu der Vorderseite gelegene Rückseite sowie zwei entgegen gesetzt zueinander gelegene und jeweils zwischen der Vorderseite und der Rückseite gelegene Stirnseiten hat, wobei die Aktuatorvorrichtung aufweist:
▪ eine Mehrzahl von Aktuatoren, die jeweils aus einem piezoelektrischen oder elektrostriktiven Material gebildet sind und sich jeweils in der Dickenrichtung Y von dem Basiskörper aus erstrecken und den Aufbaukörper bilden, und die Aktuatoren in der Längsrichtung X der Aktuatorvorrichtung hintereinander derart angeordnet sind, dass zwischen jeweils zwei benachbarten Aktuatoren eine Ausnehmung ausgebildet ist, wobei die Aktuatoren jeweils zumindest zwei innere Betätigungs-Elektroden aufweisen, von denen sich zumindest eine erste innere Betätigungs-Elektrode in positiver Tiefenrichtung Z von der Vorderseite bis zu einem Abstand zu der Rückseite hin erstreckt und von denen sich zumindest eine zweite innere Betätigungs-Elektrode in negativer Tiefenrichtung Z von der Rückseite bis zu einem Abstand zur Vorderseite hin erstreckt, wobei die zumindest eine erste innere Betätigungs-Elektrode jedes Aktuators zur elektrischen Verbindung mit einem ersten Anschlusspol einer Betätigungsvorrichtung vorgesehen ist,
▪ eine Rückseiten-Schicht, die aus elektrisch leitfähigem Material gebildet und auf der Rückseite der Aktuatorvorrichtung angeordnet sowie elektrisch mit der zumindest einen zweiten inneren Betätigungs-Elektrode der Aktuatoren verbunden ist,
▪ eine äußere Rückführungs-Verbindungsschicht, die auf einem Rückführungskörper des Grundkörpers angeordnet ist und die elektrisch mit der Rückseiten-Schicht verbunden ist,
▪ eine äußere Rückführungs-Anschlussbeschichtung an der Vorderseite der Aktuatorvorrichtung zur elektrischen Verbindung mit einem zweiten Anschlusspol der Betätigungsvorrichtung, wobei die äußere Rückführungs-Anschlussbeschichtung elektrisch mit der äußeren Rückführungs-Verbindungsschicht verbunden ist.

Dabei kann das Basismaterial von sämtlichen oder einer Mehrzahl von Aktuatoren jeweils aus einem piezoelektrischen oder elektrostriktiven Material besteht, also ausschließlich aus piezoelektrischen oder elektrostriktiven Material gebildet ist. Als Basismaterial wird hierbei das Material des Aktautors ohne dessen Elektroden verstanden.

Mit der erfindungsgemäßen Aktuatorvorrichtung ist es möglich, sowohl die zumindest eine erste innere Betätigungs-Elektrode und die zumindest eine zweite innere Betätigungs-Elektrode von der Vorderseite der Aktuatorvorrichtung her zu kontaktieren, wobei die erfindungsgemäße Aktuatorvorrichtung eine sehr effektive Rückführung elektrischer Leistung von der Vorderseite auf die Rückseite erlaubt.

Nach einer Ausführungsform der erfindungsgemäßen Aktuatorvorrichtung ist vorgesehen, dass die Aktuatorvorrichtung eine Aktuator-Anschlussbeschichtung aufweist, die mit der jeweiligen ersten inneren Betätigungs-Elektrode E1, E3 der Aktuatoren der Mehrzahl von Aktuatoren elektrisch verbunden ist und an die jeweils ein erster elektrischer Pol einer Mehrzahl von elektrischen Polen der Betätigungs-Vorrichtung zur unabhängigen Ansteuerung der einzelnen Aktuatoren anschließbar ist.

Nach einer Ausführungsform der erfindungsgemäßen Aktuatorvorrichtung ist vorgesehen, dass in dem Rückführungskörper innere Rückführungs-Elektroden angeordnet sind, von denen sich zumindest eine erste innere Rückführungs-Elektrode RE1, RE3 in positiver Tiefenrichtung Z von der Vorderseite bis zu einem Abstand zu der Rückseite hin erstreckt und von denen sich zumindest eine zweite innere Rückführungs-Elektrode RE2, RE4 in negativer Tiefenrichtung Z von der Rückseite bis zu einem Abstand zur Vorderseite hin erstreckt.

Nach einer Ausführungsform der erfindungsgemäßen Aktuatorvorrichtung ist vorgesehen, dass die Rückseiten-Schicht im Bereich des Basiskörpers des Grundkörpers eine größere Dicke in Tiefenrichtung Z hat als im Bereich des Aufbaukörpers, d.h. in dem Bereich, den die Aktuatoren an der Rückseite der Aktuatorvorrichtung ausbilden.

Nach einer Ausführungsform der erfindungsgemäßen Aktuatorvorrichtung ist vorgesehen, dass der Grundkörper mit dem Basiskörper und dem Aufbaukörper, welcher die Aktuatoren bildende Aktuator-Körper umfasst, einen monolithischen Körper bildet.

Nach einer Ausführungsform der erfindungsgemäßen Aktuatorvorrichtung ist vorgesehen, dass der Basiskörper und der Aufbaukörper des Grundkörpers jeweils als eigener Teilkörper gebildet ist.

Nach einer Ausführungsform der erfindungsgemäßen Aktuatorvorrichtung ist vorgesehen, dass der Basiskörper und der Aufbaukörper miteinander verklebt sind.

Nach einer Ausführungsform der erfindungsgemäßen Aktuatorvorrichtung ist vorgesehen, dass die Rückseiten-Schicht und die Rückführungs-Verbindungsschicht zusammen eine einstückige Schicht bilden.

Nach einer Ausführungsform der erfindungsgemäßen Aktuatorvorrichtung ist vorgesehen, dass die Aktuatorvorrichtung einen Basiskörper aufweist, von dem aus sich Aktuatoren-Körper bzw. die Aktuatoren erstrecken, und die sich so erstreckenden Aktuator-Körper bzw. Aktuatoren den Aufbaukörper bilden.

Dabei kann insbesondere vorgesehen sein, dass im Basiskörper zumindest eine vorzugsweise plattenförmige Schwindungsanpassungs-Elektrode gelegen ist, wobei zumindest eine Schwindungsanpassungs-Elektrode derart im Basiskörpergelegen ist, dass ein Randabschnitt derselben in jeder von zwei Rückführungsabschnitt-Oberflächen liegt, um ein lokales Schwindungsverhalten des Basiskörpers bei der Herstellung desselben auszugleichen.

Bei diesen Ausführungsformen kann insbesondere vorgesehen sein, dass eine an der Rückführungsabschnitt-Oberfläche anliegende Schwindungsanpassungs-Elektrode in der Tiefenrichtung gesehen sich von der Rückseite bis in den Bereich eines Rückführungs-Anschlussstücks erstreckt.

Weiterhin kann bei diesen Ausführungsformen insbesondere vorgesehen sein, dass die Rückführungsabschnitt-Oberfläche einen Stirnseiten-Schichtabschnitt mit einer entsprechenden Beschichtung aufweist.

Generell wird hierin unter dem Ausdruck einer "in eine Richtung weisende Oberfläche" wie z.B. "in die X-Richtung weisende Oberfläche" verstanden, dass die Flächen-Normale der jeweiligen Oberfläche in die genannte Richtung wie z.B. die X-Richtung weist oder in einem spitzen Winkel zu dieser verläuft.

Unter "Beschichtung" wird hierin - soweit keine andere Feststellung getroffen wird-generell verstanden, dass es sich um eine Beschichtung mit einer elektrisch leitfähigen Schicht handelt.

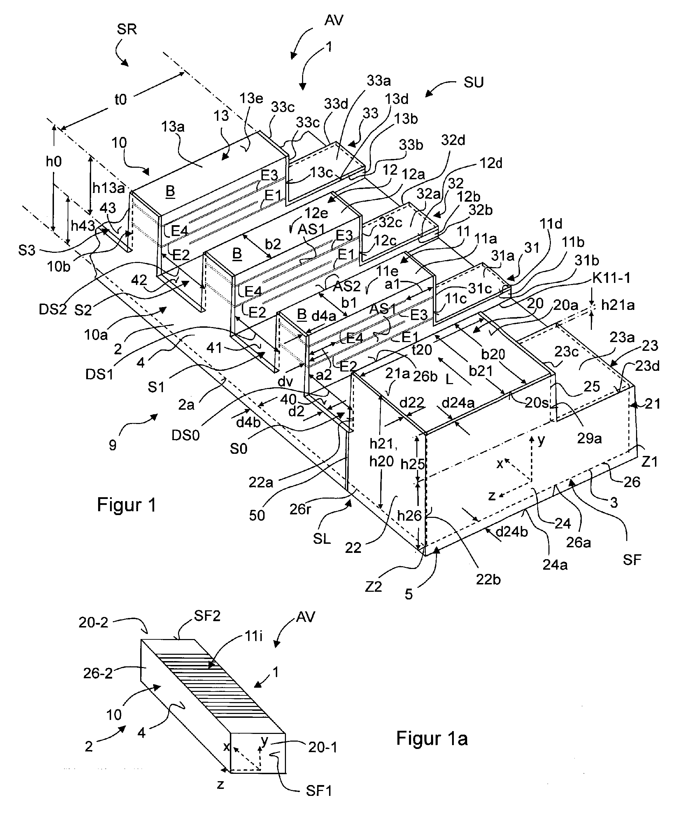

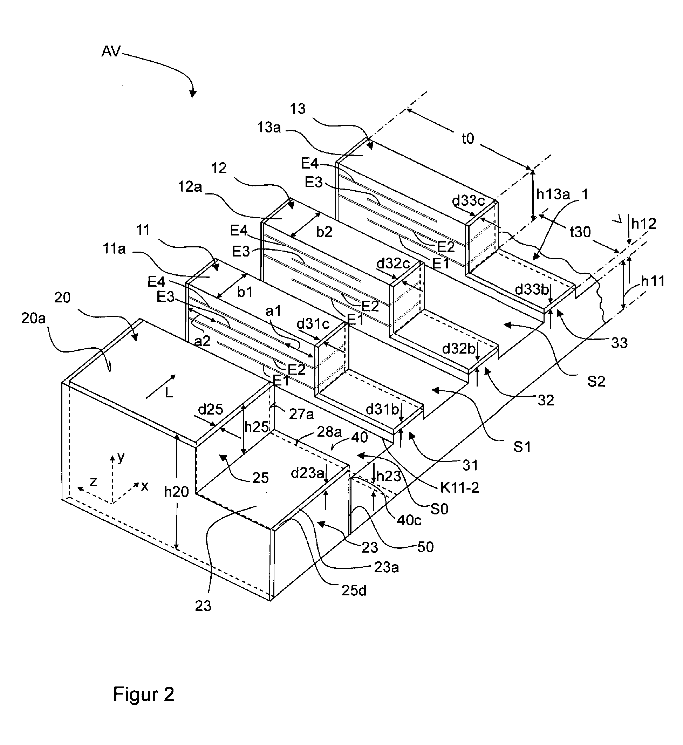

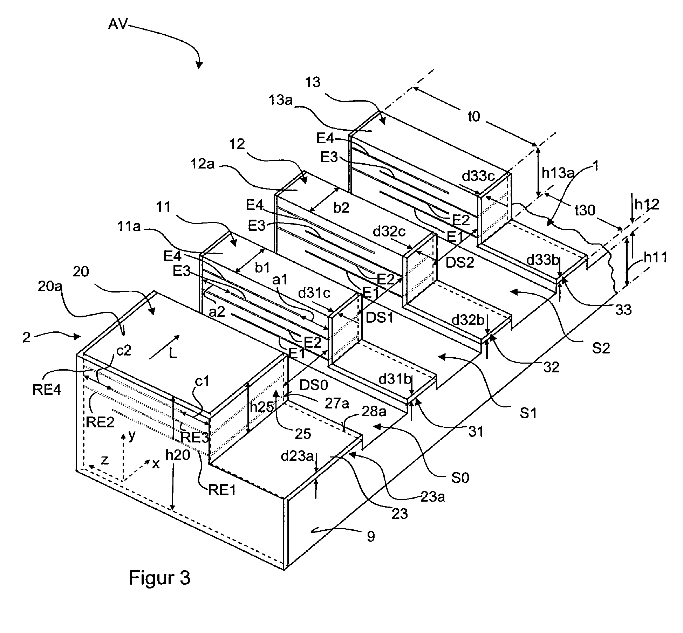

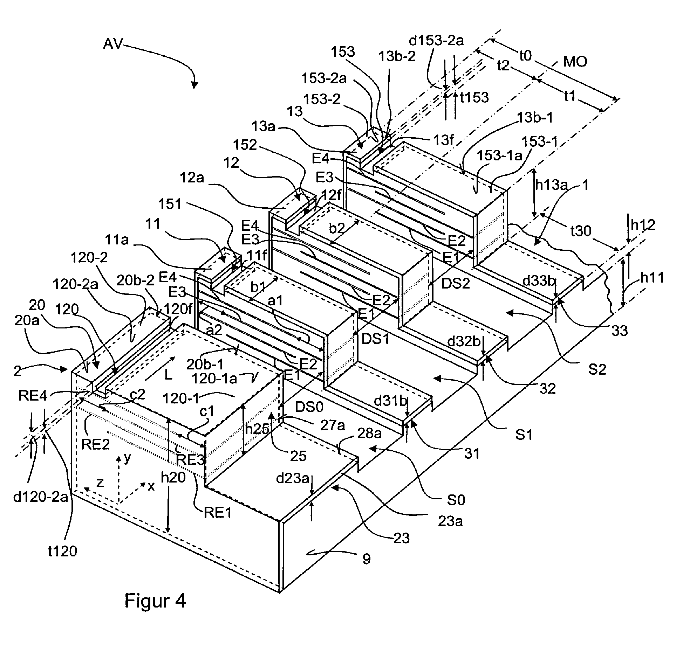

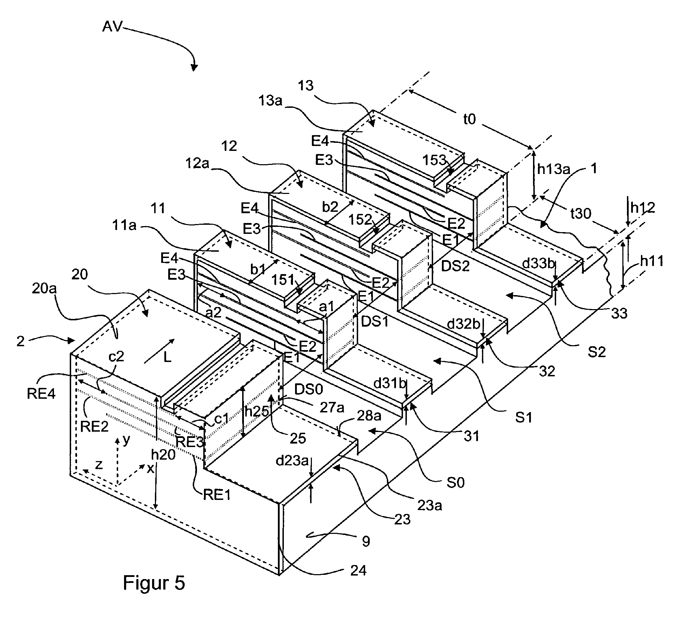

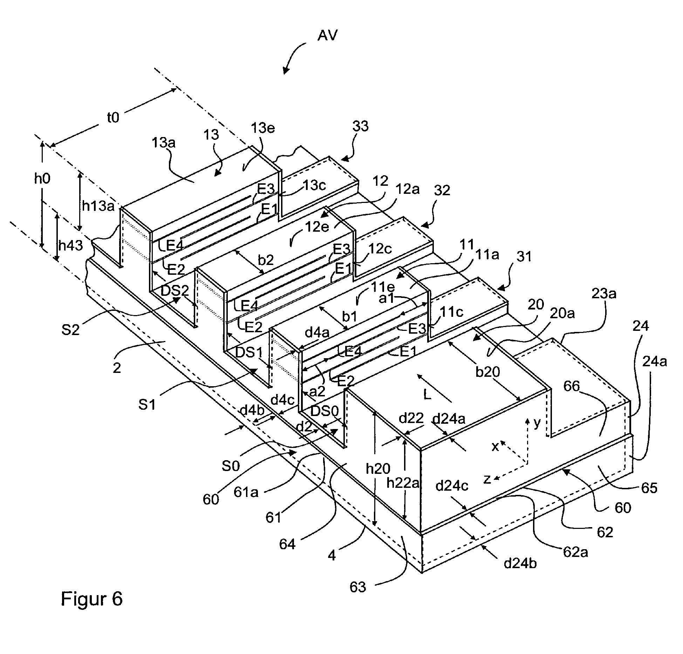

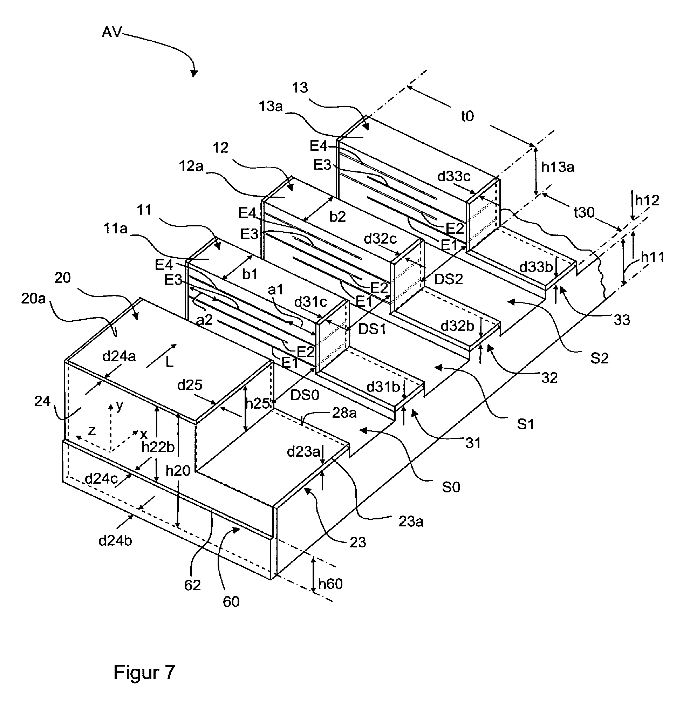

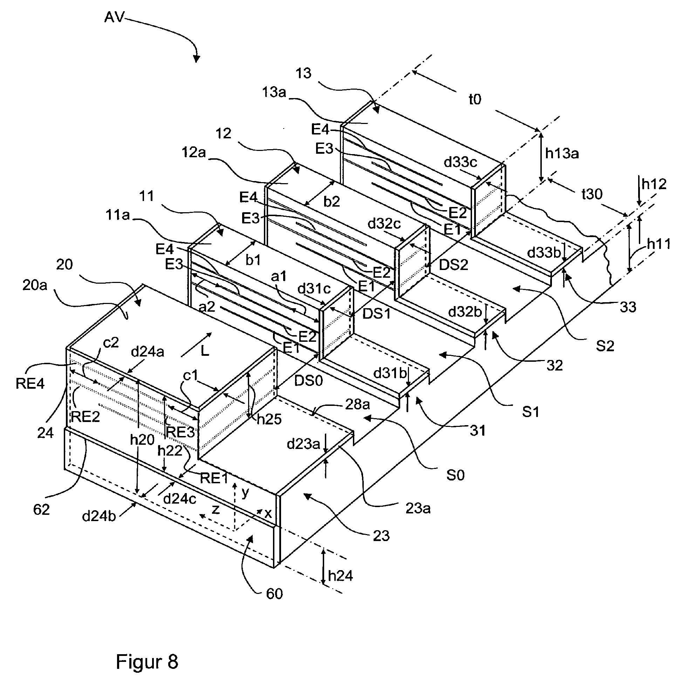

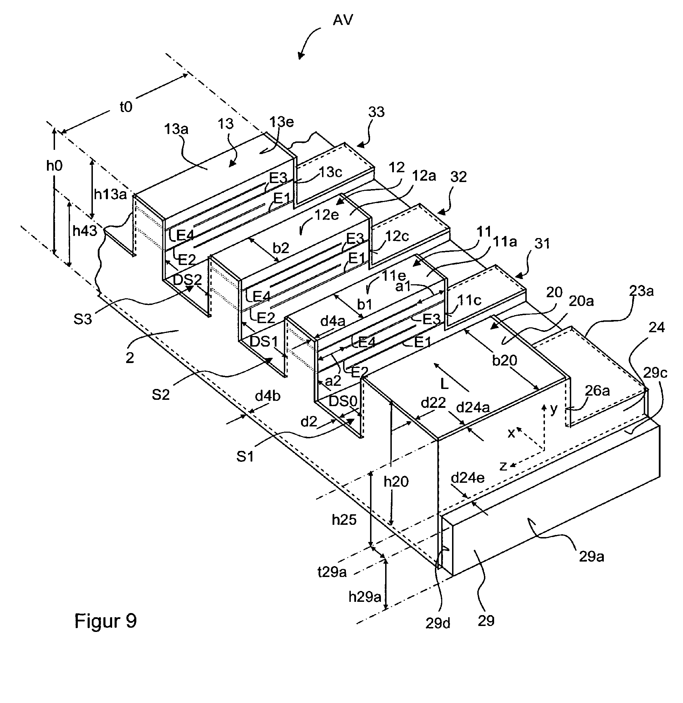

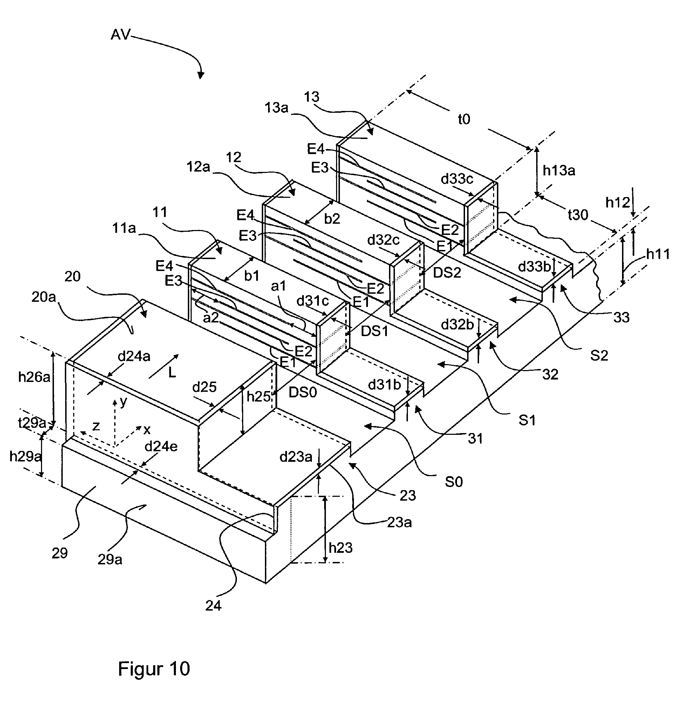

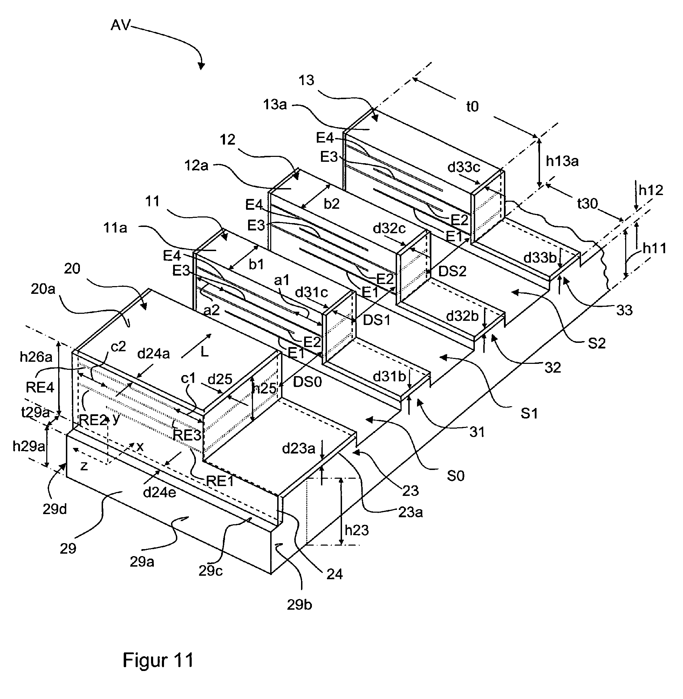

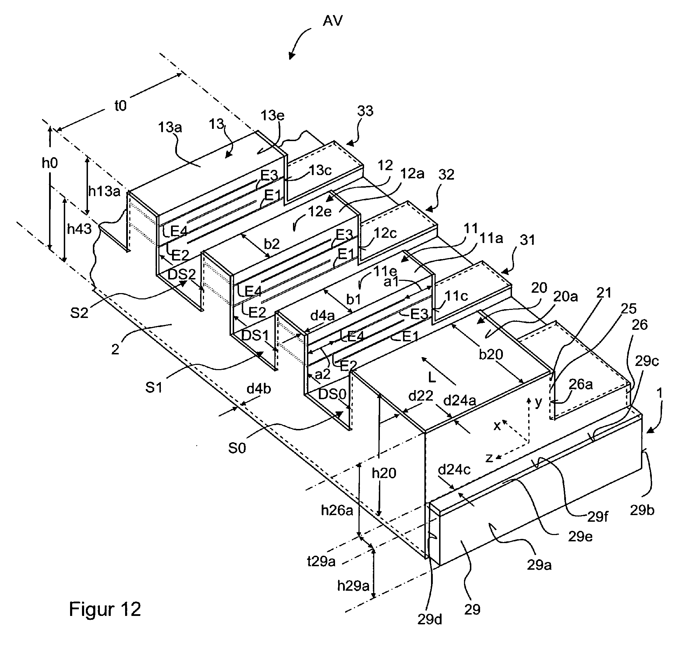

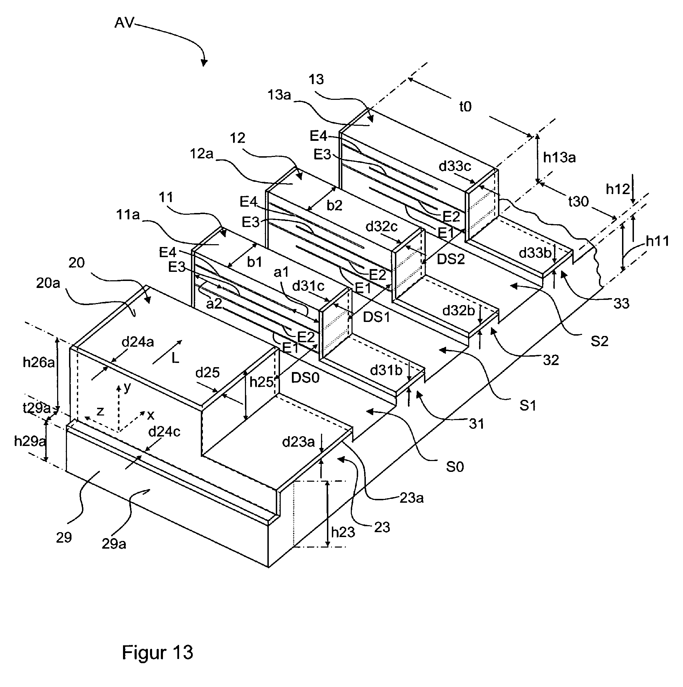

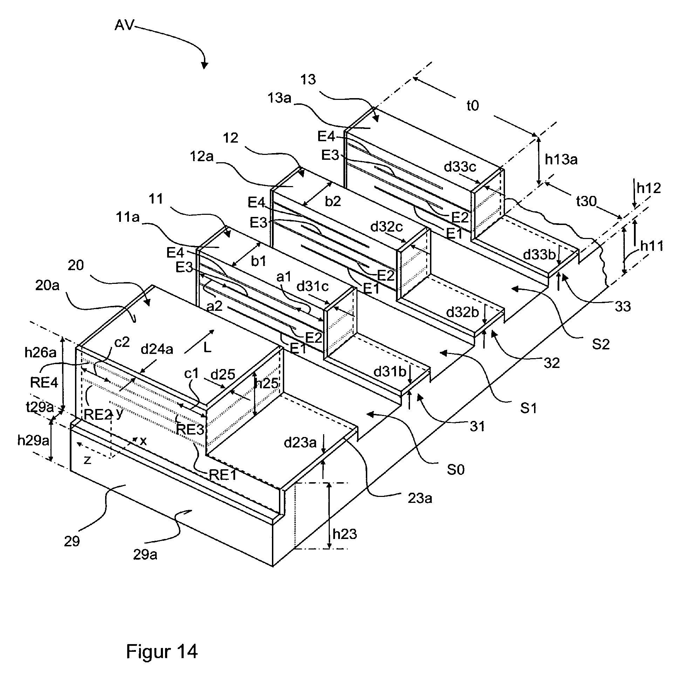

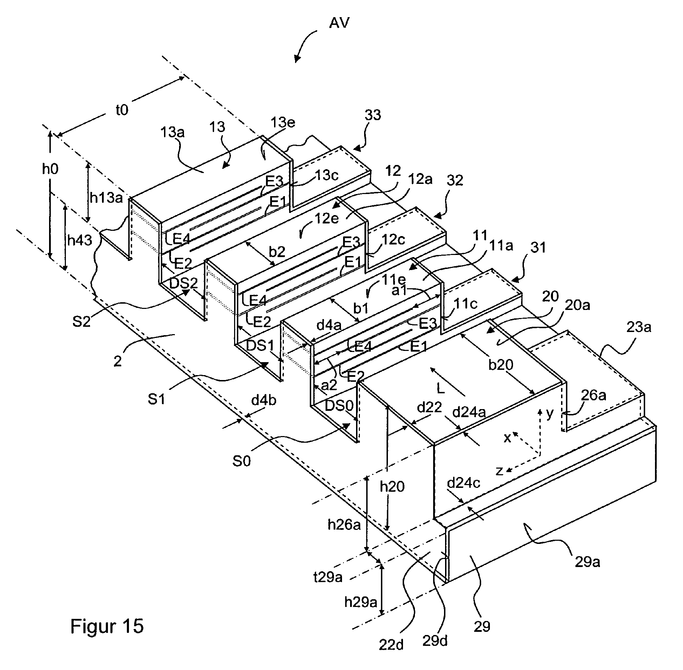

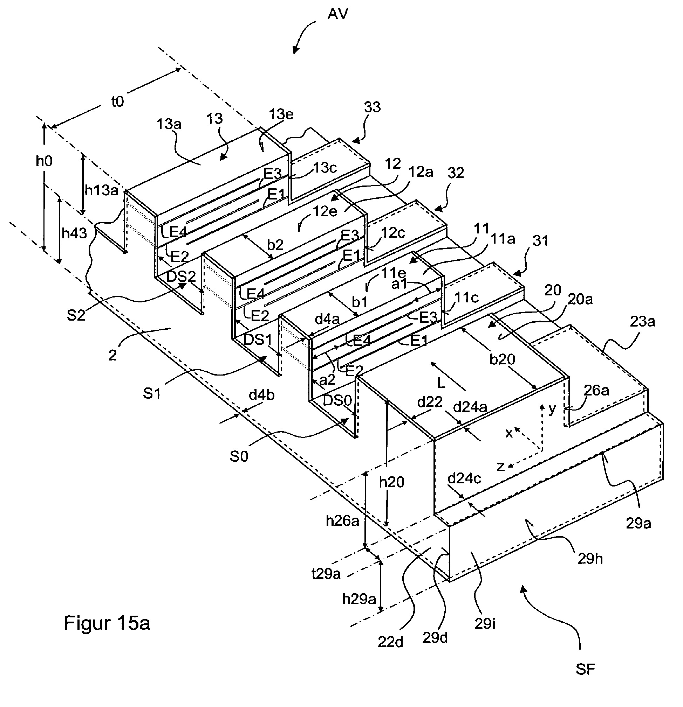

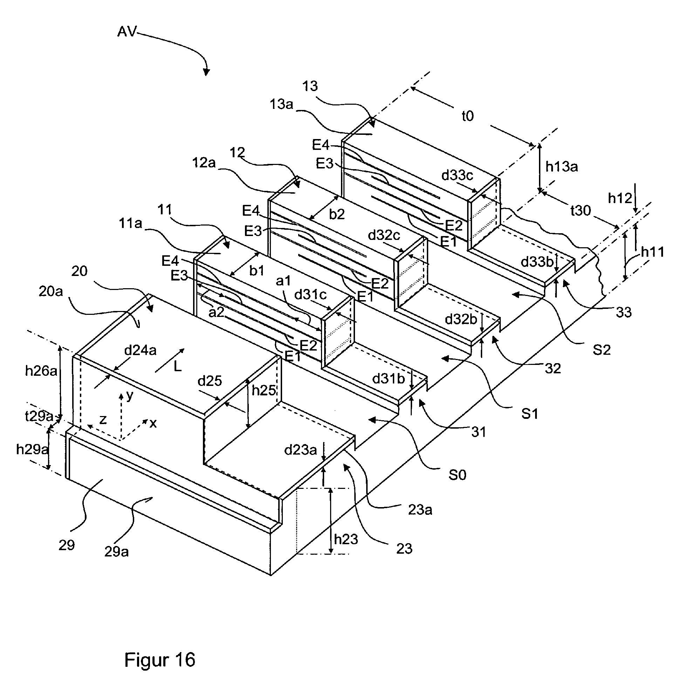

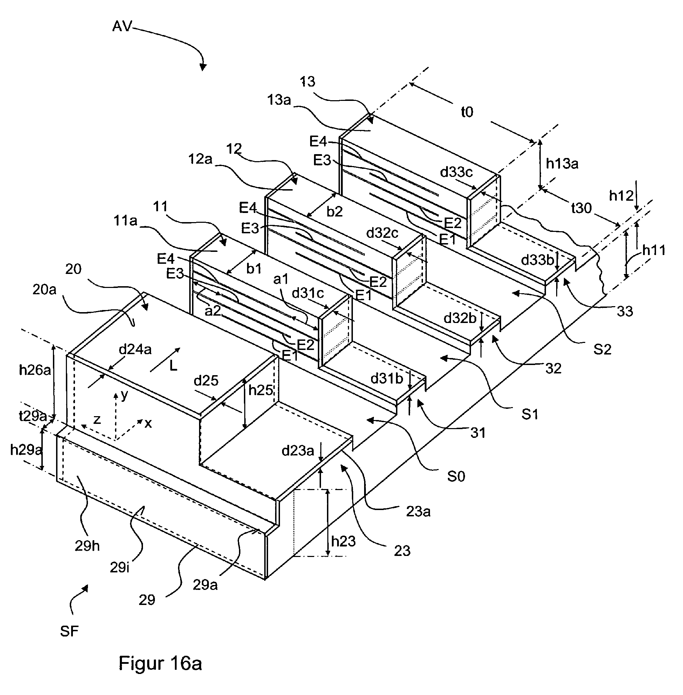

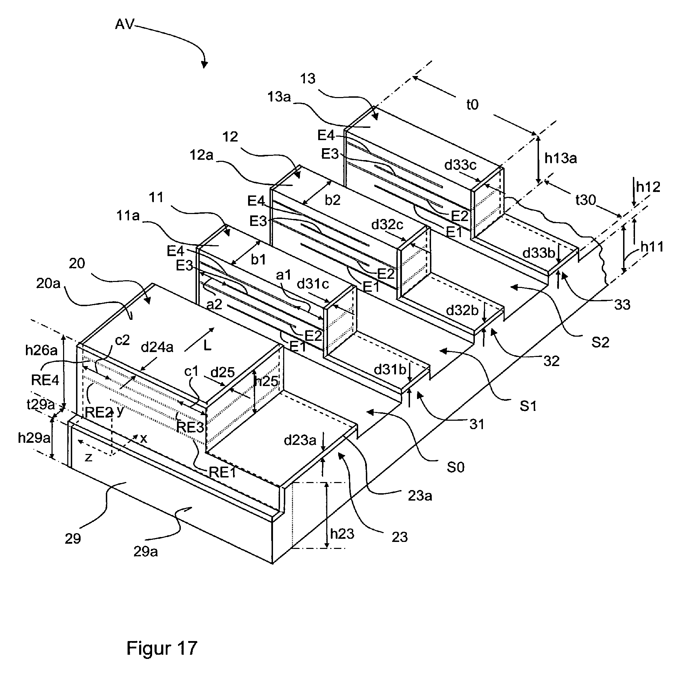

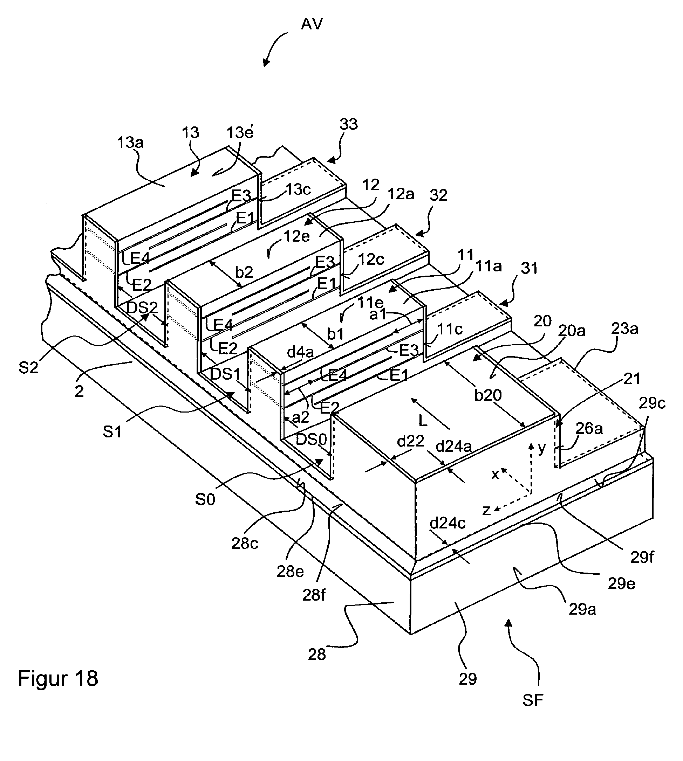

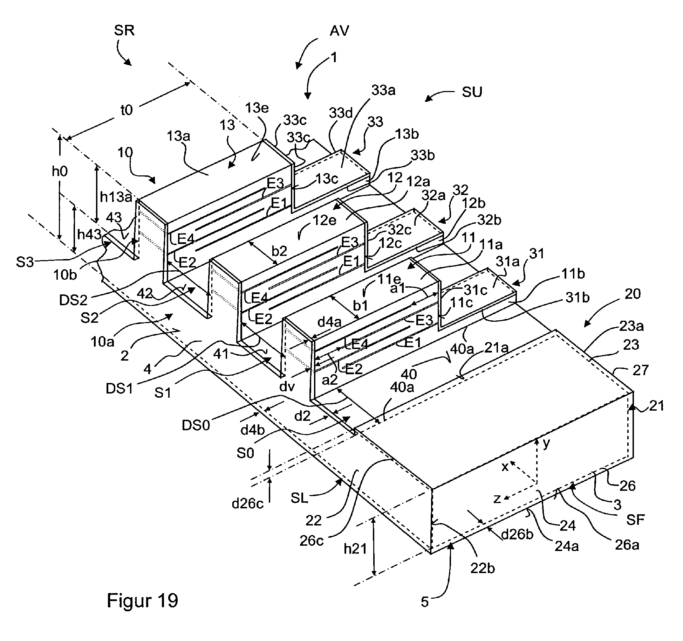

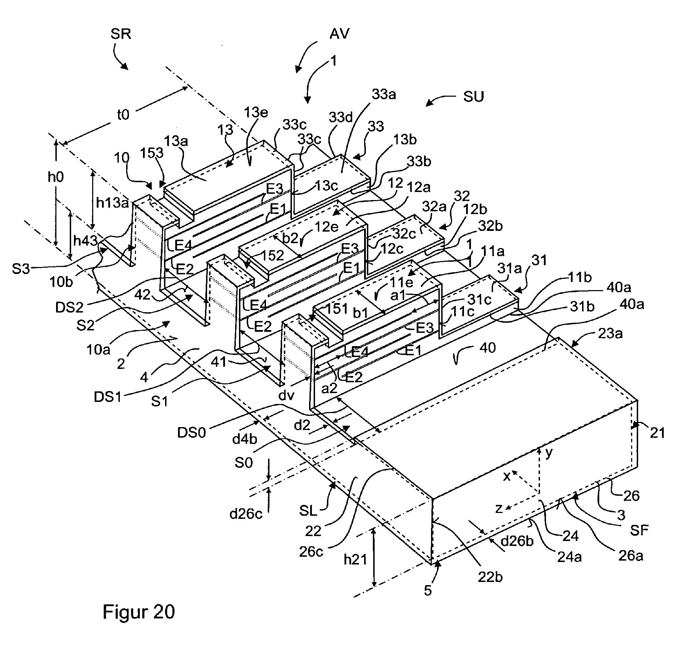

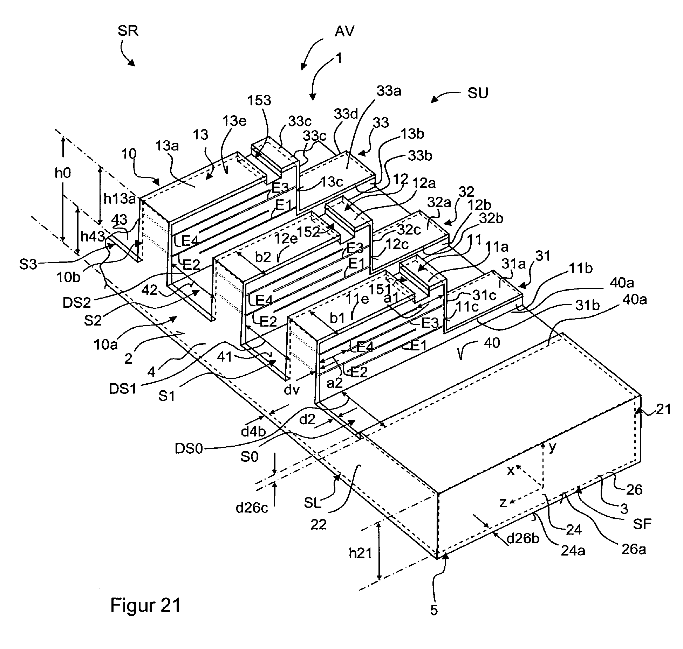

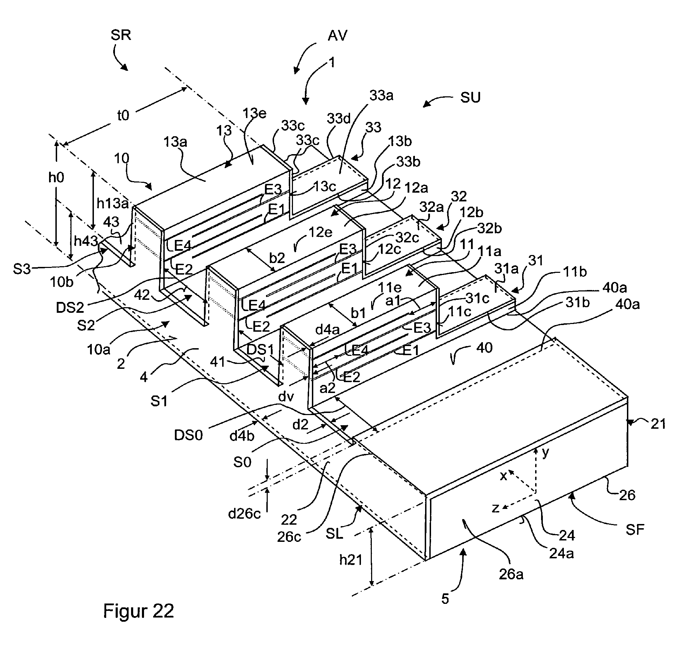

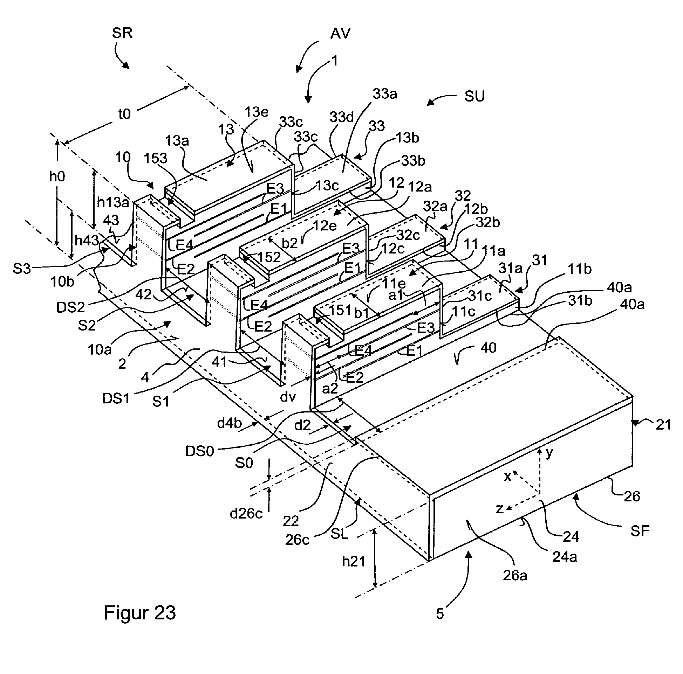

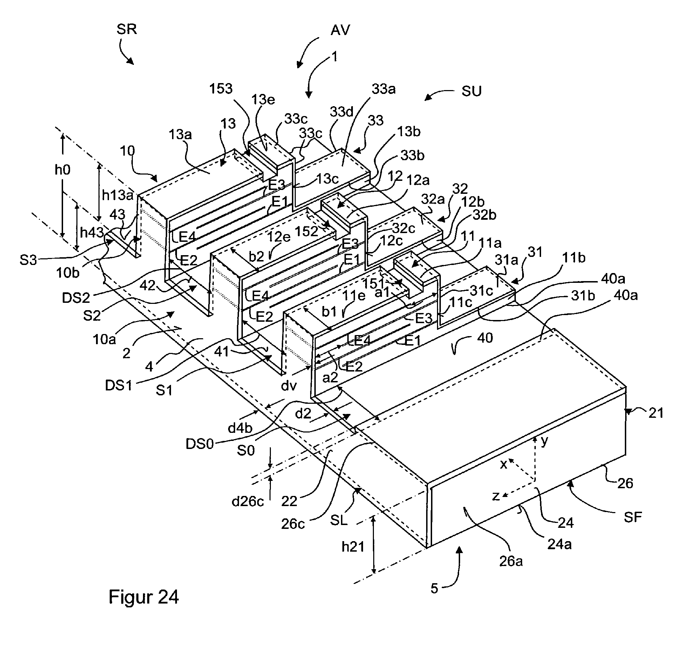

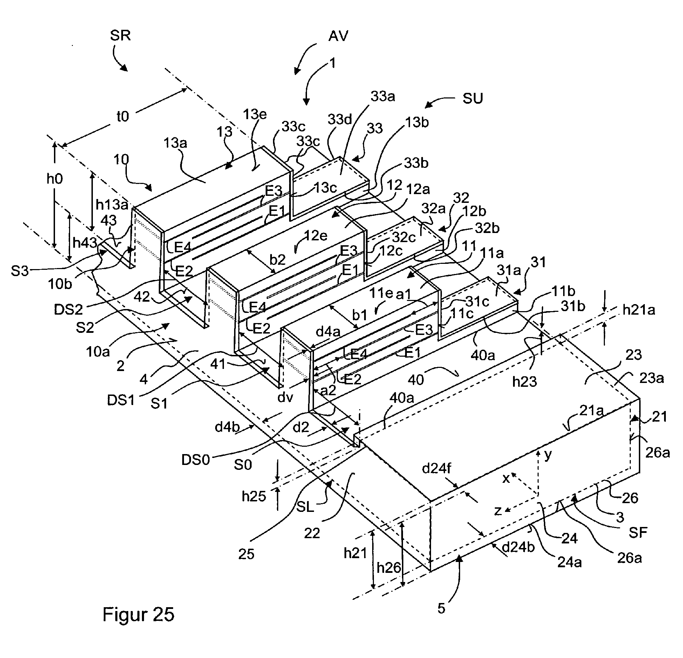

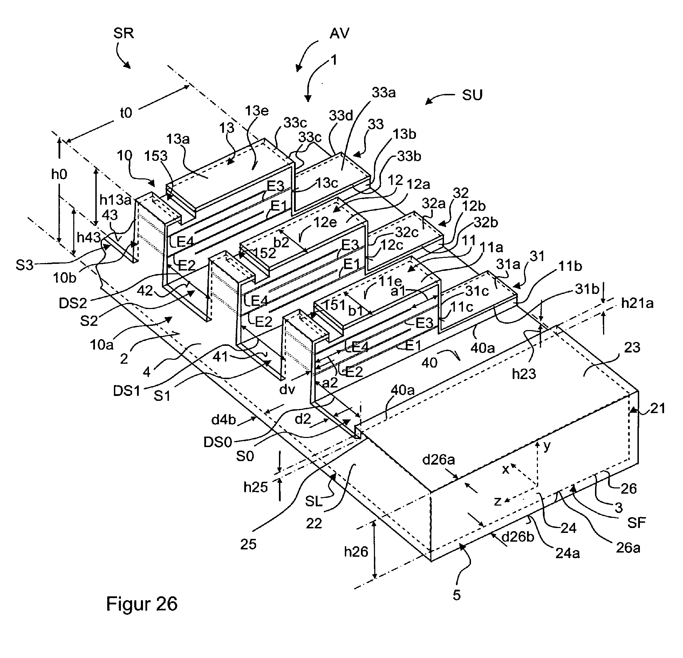

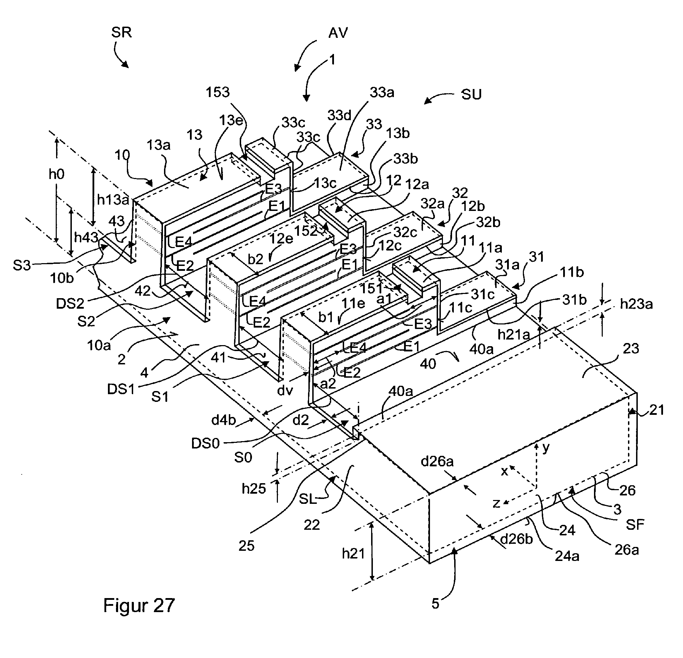

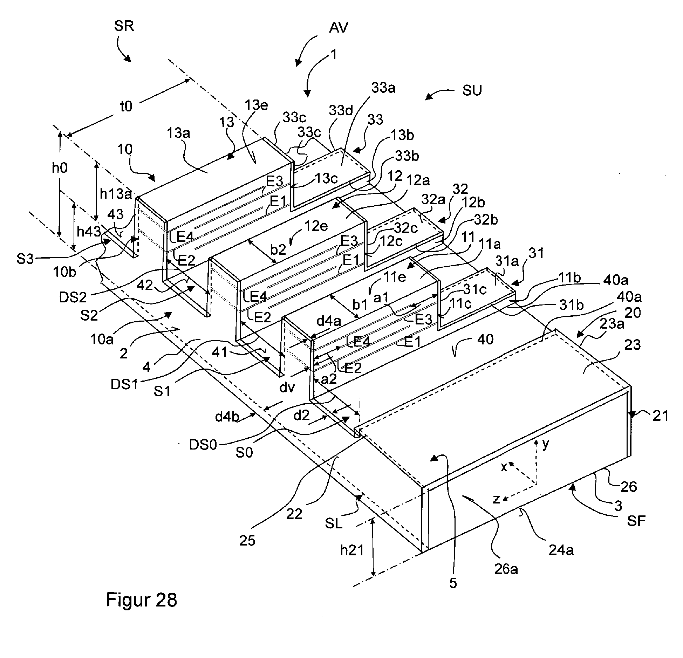

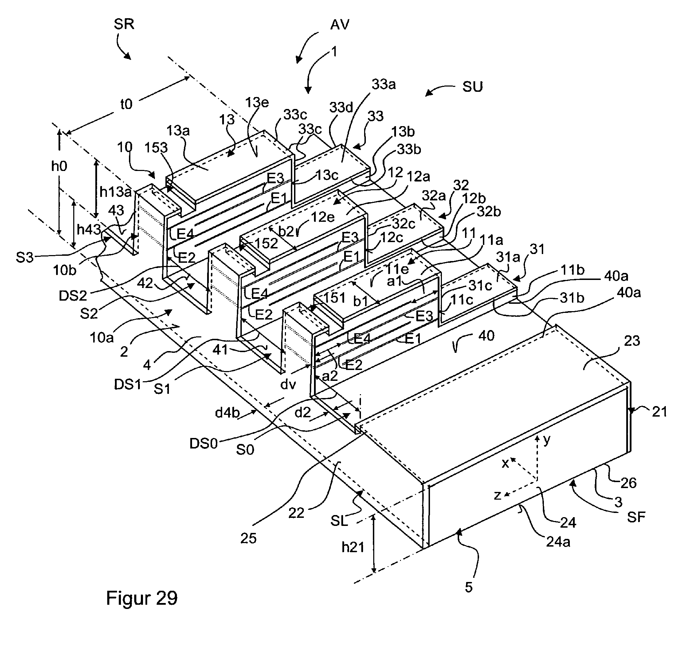

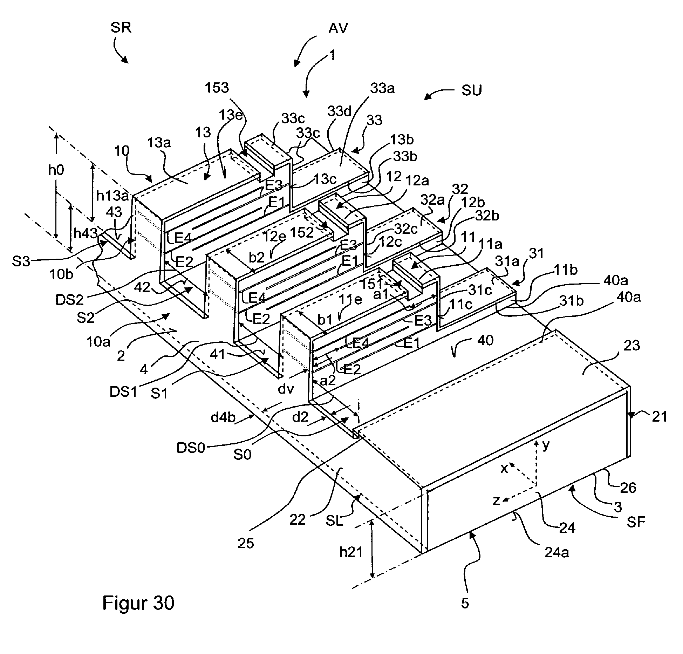

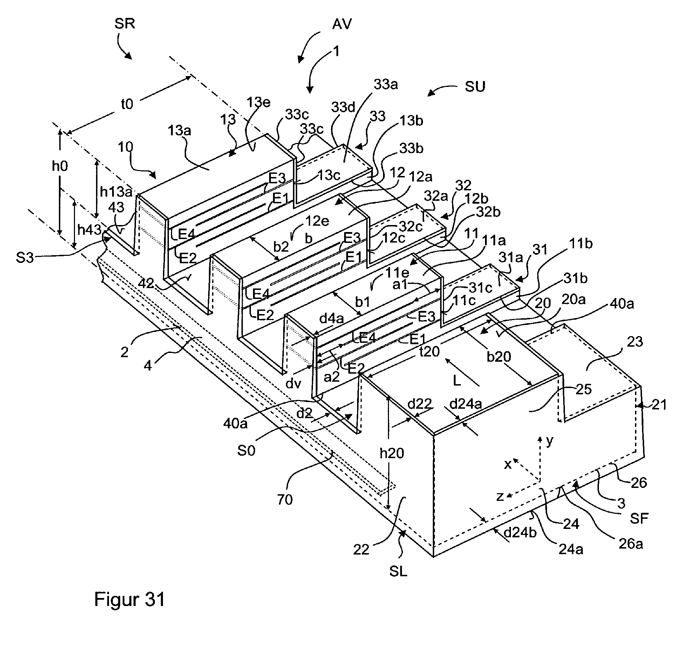

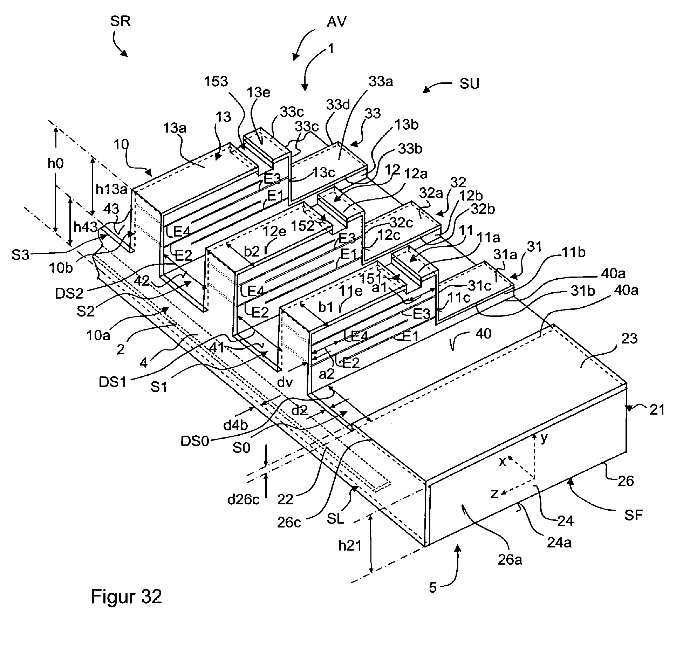

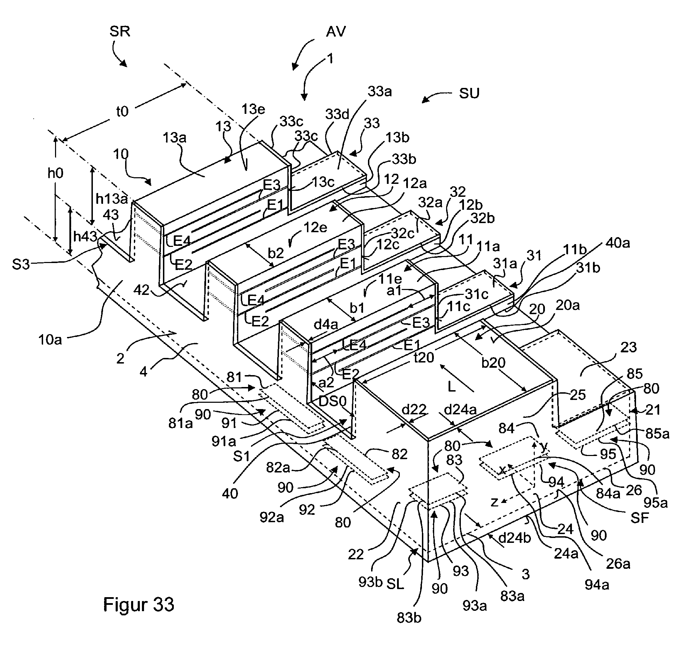

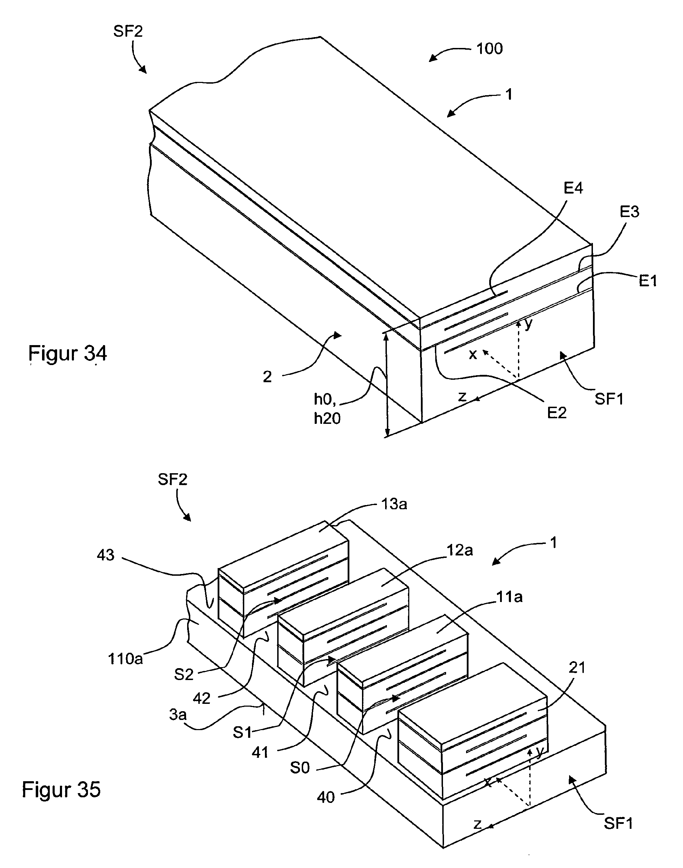

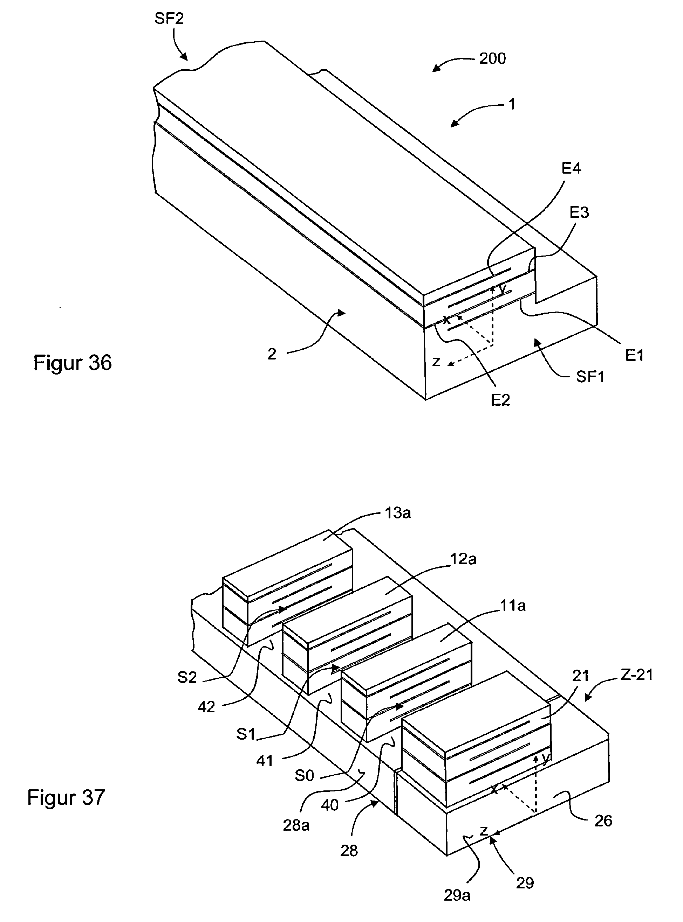

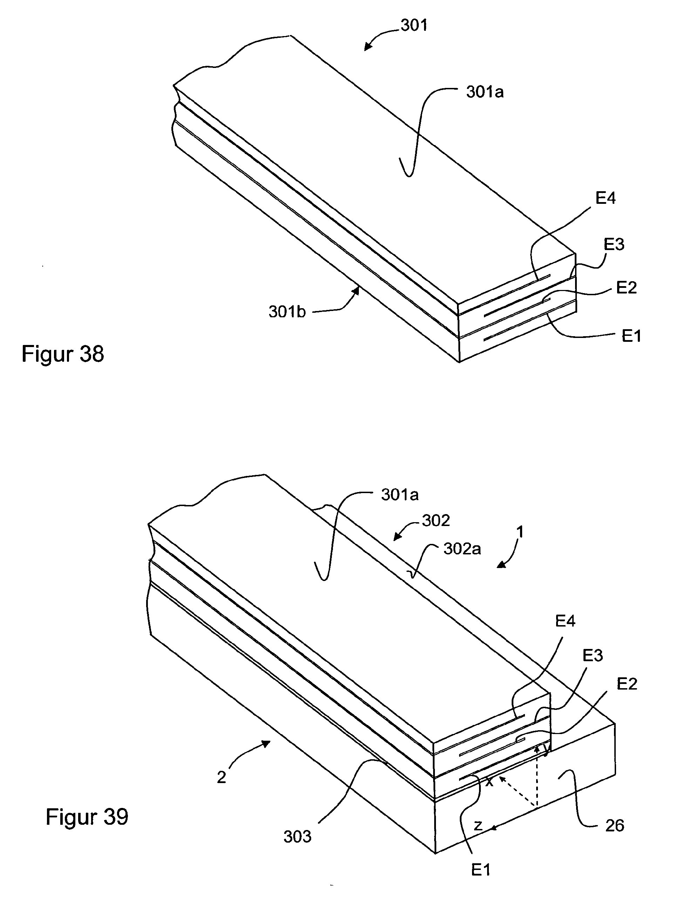

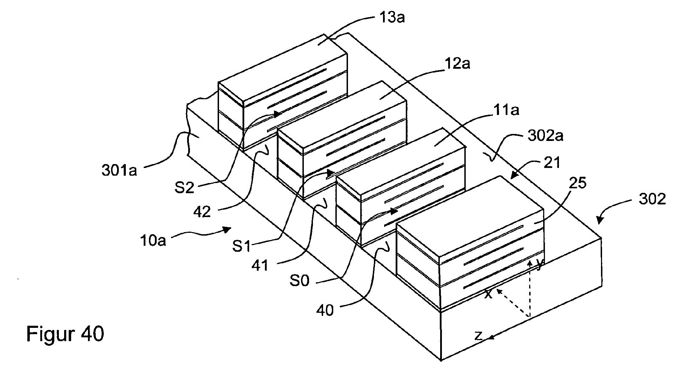

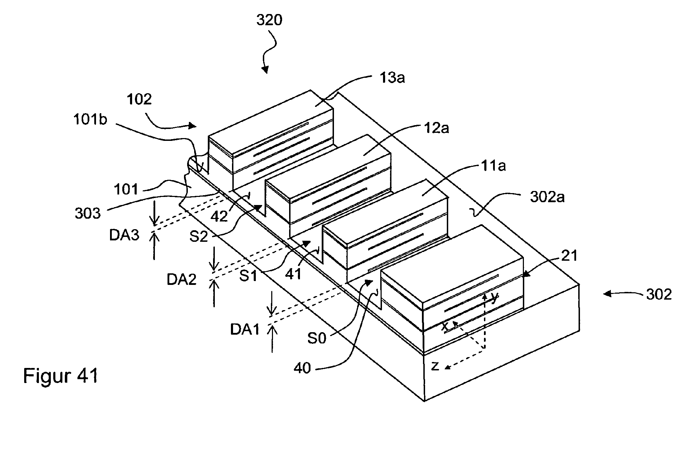

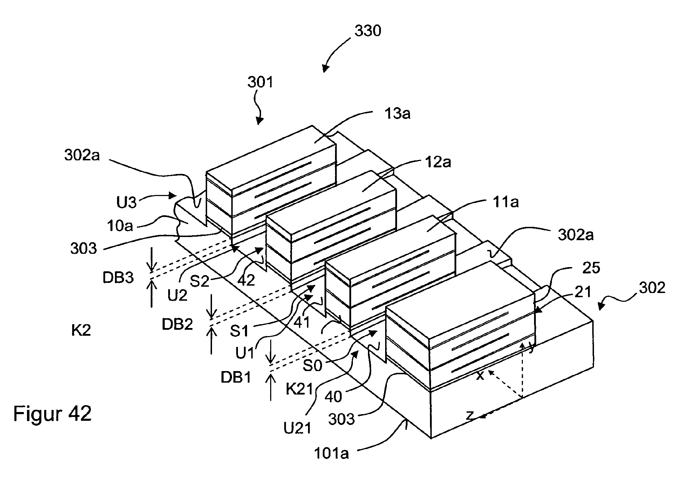

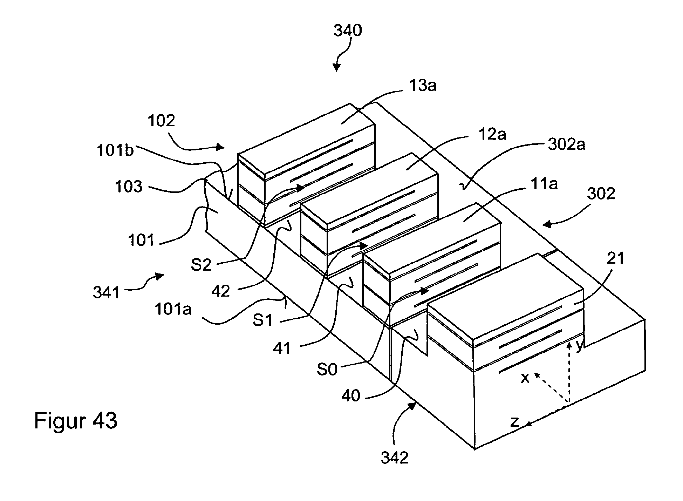

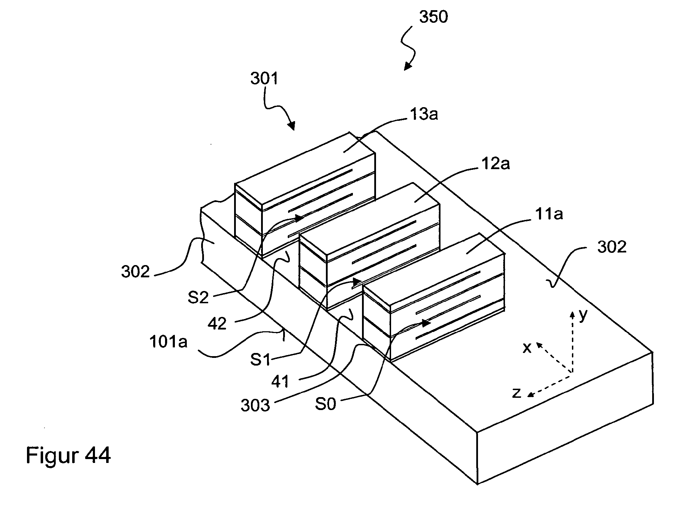

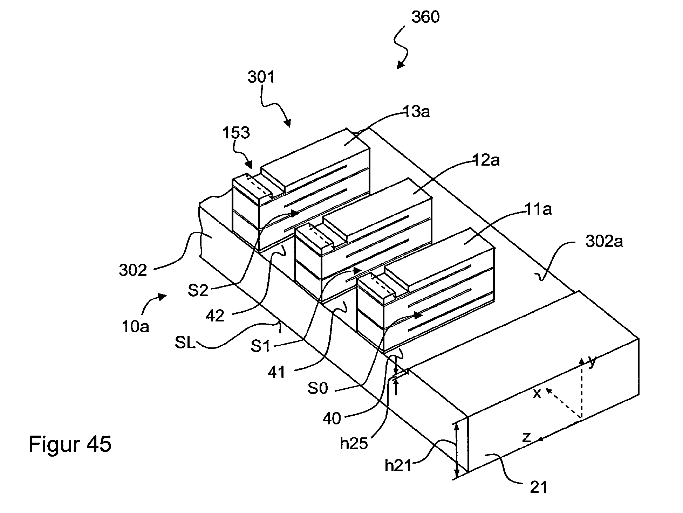

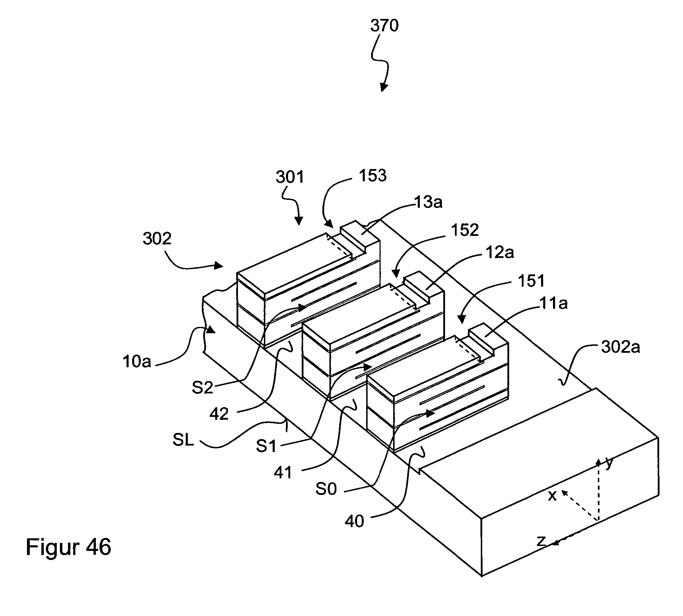

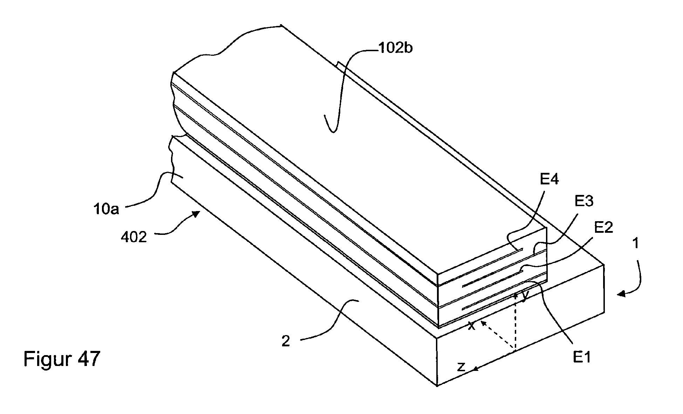

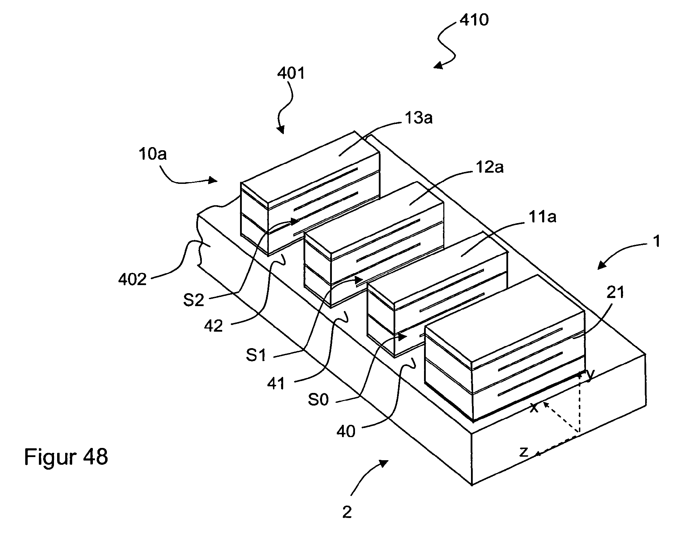

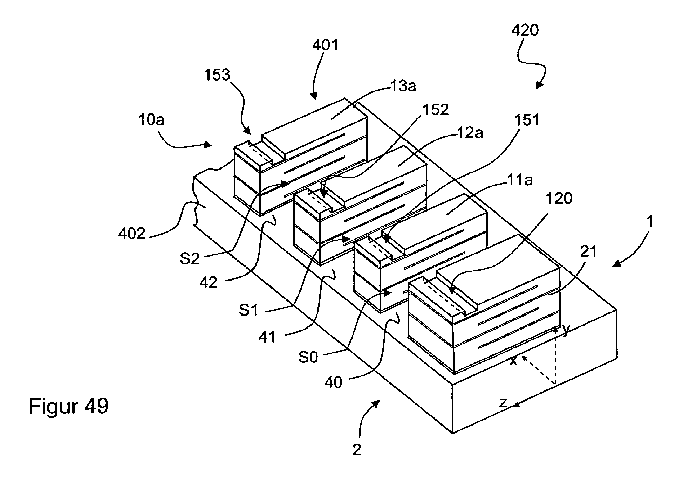

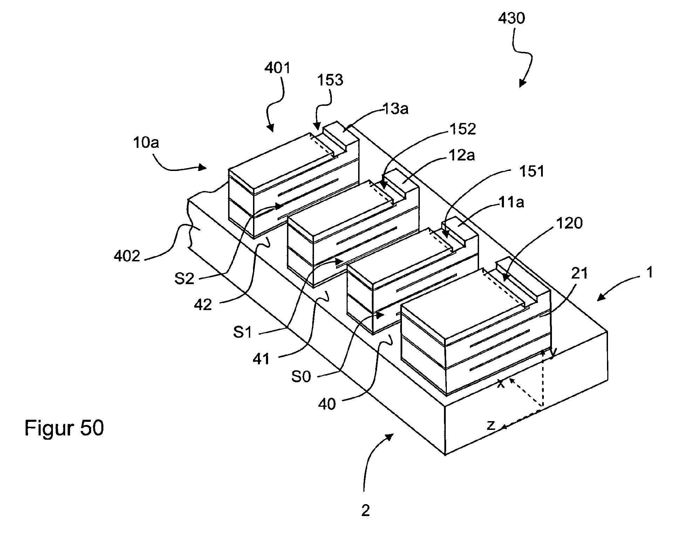

Im Folgenden werden Ausführungsformen der Erfindung an Hand der beiliegenden Figuren beschrieben, die zeigen:
▪ Figur 1 eine perspektivische Darstellung eines Teils einer ersten Ausführungsform der erfindungsgemäßen Aktuatorvorrichtung als Ansicht mit einer Blickrichtung auf eine Rückseite derselben, wobei die Aktuatorvorrichtung generell einen Grundkörper, umfassend einen Basiskörper und einen Aufbaukörper mit Aktuatorkörpern bzw. Aktuatoren, die jeweils eine Aktuator-Anschlussbeschichtung haben, sowie einen Rückführungskörper mit einer Rückführungskörper-Anschlussbeschichtung aufweist;
▪ Figur 1 a eine schematische und stark vereinfachte Gesamtdarstellung einer Ausführungsform der erfindungsgemäßen Aktuatorvorrichtung in perspektivischer Darstellung;
▪ Figur 2 eine perspektivische Darstellung eines Teils der ersten Ausführungsform der erfindungsgemäßen Aktuatorvorrichtung gemäß Figur 1 als Ansicht mit einer Blickrichtung auf eine Vorderseite derselben, die in Bezug auf eine Längsrichtung der Aktuatorvorrichtung entgegen gesetzt zu der Rückseite gelegen ist;
▪ Figur 3 eine perspektivische Darstellung eines Teils einer auf der ersten Ausführungsform der erfindungsgemäßen Aktuatorvorrichtung basierenden weiteren Ausführungsform derselben in der Darstellungsweise der Figur 2, wobei in einem Rückführungs-Teilstück Rückführungs-Elektroden eingesetzt sind, die von der Vorderseite oder der Rückseite ausgehen und nur bis zu einem Abstand der jeweils entgegen gesetzten Rückseite bzw. Vorderseite reichen, bei dem diese keine elektrische Verbindung zwischen der Rückseite und der Vorderseite realisieren;
▪ Figur 4 eine perspektivische Darstellung eines Teils einer weiteren Ausführungsform der erfindungsgemäßen Aktuatorvorrichtung als Ansicht mit einer Blickrichtung auf deren Vorderseite, wobei die weitere Ausführungsform der Aktuatorvorrichtung gegenüber der Ausführungsform gemäß Figur 3 eine Beschichtung an einer Oberseite derselben aufweist, die durch eine Aktuatornut im Bereich der Rückseite der Aktuatorvorrichtung durchtrennt ist;
▪ Figur 5 eine perspektivische Darstellung eines Teils einer weiteren Ausführungsform der erfindungsgemäßen Aktuatorvorrichtung als Ansicht mit einer Blickrichtung auf deren Vorderseite, wobei die Aktuatorvorrichtung eine Beschichtung an einer Oberseite derselben aufweist, welche gegenüber der Ausführungsform der Figur 4 durch eine Aktuatornut im Bereich der Vorderseite der Aktuatorvorrichtung durchtrennt ist;
▪ Figur 6 eine perspektivische Darstellung eines Teils einer zweiten Ausführungsform der erfindungsgemäßen Aktuatorvorrichtung als Ansicht mit einer Blickrichtung auf die Rückseite derselben, wobei die Ausführungsform der Aktuatorvorrichtung eine Beschichtung an der Rückseite und den Stirnseiten aufweist, die in einem unteren Bereich, welcher benachbart zur Unterseite SL ist, eine größere Dicke hat;
▪ Figur 7 eine perspektivische Darstellung eines Teils der in der Figur 5 gezeigten Ausführungsform der erfindungsgemäßen Aktuatorvorrichtung als Ansicht mit einer Blickrichtung auf die Vorderseite derselben;
▪ Figur 8 eine perspektivische Darstellung eines Teils einer auf der Ausführungsform der erfindungsgemäßen Aktuatorvorrichtung gemäß Figur 5 basierenden weiteren Ausführung derselben in der Darstellungsweise der Figur 7, wobei in dem Rückführungs-Teilstück Rückführungs-Elektroden eingesetzt sind, die von der Vorderseite oder der Rückseite ausgehen und nur bis zu einem Abstand der jeweils entgegen gesetzten Rückseite bzw. Vorderseite reichen, bei dem diese keine elektrische Verbindung zwischen der Rückseite und der Vorderseite realisieren;
▪ Figur 9 eine perspektivische Darstellung eines Teils einer weiteren Ausführungsform der erfindungsgemäßen Aktuatorvorrichtung als Ansicht mit einer Blickrichtung auf eine Rückseite derselben, wobei die Ausführungsform der Aktuatorvorrichtung ein sockelartiges Grundkörperendstück aufweist;
▪ Figur 10 eine perspektivische Darstellung der Ausführungsform der erfindungsgemäßen Aktuatorvorrichtung gemäß Figur 9 als Ansicht mit einer Blickrichtung auf eine Vorderseite derselben;
▪ Figur 11 eine perspektivische Darstellung eines Teils einer auf der Ausführungsform der erfindungsgemäßen Aktuatorvorrichtung nach der Figur 9 basierenden weiteren Ausführung derselben in der Darstellungsweise der Figur 10, wobei in dem Rückführungs-Teilstück Rückführungs-Elektroden eingesetzt sind, die von der Vorderseite oder der Rückseite ausgehen und nur bis zu einem Abstand der jeweils entgegen gesetzten Rückseite bzw. Vorderseite reichen, bei dem diese keine elektrische Verbindung zwischen der Rückseite und der Vorderseite realisieren;
▪ Figur 12 eine perspektivische Darstellung eines Teils einer auf der Ausführungsform der erfindungsgemäßen Aktuatorvorrichtung nach der Figur 9 basierenden weiteren Ausführung derselben in der Darstellungsweise der Figur 9, wobei das Rückführungs-Teilstück keine Rückführungs-Elektroden und der Grundkörper ein Grundkörperendstück aufweist;
▪ Figur 13 eine perspektivische Darstellung eines Teils der Ausführungsform der Aktuatorvorrichtung nach der Figur 12 als Ansicht mit einer Blickrichtung auf eine Vorderseite derselben, die in Bezug auf eine Längsrichtung der Aktuatorvorrichtung entgegen gesetzt zu der Rückseite gelegen ist;
▪ Figur 14 eine perspektivische Darstellung eines Teils einer auf der Ausführungsform der erfindungsgemäßen Aktuatorvorrichtung nach der Figur 13 basierenden weiteren Ausführung derselben in der Darstellungsweise der Figur 13, wobei das Rückführungs-Teilstück Rückführungs-Elektroden aufweist;
▪ Figur 15 eine perspektivische Darstellung eines Teils einer auf der Ausführungsform der erfindungsgemäßen Aktuatorvorrichtung nach der Figur 12 basierenden weiteren Ausführung derselben in der Darstellungsweise der Figur 12, wobei das Grundkörperendstück an der Rückseite beschichtet ist;
▪ Figur 15a eine perspektivische Darstellung eines Teils einer Ausführungsform der Aktuatorvorrichtung, die auf der Ausführungsform der Figur 15 basiert und gegenüber dieser eine weitere Beschichtung an der Frontseite aufweist;
▪ Figur 16 eine perspektivische Darstellung eines Teils der Ausführungsform der Aktuatorvorrichtung der auf der Figur 15 basierenden weiteren Ausführung derselben in als Ansicht mit einer Blickrichtung auf die Vorderseite derselben;
▪ Figur 16a eine perspektivische Darstellung eines Teils der Ausführungsform der Aktuatorvorrichtung der auf der Figur 15a basierenden weiteren Ausführung derselben in als Ansicht mit einer Blickrichtung auf die Vorderseite derselben;
▪ Figur 17 eine perspektivische Darstellung eines Teils einer auf der Ausführungsform der erfindungsgemäßen Aktuatorvorrichtung nach der Figur 15 basierenden weiteren Ausführung derselben in der Darstellungsweise der Figur 16, wobei das Rückführungs-Teilstück Rückführungs-Elektroden aufweist;
▪ Figur 18 eine perspektivische Darstellung eines Teils einer auf der Ausführungsform der erfindungsgemäßen Aktuatorvorrichtung nach der Figur 15 basierenden weiteren Ausführung derselben in der Darstellungsweise der Figur 15, wobei die Aktuatorvorrichtung ein weiteres, zweites Grundkörperendstück an der Rückseite der Aktuatorvorrichtung aufweist;
▪ Figur 19 eine perspektivische Darstellung eines Teils einer weiteren Ausführungsform der erfindungsgemäßen Aktuatorvorrichtung in der Darstellungsweise der Figur 1, bei der gegenüber der in der Figur 1 dargestellten Ausführungsform das Rückführungs-Teilstück in einer alternativen Weise und dessen Stützabschnitt mit einer geringeren Höhe ausgeführt ist;
▪ Figur 20 eine perspektivische Darstellung eines Teils einer weiteren Ausführungsform der erfindungsgemäßen Aktuatorvorrichtung auf Basis der Aktuatorvorrichtung gemäß Figur 19, wobei die weitere Ausführungsform der Aktuatorvorrichtung gegenüber der Ausführungsform der Figur 19 eine Beschichtung an der Oberseite der Aktuatorkörper aufweist, die durch eine Aktuatornut im Bereich der Rückseite der Aktuatorvorrichtung durchtrennt ist;
▪ Figur 21 eine perspektivische Darstellung eines Teil einer weiteren Ausführungsform der erfindungsgemäßen Aktuatorvorrichtung auf Basis der Aktuatorvorrichtung der Figur 20, wobei die obere Leitungsschicht an der Oberseite derselben durch eine Aktuatornut im Bereich der Vorderseite der Aktuatorvorrichtung durchtrennt ist;
▪ Figur 22 eine perspektivische Darstellung eines Teils einer weiteren Ausführungsform der erfindungsgemäßen Aktuatorvorrichtung in der Darstellungsweise der Figur 1, bei der gegenüber der in der Figur 1 dargestellten Ausführungsform das Rückführungs-Teilstück in einer alternativen Weise und ohne einen Stützabschnitt und ohne Beschichtung an der Stirnfläche ausgeführt ist;
▪ Figur 23 eine perspektivische Darstellung eines Teils einer weiteren Ausführungsform der erfindungsgemäßen Aktuatorvorrichtung auf Basis der Aktuatorvorrichtung der Figur 22, wobei die weitere Ausführungsform der Aktuatorvorrichtung gegenüber der Ausführungsform der Figur 22 eine Beschichtung an der Oberseite der Aktuatorkörper aufweist, die durch eine Aktuatornut im Bereich der Rückseite der Aktuatorvorrichtung durchtrennt ist;
▪ Figur 24 eine perspektivische Darstellung eines Teil einer weiteren Ausführungsform der erfindungsgemäßen Aktuatorvorrichtung auf Basis der Aktuatorvorrichtung der Figur 22, wobei die Beschichtung an der Oberseite der Aktuatorkörper durch eine Aktuatornut im Bereich der Vorderseite der Aktuatorvorrichtung durchtrennt ist;
▪ Figur 25 eine perspektivische Darstellung eines Teils einer weiteren auf der Ausführungsform der Figur 19 basierenden Ausführungsform der erfindungsgemäßen Aktuatorvorrichtung in der Darstellungsweise der Figur 19, wobei das Rückführungs-Teilstück eine alternative Art der Beschichtung aufweist;
▪ Figur 26 eine perspektivische Darstellung eines Teils einer weiteren Ausführungsform der erfindungsgemäßen Aktuatorvorrichtung auf Basis der Aktuatorvorrichtung der Figur 25, wobei die weitere Ausführungsform der Aktuatorvorrichtung gegenüber der Ausführungsform der Figur 25 eine Beschichtung an der Oberseite der Aktuatorkörper aufweist, die durch eine Aktuatornut im Bereich der Rückseite der Aktuatorvorrichtung durchtrennt ist;
▪ Figur 27 eine perspektivische Darstellung eines Teil einer weiteren Ausführungsform der erfindungsgemäßen Aktuatorvorrichtung auf Basis der Aktuatorvorrichtung der Figur 25, wobei im Gegensatz zur Ausführungsform gemäß Figur 26 die Beschichtung an der Oberseite der Aktuatorkörper im Bereich der Vorderseite der Aktuatorvorrichtung durchtrennt ist;
▪ Figur 28 eine perspektivische Darstellung eines Teils einer weiteren auf der Ausführungsform der Figur 25 basierenden Ausführungsform der erfindungsgemäßen Aktuatorvorrichtung in der Darstellungsweise der Figur 25, bei der gegenüber der in der Figur 22 dargestellten Ausführungsform das Rückführungs-Teilstück keine Beschichtung auf der Stirnseite aufweist;
▪ Figur 29 eine perspektivische Darstellung eines Teils einer weiteren Ausführungsform der erfindungsgemäßen Aktuatorvorrichtung auf Basis der Aktuatorvorrichtung der Figur 28, wobei die weitere Ausführungsform der Aktuatorvorrichtung gegenüber der Ausführungsform der Figur 28 eine Beschichtung an der Oberseite der Aktuatorkörper aufweist, die durch eine Aktuatornut im Bereich der Rückseite der Aktuatorvorrichtung durchtrennt ist;
▪ Figur 30 eine perspektivische Darstellung eines Teil einer weiteren Ausführungsform der erfindungsgemäßen Aktuatorvorrichtung auf Basis der Aktuatorvorrichtung der Figur 28, wobei im Gegensatz zur Ausführungsform gemäß Figur 29 die Beschichtung an der Oberseite der Aktuatorkörper durch eine Aktuatornut im Bereich der Vorderseite der Aktuatorvorrichtung durchtrennt ist;
▪ Figur 31 eine perspektivische Darstellung eines Teils einer weiteren Ausführungsform der erfindungsgemäßen Aktuatorvorrichtung in der Darstellungsweise der Figur 1, bei der gegenüber der in der Figur 1 dargestellten Ausführungsform an der Rückseite der Aktuatorvorrichtung eine Sammel-Elektrode als innere Elektrode angeordnet ist;
▪ Figur 32 eine perspektivische Darstellung eines Teils einer weiteren auf der Ausführungsform der Figur 31 basierenden Ausführungsform der erfindungsgemäßen Aktuatorvorrichtung in der Darstellungsweise der Figur 31, bei der gegenüber der in der Figur 31 dargestellten Ausführungsform das Rückführungs-Teilstück keinen Stützabschnitt aufweist,
▪ Figur 33 eine perspektivische Darstellung eines Teils einer weiteren Ausführungsform der erfindungsgemäßen Aktuatorvorrichtung in der Darstellungsweise der Figur 1, bei der gegenüber der in der Figur 1 dargestellten Ausführungsform in dem Basiskörper Schwindungsanpassungs-Elektroden als innere Elektroden angeordnet sind;
▪ Figur 34 eine Ausführungsform eines Grundkörper-Zwischenprodukts zur Herstellung einer der Ausführungsformen gemäß den Figuren 1 bis 33, wobei das Zwischenprodukt ein monolithischer Block ist;
▪ Figur 35 eine Ausführungsform eines weiteren Zwischenprodukts, das auf das Zwischenprodukt der Figur 34 durch Bearbeitung desselben folgt,
▪ Figur 36 zu einem bezüglich der Figuren 34 und 35 alternativen Herstellungsverfahren eine Ausführungsform eines Grundkörper-Zwischenprodukts zur Herstellung der erfindungsgemäßen Aktuatorvorrichtung, wobei das Zwischenprodukt ein monolithischer Block ist, an den ein Rückführungskörper befestigbar ist;
▪ Figur 37 ein weiteres Zwischenprodukt des Verfahrens, auf das sich das Zwischenprodukt gemäß Figur 36 bezieht, wobei das in der Figur 37 gezeigte Zwischenprodukt den Rückführungskörper aufweist;
▪ Figur 38 eine Ausführungsform eines Aufbaukörper-Zwischenprodukts zur Herstellung der erfindungsgemäßen Aktuatorvorrichtung, bei der der Grundkörper aus einem Basiskörper-Zwischenprodukt und dem Oberkörper-Zwischenprodukt gemäß Figur 38 aus separaten Teilen zusammengesetzt ist;
▪ Figur 39 eine Ausführungsform eines Grundkörper-Zwischenprodukts zur Herstellung der erfindungsgemäßen Aktuatorvorrichtung, wobei das Grundkörper-Zwischenprodukt aus dem Oberkörper-Zwischenprodukt nach der Figur 38 und einem Basiskörper-Zwischenprodukt als separate Zwischenprodukte zusammengesetzt ist;
▪ Figur 40 eine Ausführungsform eines weiteren Zwischenprodukts, das aus einem Grundkörper-Zwischenprodukt nach der Figur 39 gebildet ist und bei dem aus dem Oberkörper-Zwischenprodukt mehrere Aktuatorkörper und ein Stützabschnitt des Rückführungskörpers herausgebildet sind;
▪ Figur 41 eine Ausführungsform eines weiteren Zwischenprodukts, das alternativ zu der in der Figur 40 gezeigten Ausführungsform eines Zwischenprodukts ausgebildet ist, indem die Aktuatorkörper und der Stützabschnitt des Rückführungskörpers auf zu dieser alternativen Weise herausgebildet sind;
▪ Figur 42 eine Ausführungsform eines weiteren Zwischenprodukts, das alternativ zu der in der Figur 40 gezeigten Ausführungsform eines Zwischenprodukts ausgebildet ist, indem die Aktuatorkörper und der Rückführungskörper samt Stützabschnitt auf eine weitere zu dieser alternativen Weise herausgebildet sind;
▪ Figur 43 eine Ausführungsform eines weiteren Zwischenprodukts, das alternativ zu der in der Figur 40 gezeigten Ausführungsform eines Zwischenprodukts ausgebildet ist, indem der Rückführungskörper des Zwischenprodukts als eigenes Zwischenprodukt gebildet ist;
▪ Figur 44 eine Ausführungsform eines weiteren Zwischenprodukts, das alternativ zu der in der Figur 40 gezeigten Ausführungsform eines Zwischenprodukts ausgebildet ist, indem der Rückführungskörper des Zwischenprodukts keinen Stützabschnitt aufweist;
▪ Figur 45 eine perspektivische Darstellung eines Teils eines weiteren Zwischenprodukts der erfindungsgemäßen Aktuatorvorrichtung auf Basis der Aktuatorvorrichtung der Figur 44, wobei bei der dargestellten Ausführungsform das Rückführungs-Teilstück einen gegenüber der in der Figur 1 gezeigten Stützabschnitt geringerer Höhe aufweist, wobei die weitere Ausführungsform der Aktuatorvorrichtung gegenüber der Ausführungsform der Figur 40 eine obere Aktuatornut im Bereich der Rückseite der Aktuatorvorrichtung aufweist;
▪ Figur 46 eine perspektivische Darstellung eines Teils eines weiteren Zwischenprodukts der erfindungsgemäßen Aktuatorvorrichtung auf Basis der Aktuatorvorrichtung der Figur 44, wobei bei der dargestellten Ausführungsform das Rückführungs-Teilstück einen gegenüber der Ausführungsform der in Figur 1 gezeigten Stützabschnitt geringerer Höhe aufweist, wobei die weitere Ausführungsform der Aktuatorvorrichtung gegenüber der Ausführungsform der Figur 44 eine obere Aktuatornut im Bereich der Vorderseite der Aktuatorvorrichtung aufweist;
▪ Figur 47 eine gegenüber der in der Figur 39 dargestellten Ausführungsform eines Grundkörper-Zwischenprodukts weitere Ausführungsform des Grundkörper-Zwischenprodukts, wobei das Basiskörper-Zwischenprodukt ein erstes Grundkörper-Endstück und ein zweites Grundkörper-Endstück aufweist;
▪ Figur 48 eine Ausführungsform eines weiteren Zwischenprodukts, das aus einem Grundkörper-Zwischenprodukt nach der Figur 47 gebildet ist und bei dem aus dem Zwischenprodukt mehrere Aktuatorkörper und ein Rückführungskörper mit Stützabschnitt herausgebildet sind;
▪ Figur 49 eine perspektivische Darstellung eines Teils eines weiteren Zwischenprodukts der erfindungsgemäßen Aktuatorvorrichtung auf Basis der Aktuatorvorrichtung der Figur 48, wobei die weitere Ausführungsform der Aktuatorvorrichtung gegenüber der Ausführungsform der Figur 48 eine obere Aktuatornut im Bereich der Rückseite der Aktuatorvorrichtung aufweist;
▪ Figur 50 eine perspektivische Darstellung eines Teils eines weiteren Zwischenprodukts der erfindungsgemäßen Aktuatorvorrichtung auf Basis der Aktuatorvorrichtung der Figur 48, wobei bei der dargestellten Ausführungsform gegenüber der Ausführungsform der Figur 48 eine obere Aktuatornut im Bereich der Vorderseite der Aktuatorvorrichtung aufweist.

In den Figuren sind Komponenten und Bestandteile mit ähnlicher oder gleicher Funktion teilweise mit jeweils demselben Bezugszeichen versehen.

Die erfindungsgemäße Aktuatorvorrichtung AV weist eine Mehrzahl von Aktuatoren auf, von denen zur besseren Veranschaulichung in den Figuren meist nur drei Aktuatoren 11, 12, 13 gezeigt und entsprechend beschrieben sind. Es ist denkbar, dass die erfindungsgemäße Aktuatorvorrichtung AV eine Vielzahl von Aktuatoren aufweist, z.B. in einer Anzahl zwischen 100 und 500. Daneben ist denkbar, dass die erfindungsgemäße Aktuatorvorrichtung nur zwei Aktuatoren aufweist. Das Material der Aktuatoren 11, 12, 13 ist, abgesehen von den Elektroden, aus einem piezoelektrischen oder elektrostriktiven Material gebildet oder besteht aus einem piezoelektrischen oder elektrostriktiven Material. Die Aktuatoren 11, 12, 13 können elektrisch mittels einer in den Figuren nicht dargestellten elektrischen Betätigungsvorrichtung, die mit Elektroden der Aktuatoren 11, 12, 13 elektrisch verbunden sind, einzeln betätigt werden. Zur Beschreibung der erfindungsgemäßen Aktuatorvorrichtung AV ist in den Figuren ein orthogonales Koordinatensystem mit einer X-Richtung eingetragen, die in der Längsrichtung L der erfindungsgemäßen Aktuatorvorrichtung AV gerichtet ist, in der gesehen die Aktuatoren 11, 12, 13 nebeneinander angeordnet sind. Die Y-Richtung bezeichnet eine Dickenrichtung oder Höhenrichtung der erfindungsgemäßen Aktuatorvorrichtung AV und die Z-Richtung eine Tiefenrichtung oder Breitenrichtung der erfindungsgemäßen Aktuatorvorrichtung AV.

Die Aktuatorvorrichtung AV hat generell einen Aktuatorvorrichtungs-Grundkörper 10 oder kurz Grundkörper 10 umfassend einen Basiskörper 10a und einen Aufbaukörper 10b, wobei der Aufbaukörper 10b Aktuatoren 11, 12, 13 mit jeweils einer Aktuator-Anschlussbeschichtung 31a, 32a, 33a aufweist, sowie einen Rückführungskörper 21 mit einer Rückführungs-Verbindungsschicht 5.

Bei der Ausführungsform der Figur 15 ist die Oberfläche 29a unbeschichtet. Bei dieser Ausführungsform kann zusätzlich die Oberfläche 29a beschichtet sein, wie diese in den Figuren 15a und 16a dargestellt ist: dabei ist die Oberfläche 29a mit der Schicht 29h beschichtet, deren Oberfläche 29i Teil der Stirnseite SL ist.

Die Aktuatoren 11, 12, 13 können sich bei der erfindungsgemäßen Aktuatorvorrichtung AV aufgrund einer Betätigung durch die elektrische Betätigungsvorrichtung, d.h. durch Beaufschlagung mit einer elektrischen Spannung, in der Dickenrichtung Y ausdehnen oder zusammenziehen. Auf diese Weise können diese beispielsweise auf zu verstellende oder formveränderliche Teile oder Teilbereiche einer Anwendungskomponente einwirken.

Die erfindungsgemäße Aktuatorvorrichtung AV kann z.B. als Piezomotor ausgeführt sein. Daneben kann die erfindungsgemäße Aktuatorvorrichtung AV als Ultraschallwandler, insbesondere als Ultraschallarray oder Lineararray ausgeführt sein. Weiterhin kann in einem Anwendungsfall der Erfindung eine Anwendungskomponente eine Behältervorrichtung einer Druckmittel-Abgabevorrichtung eines Druckers und insbesondere eines Tintenstrahldruckers mit einer Mehrzahl von einzeln formveränderlichen Teilbehältern sein, so dass durch eine derart durch die erfindungsgemäß vorgesehenen Aktuatoren verursachte Formveränderung eines Teilbehälters in diesem enthaltende Druckmittels, wie im Beispiel des Tintenstrahldruckers Tinte, durch eine Düse desselben verdrängt werden kann. Eine andere Anwendungskomponente kann eine Einspritzvorrichtung eines Motors und die Teilbehälter Behälter zur Aufnahme und zum Ausspritzen von Treibstoff sein, das durch Aktuieren von erfindungsgemäß vorgesehenen und an den Teilbehältern anliegenden Aktuatoren bewirkt wird.

Die zuvor beschriebenen Anwendungen nutzen den sogenannten inversen piezoelektrischen Effekt, bei welchem durch Anlegen einer elektrischen Spannung eine Deformation des Aktuators oder Aktors hervorgerufen wird. Es ist jedoch ebenso denkbar, dass mit der erfindungsgemäßen Aktuatorvorrichtung der piezoelektrische Effekt genutzt wird, beispielsweise in Form eines Sensors. Bei Nutzung einer Vielzahl von Aktoren ist beispielsweise Sensor zur Positionsdetektierung vorstellbar.

Die Aktuatorvorrichtung AV weist weiterhin auf: eine Vorderseite 1, eine in Bezug auf eine Längsrichtung X der Aktuatorvorrichtung AV entgegengesetzt zu der Vorderseite 1 gelegene Rückseite 2, eine in negativer Y-Richtung weisende Unterseite SL sowie eine in positiver Y-Richtung weisende Oberseite SU. Die Vorderseite 1 ist in Längsrichtung X gesehen und in Bezug auf den Ort der Aktuatoren 11, 12, 13 auf einer Seite, die entgegen gesetzt zur Rückseite 2 gelegen ist, angeordnet. Somit ist die Vorderseite 1 in Bezug auf die Aktuatoren 11, 12, 13 jenseits der Rückseite 2 angeordnet. Die Rückseite 2 des Grundkörpers 10 ist aus einer Oberfläche 2a gebildet, die eine einheitliche und insbesondere ebene Oberfläche darstellt. Unter "einheitlich" wird in diesem Zusammenhang verstanden, dass sich die Oberfläche entlang der X-Richtung erstreckt. Insbesondere kann dabei vorgesehen sein, dass die Oberfläche 2a eine über ihre Erstreckung einheitliche Krümmung aufweist, also keinen Wendepunkt besitzt.

Der Grundkörper 10 weist einen Basiskörper 10a und einen Aufbaukörper 10b mit sich in der Dickenrichtung Y von dem Basiskörper 10a aus erstreckenden AktuatorKörpern 11a, 12a, 13a auf, aus denen die Aktuatoren 11, 12, 13 gebildet sind. Die Aktuator-Körper 11 a, 12a, 13a sind aus einem piezoelektrischen oder elektrostriktiven Material und beispielsweise aus PZT gebildet und zumindest in einigen derselben sind Betätigungs-Elektroden angeordnet, die durch eine Betätigungsvorrichtung betätigbar sind. Die jeweiligen Aktuatorkörper 11 a, 12a, 13a mit den jeweils in diesen angeordneten Betätigungs-Elektroden bilden jeweils einen Aktuator 11, 12, 13. Jeder Aktuatorkörper 11 a, 12a, 13a weist eine obere Oberfläche 11 e bzw. 12e bzw. 13e auf, die somit Teil der Oberseite SU sind.

Die sich in der X-Richtung erstreckenden Breiten b und die sich in der Z-Richtung erstreckenden Längen oder Tiefen t0 der Aktuatorkörper 11 a, 12a, 13a der erfindungsgemäßen Aktuatorvorrichtung AV können insbesondere gleich groß sein.

In den dargestellten Ausführungsformen der erfindungsgemäßen Aktuatorvorrichtung AV sind die Aktuatoren 11, 12, 13 nebeneinander bzw. in X-Richtung hintereinander derart angeordnet, dass zwischen jeweils zwei Aktuatoren-beispielsweise zwischen den Aktuatoren 11, 12, 13 - eine Ausnehmung S1, S2 mit der sich in der in der X-Richtung erstreckenden Breite DS1 bzw. DS2 und den in die Y-Richtung weisenden Oberflächen 41, 42 ausgebildet ist. Die Ausnehmungen S1 und S2 werden somit umgrenzt von der Oberfläche 41 bzw. 42 und den einander zugewandten Seiten AS1, AS2 jeweils benachbarter Aktuatoren 11 und 12 bzw. 12 und 13. Die sich in der in der X-Richtung erstreckende Breite (z. B. DS1, DS2) zwischen in der X-Richtung benachbart zueinander gelegenen Aktuatoren (z.B. Aktuatoren 11 und 12) kann insbesondere gleich groß sein. Alternativ können auch unterschiedliche Breiten vorgesehen sein. Auch ist zwischen dem Aktuator 11 und dem Rückführungskörper 21 eine Ausnehmung S0 mit der in der X-Richtung verlaufenden Breite DS0 mit einer in die Y-Richtung weisenden Oberfläche 40 angeordnet. Insbesondere kann vorgesehen sein, dass die Breiten DS1, DS2 zwischen jeweils zwei in der X-Richtung benachbart zueinander gelegenen Aktuatoren mit der Breite DS0 zwischen dem Rückführungskörper 21 und dem benachbarten Aktor 11 übereinstimmen.

Der Abschnitt des Grundkörpers 10, welcher in der Y-Richtung gesehen bis zu den Oberflächen 40, 41, 42 der Ausnehmungen S0, S1, S2 reicht, bildet den Basiskörper 10a. In der Figur 1 ist beispielartig die Höhe h43 der Ausnehmung S3 eingetragen. Demnach hat der Basiskörper 10a hier die Höhe h43.

Vorzugsweise ist vorgesehen, dass der Grundkörper 10 als Block gebildet ist, so dass der Grundkörper 10 einheitlich aus einem Basismaterial gebildet ist. Dabei kann auch vorgesehen sein, dass die Außenkontur, die aus den Außenflächen des Grundkörpers 10 gebildet ist, eine Quaderform hat. Die virtuelle Oberseite des Grundkörpers 10 ist teils aus den Oberflächen 40, 41, 42 und den zwischen diesen gelegenen und diese verbindenden virtuellen Verbindungsflächen gebildet. Die virtuellen Verbindungsflächen können insbesondere derart definiert sein, dass diese zwischen den Oberflächen 40, 41, 42 über die gesamte jeweilige Verbindungsfläche gesehen eine möglichst geringe Wölbung aufweisen. Die Aktuatoren 11, 12, 13 sind vorzugsweise einstückig mit dem Grundkörper 10 verbunden, so dass diese in ihrem jeweiligen Verbindungsbereich zu dem Grundkörper 10 flächig und fest mit diesem verbunden sind, so dass weder der Aktuator 11, 12, 13 insgesamt noch ein Teilabschnitt des jeweiligen Aktuators 11, 12, 13 eine Bewegungsfreiheit gegenüber dem Grundkörper 10 besitzt.

Die Aktuatorkörper 11a, 12a, 13a des Grundkörpers 10 bzw. des Aufbaukörpers 10b erstrecken sich vom Basiskörper 10a in der Y-Richtung in eine Höhe, die insbesondere für die Aktuatorkörper 11a, 12a, 13a der erfindungsgemäßen Aktuatorvorrichtung AV gleich groß ist. In der Figur 1 ist beispielartig die Höhe h13a des Aktuatorkörpers 13a eingetragen.

Die Aktuatoren 11, 12, 13 weisen jeweils zumindest zwei innere Betätigungs-Elektroden auf, die in einer Mehrzahl der Aktuatoren angeordnet sind und von denen sich zumindest eine erste innere Betätigungs-Elektrode E1, E3 von der Vorderseite 1 bis zu einem Abstand a2 zu der Rückseite 2 der Aktuatorvorrichtung AV hin erstreckt und von denen sich zumindest eine zweite innere Betätigungs-Elektrode E2, E4 von der Rückseite 2 bis zu einem Abstand a1 zur Vorderseite 1 hin erstreckt. Bei elektrischer Ansteuerung der zumindest einen ersten inneren Betätigungs-Elektrode E1, E3 und der zumindest einen zweiten inneren Betätigungs-Elektrode E2, E4 mit einer zueinander entgegen gesetzten elektrischen Polung durch eine an die Betätigungs-Elektroden angeschlossene Betätigungsvorrichtung wird eine Ausdehnung oder ein Zusammenziehen des zwischen den beiden Elektroden angeordneten piezoelektrischen oder elektrostriktiven Materials und damit des Aktuators in der Y-Richtung bewirkt, in dem diese gelegen sind.

Die Oberfläche einer Ausführungsform der erfindungsgemäßen Aktuatorvorrichtung AV, die in die Y-Richtung weist, kann im Bereich der Aktuatoren 11, 12, 13 ohne eine elektrisch leitende Schicht versehen sein, wie dies in der Figur 1 dargestellt ist. Bei dieser Ausführungsform sind sowohl die Oberflächen 11 e, 12e, 13e, als auch die in die X-Richtung weisenden Seitenwände der Aktuatoren 11, 12, 13 und die Oberflächen 41, 42 der Ausnehmungen S2, S3 unbeschichtet.

Die Betätigungsvorrichtung ist mit einem ersten elektrischen Pol an die ersten Elektroden E1, E3 an der Vorderseite 1 anschließbar. Hierzu kann jeder anzusteuernde Aktuator 11, 12, 13 eine Direktanschluss-Beschichtung oder erste Anschluss-Schicht oder Aktuator-Anschlussbeschichtung 31a, 32a, 33a aus einem elektrisch leitenden und insbesondere metallischen Material aufweisen, die elektrisch mit den ersten inneren Betätigungs-Elektroden E1, E3 in Verbindung stehen und insbesondere direkt mit diesen verbunden sein können und dadurch den ersten Pol oder die ersten Pole der Aktuatorvorrichtung AV ausbilden. Die Aktuator-Anschlussbeschichtung 31 a, 32a, 33a ist insbesondere aus einer Schicht 31 c, 32c, 33c aus einem elektrisch leitenden und insbesondere metallischen Material gebildet, die auf der in die negative Z-Richtung weisenden Seitenfläche oder Stirnfläche 11 c, 12c, 13c des jeweiligen Aktuators 11, 12, 13 gelegen ist. Die Schicht 31 c, 32c, 33c steht elektrisch mit den ersten inneren Betätigungs-Elektroden E1, E3 in Verbindung und ist insbesondere direkt mit diesen verbunden.

In den dargestellten Ausführungsformen der Aktuatorvorrichtung AV weist jeder Aktuatorkörper 11a, 12a, 13a eine Stufe oder ein sich in der Z-Richtung erstreckendes zungenförmiges Anschlussstück oder eine zungenförmige Verlängerung 11 b, 12b, 13b auf, so dass der Aktuatorkörper 11 a, 12a, 13a jeweils aus einem Aktuatorkörper-Betätigungsstück B und einem Anschlussstück 11 b, 12b, 13b mit der in der Z-Richtung verlaufenden Tiefe oder Länge t30 gebildet ist. Die Anschlussstücke 11b, 12b, 13b sind an ihrer in die Y-Richtung weisenden Oberfläche jeweils mit einer Aktuator-Anschlussbeschichtung 31a, 32a, 33a aus einem elektrisch leitenden und insbesondere metallischen Material beschichtet. Bei dieser Ausführungsform ist somit die Aktuator-Anschlussbeschichtung 31 a, 32a, 33a durch die auf der jeweiligen Seitenfläche des Aktuatorkörper-Betätigungsstücks B gelegenen Teilschicht oder Betätigungsstück-Anschlussschicht 31 c, 32c, 33c mit der Dicke d31c, d32c, d33c und der auf der zungenförmigen Verlängerung 31 b, 32b, 33b gelegenen Aktuatoranschluss-Beschichtung mit der Dicke d31 b, d32b, d33b gebildet. Weiterhin ist die auf der in die negative Z-Richtung weisenden Seitenfläche 11 c, 12c, 13c des jeweiligen Aktuators 11, 12, 13 gelegene Teilschicht 31c, 32c, 33c mit der Betätigungsstück-Anschlussschicht 31 c, 32c, 33c verbunden und kann insbesondere mit der Betätigungsstück-Anschlussschicht 31 c, 32c, 33c einstückig ausgebildet sein, um eine einheitliche erste Anschluss-Beschichtung 31 a, 32a, 33a zu bilden. Auf diese Weise kann der jeweilige erste Pol der Betätigungsvorrichtung an der Aktuator-Anschlussbeschichtung 31 a, 32a, 33a angeschlossen werden.

Bei einer weiteren Ausführungsform der erfindungsgemäßen Aktuatorvorrichtung AV kann diese generell auch derart ausgeführt sein, dass diese kein zungenförmiges Anschlussstück oder keine zungenförmige Verlängerung 11 b, 12b, 13b mit einer jeweiligen Aktuator-Anschlussbeschichtung 31 a, 32a, 33a aufweist, so dass die Teilschichten oder Betätigungsstück-Anschlussschichten 31 c, 32c, 33c die elektrischen Anschlüsse für die Betätigungsvorrichtung oder den ersten Pol bilden

Die erfindungsgemäße Aktuatorvorrichtung AV weist ein Rückführungs-Teilstück 20 zur Ausbildung eines zweiten elektrischen Pols auf. Das Rückführungs-Teilstück 20 weist den Rückführungskörper 21 und weiterhin einen Rückführungsabschnitt 26 mit einer in die negative X-Richtung weisenden Rückführungsabschnitt-Oberfläche 26a und einen sich in der Y-Richtung von diesem aus erstreckenden Stützabschnitt 25 auf. In der Y-Richtung gesehen hat der Rückführungsabschnitt 26 eine Höhe h26 und der Stützabschnitt 25 eine Höhe h25, so dass bei der Ausführungsform der Figur 1 der Rückführungskörper 21 eine Höhe h21 = h26 + h25 hat.

Bei einer Ausführungsform der erfindungsgemäßen Aktuatorvorrichtung AV sind die Aktuatorkörper 11a, 12a, 13a in der Längsrichtung oder der x-Richtung gesehen hintereinander gelegen und ist der Rückführungskörper 21 in der x-Richtung gesehen hinter der Reihe von Aktuatorkörpern 11 a, 12a, 13a gelegen. Dabei kann insbesondere vorgesehen sein, dass die Oberfläche 26r des Rückführungskörpers 21 und die Oberfläche 2a der Rückseite 2 des Grundkörpers 10 eine einheitliche und insbesondere ebene Oberfläche bildet. Unter "einheitlich" wird in diesem Zusammenhang verstanden, dass sich die Oberfläche entlang der X-Richtung erstreckt. Insbesondere kann dabei vorgesehen sein, dass die Oberfläche eine über ihre Erstreckung einheitliche Krümmung aufweist, also keinen Wendepunkt besitzt.

Der Oberflächen-Bereich, mit dem der Rückführungsabschnitt 26 an der Rückseite 2 auftritt, ist mit dem Bezugzeichen 26r versehen.

In der Figur 1 a ist eine Ausführungsform der erfindungsgemäßen Aktuatorvorrichtung AV gezeigt, die jeweils an ihren in X-Richtung gesehen gegenüberliegenden Stirnseiten SF1, SF2 ein Rückführungs-Teilstück 20-1, 20-2 aufweist. In den weiteren Figuren ist ein Rückführungs-Teilstück generell mit dem Bezugszeichen 20 bezeichnet und dessen hierin beschriebenen Ausführungsformen können an jeder der Stirnseiten SF1, SF2 angeordnet sein. Die Rückführungs-Teilstücke 20-1 bzw. 20-2 können nach einer der hierin genannten Ausführungsformen und insbesondere identisch gestaltet sein. In der Darstellung der Figur 1 a sind die Aktuatoren schematisch als einzelne Striche eingetragen, die summarisch mit dem Bezugszeichen 11 i versehen sind.

Die X-Koordinate des hierin verwendeten Koordinatensystems kann insbesondere derart definiert sein, dass der Ursprung des Koordinatensystems in dem Mittelpunkt des Kantenabschnitts liegt, der die Rückführungsabschnitt-Oberfläche 26a und die Unterseite SL miteinander verbindet. Die X-Koordinate verläuft dabei quer zur Längserstreckung der Aktuatoren 11, 12, 13, die sich von der Vorderseite 1 zur Rückseite 2 erstrecken, und durch den Mittelpunkt eines die Unterseite SL in der positiven X-Richtung abschließenden Kantenabschnitts, der insbesondere derjenige Kantenabschnitt sein kann, der eine Oberfläche, die in Bezug auf die Y-Richtung entgegen gesetzt zu der Rückführungsabschnitt-Oberfläche 26a weist und an der Unterseite SL anliegt, mit der Unterseite SL verbindet. Zur Definition des Koordinatensystems verläuft die Z-Achse durch die beiden vorderen, also an der Rückführungsabschnitt-Oberfläche 26a gelegenen unteren Eckpunkte Z1, Z2 der Aktuatorvorrichtung AV. Dabei ist der Punkt Z1 als Schnittpunkt der Unterseite SL, der Rückführungsabschnitt-Oberfläche 26a und der Vorderseite 1 und der Punkt Z2 als Schnittpunkt der Unterseite SL, der Rückführungsabschnitt-Oberfläche 26a und der Rückseite 2 definiert.

Bei dem genannten Kantenabschnitt oder den Punkten Z1, Z2 können ein idealisierter Kantenabschnitt oder können idealisierte Punkte verwendet werden, wenn bei einer Ausführung oder Realisierung der erfindungsgemäßen Aktuatorvorrichtung AV an den Stellen, an denen der Kantenabschnitt oder die Punkte angenommen werden, ein gerundeter Übergangsabschnitt bzw. jeweils eine abgerundete Ecke vorliegt. In diesem Fall ist nach der hierin gegebenen Definition vorgesehen, dass der Kantenabschnitt oder die Punkte zur Definition der Lage des Koordinatensystems an der Aktuatorvorrichtung AV durch Verlängerung der Erstreckung der jeweils dafür verwendeten Oberflächen oder Seiten gebildet wird bzw. werden, also gegebenenfalls der Rückführungsabschnitt-Oberfläche 26a, der Vorderseite 1, der Unterseite SL, der Rückführungsabschnitt-Oberfläche 26a oder der Rückseite 2.

Hierin kann bei entsprechenden gerundeten Oberflächenbereichen generell zur Definition einer Kantenlinie oder eines Punkte eine idealisierte Kantenlinie bzw. ein idealisierter Punkt verwendet werden, die aus dem Schnittpunkt von Verlängerungen der Erstreckung von zwei jeweiligen benachbarten und aufeinander zu verlaufenden Oberflächen entsteht bzw. entstehen. Unter Erstreckung kann hierbei eine Länge von 1/10 der Länge verstanden werden, über die sich die jeweilige Fläche in der jeweils relevanten und diese definierenden Richtung erstreckt.

Die in die Y-Richtung weisende Oberfläche 21 a des Rückführungskörpers 21 ist bei der Ausführungsform der Figur 1 unbeschichtet, so dass die Oberfläche 21 a des Rückführungskörpers 21 identisch mit der Oberfläche 21 a des Rückführungs-Teilstücks 20 ist.

Alternativ oder zusätzlich zur Beschichtung der in die negative X-Richtung weisenden Rückführungsabschnitt-Oberfläche 26a kann generell bei den Ausführungsformen der erfindungsgemäßen Aktuatorvorrichtung AV auch die in die positive X-Richtung weisende und dem Aktuator 11 zugewandte Rückführungsabschnitt-Oberfläche 26b mit einer elektrisch leitfähigen Schicht beschichtet sein.

Der Rückführungsabschnitt 26 kann ein Rückführungs-Zusatzstück oder Rückführungs-Anschlussstück 23 aufweisen, das insbesondere als Stützabschnitt ausgeführt sein kann und in der negativen Z-Richtung gesehen im Bereich der Anschlussstücke 11 b, 12b, 13b gelegen ist. Das Rückführungs-Anschlussstück 23 erhebt sich in der Y-Richtung gesehen um die Höhe h23 über die Oberfläche 40. Bei den Ausführungsformen der erfindungsgemäßen Aktuatorvorrichtung AV kann generell vorgesehen sein, dass das Anschlussstück 23 an seiner in der positiven Y-Richtung weisenden Oberfläche 23d mit einer elektrisch leitenden und insbesondere metallischen Rückführungs-Anschlussbeschichtung oder äußeren Anschlussschicht 23a mit der Dicke d23a beschichtet ist, der einen zweiten elektrischen Pol zum Anschluss der Betätigungsvorrichtung bildet.

Die Rückseite 2 des Grundkörpers 10 ist mit einer Rückseiten-Schicht 4 aus einem elektrisch leitenden und insbesondere metallischen Material beschichtet. Die Dicke der Rückseiten-Schicht 4 kann in der X-Richtung und in der Z-Richtung konstant sein. Auch kann generell bei den Ausführungsformen der erfindungsgemäßen Aktuatorvorrichtung AV vorgesehen sein, dass die Dicke d4b der Rückseitenschicht 4 im Bereich des Basiskörpers 10a bzw. im Bereich des Basiskörpers 10a, der an die Unterseite SL grenzt größer ist als die Dicke d4a der Rückseitenschicht 4 im Bereich des Aufbaukörpers 10b bzw. im Bereich des Aufbaukörpers 10b, der an die Oberseite SU grenzt, wobei insbesondere vorgesehen sein kann, dass die Dicke d4b um den Faktor 1,5 größer ist als die Dicke d4a.

Die Rückseiten-Schicht 4 steht elektrisch mit den zweiten inneren Betätigungs-Elektroden E2, E4 der Aktuatorvorrichtung AV in Verbindung und ist insbesondere direkt mit diesen verbunden. Die Rückseiten-Schicht 4 ist mit einer Rückführungs-Außenschicht 5 elektrisch verbunden und insbesondere einstückig mit dieser ausgebildet, wobei die Rückführungs-Außenschicht 5 ihrerseits mit der Rückführungsanschlussbeschichtung 23a verbunden und insbesondere einstückig mit dieser ausgebildet sein kann.

In der Ausführungsform der Figur 1 ist die Rückführungs-Außenschicht 5 aus einem Stirnseiten-Schichtabschnitt 24mit einer Oberfläche 24a gebildet, die elektrisch mit einem Rückseiten-Schichtabschnitt 22 als Abschnitt der Rückseiten-Schicht 4 verbunden ist. Die Dicke des Stirnseiten-Schichtabschnitts 24 kann in der Y-Richtung und in der Z-Richtung konstant sein. Auch kann generell bei den Ausführungsformen der erfindungsgemäßen Aktuatorvorrichtung AV vorgesehen sein, dass die Dicke d24b an bzw. im Bereich der Unterseite größer ist als die Dicke d24a des Stirnseiten-Schichtabschnitts 24 an bzw. im Bereich der Oberseite SU, wobei insbesondere vorgesehen sein kann, dass die Dicke d24b um den Faktor 1,5 größer als die Dicke d24a ist.

Um die vorgesehenen Aktuatoren 11, 12, 13 oder einige der Aktuatoren 11, 12, 13 separat anzusteuern, kann die elektrische Betätigungsvorrichtung mehrere erste elektrische Pole aufweisen und die Betätigungsvorrichtung derart eingerichtet sein, dass diese für jeden der ersten elektrischen Pole unterschiedliche Steuerspannungen bzw. Steuerströme erzeugen kann, so dass bei dieser Ausführungsform die Betätigungsvorrichtung die Aktuatoren 11, 12, 13 einzeln bzw. unterschiedlich betätigen kann. Nach einer weiteren Ausführungsform kann vorgesehen sein, dass sämtliche Aktuatoren 11, 12, 13 oder einige Aktuatoren 11, 12, 13 der Betätigungsvorrichtung AV jeweils an einem einzigen ersten elektrischen Pol angeschlossen sind, so dass diese in derselben Weise betätigt werden können.

Der zweite Pol der Betätigungsvorrichtung ist ebenfalls an der Vorderseite 1 der Aktuatorvorrichtung AV und bei der Ausführungsform gemäß Figur 1 an der Rückführungsanschlussbeschichtung 23a anschließbar bzw. angeschlossen. Hierzu weist die erfindungsgemäße Aktuatorvorrichtung AV eine äußere Verbindungsschicht oder Rückführungs-Verbindungsschicht 5 auf, die mit der Rückseiten-Schicht 4 vorzugsweise einstückig elektrisch verbunden ist.

Der Rückführungskörper 21 kann auch lediglich auch aus dem Rückführungsabschnitt 26 als Bestandteil des Basisabschnitts 10a bestehen, so dass dieser keinen in der Y-Richtung aufgesetzten Stützabschnitt 25 aufweist (Figuren 19 bis 30), so dass der Rückführungskörper 21 eine Höhe h21 = h26 hat.

Der Rückführungskörper 21 kann je nach dem Herstellungsverfahren zur Herstellung des Grundkörpers 10 oder der Aktuatorvorrichtung AV mit einem Aktuatorbereich 9 des Grundkörpers 10 einstückig und insgesamt als monolithischer Block ausgebildet sein. Alternativ dazu kann der Rückführungskörper 21 nach einem alternativen Herstellungsverfahren zur Herstellung des Grundkörpers 10 oder der Aktuatorvorrichtung AV mit dem Aktuatorbereich 9 als separates Stück ausgeführt sein, dass an dem Aktuatorbereich 9 angeklebt ist. Für diesen Fall ist schematisch in der Darstellung der Figuren 1 und 2 eine Klebeschicht 50 eingetragen.

Je nach der Ausführungsform des Rückführungskörpers 21 kann die Klebeschicht 50 auch an einer anderen Stelle und insbesondere in der X-Richtung gegenüber der in der Figur 1 gezeigten Stelle verschoben sein. Dabei kann der Rückführungskörper 21 auch einen Teil des sich in der Y-Richtung erstreckenden Bereichs des Grundkörpers 10 ausbilden, in dem die Ausnehmung 40 gelegen ist, so dass die Klebeschicht 50 in der X-Richtung gesehen im Bereich der Ausnehmung 40 gelegen ist. Auch kann die Klebeschicht 50 schräg verlaufen und dabei z.B. in einem spitzen Winkel zur Y-Achse und entlang der Z-Richtung verlaufen.

Bei der Ausbildung des Rückführungskörpers 21 aus dem Rückführungsabschnitt 26 und dem Stützabschnitt 25 kann insbesondere vorgesehen sein, dass die Oberseite 21 a des Rückführungskörpers 21 in der Y-Richtung gesehen auf derselben Höhe wie die Aktuatorkörperoberflächen 11 e, 12e, 13e der Aktuatoren 11, 12, 13 liegen, dass also h0 =h21 ist, so dass auf die Oberseite SU der erfindungsgemäßen Aktuatorvorrichtung AV und somit auf die Aktuatoren 11, 12, 13 oder die Aktuatorkörper 11a, 12a, 13a sowie auf die Oberfläche 21a eine formveränderliche Anwendungskomponente aufgelegt werden kann. Bei dieser Ausführungsform der erfindungsgemäßen Aktuatorvorrichtung hat der Rückführungskörper 21 mit dem Stützabschnitt 25 zusätzlich zur Funktion der Strom-Rückführung über die Rückführungs-Verbindungsschicht 5 eine Abstützfunktion, indem der Stützabschnitt 25 einen entsprechenden Abschnitt einer solchen Anwendungskomponente aufnimmt und lagert. Für diesen Fall kann insbesondere vorgesehen sein, dass - wie in der Figur 1 gezeigt - die Oberseite 21 a desselben nicht mit einem elektrisch leitfähigen Material beschichtet ist. Bei der Ausführung nach der Figur 1 ist die Rückführungs-Verbindungsschicht 5 aus einem Schicht-Abschnitt 22 an der Rückseite 2 und einem Schicht-Abschnitt 24 an der ersten Stirnseite SF1 gebildet, die wiederum mit der Rückführungs-Anschlussbeschichtung 23a verbunden ist. Diese Schichten sind aus einem elektrisch leitfähigen Material gebildet. Auf diese Weise ist ein besonders effektiver Stromfluss bei einer einfachen und günstigen Herstellungsweise der erfindungsgemäßen Aktuatorvorrichtung AV sichergestellt.

Bei den Ausführungsformen der erfindungsgemäßen Aktuatorvorrichtung AV kann generell vorgesehen sein, dass an der in die negative X-Richtung weisenden Stirnseite SF1 das Rückführungs-Teilstück 20 ausgebildet ist. An einer in die positive X-Richtung weisenden Stirnseite (nicht gezeigt) der erfindungsgemäßen Aktuatorvorrichtung AV kann ebenfalls ein Rückführungs-Teilstück 20 nach einer hierin beschriebenen Ausführungsform derselben ausgebildet sein, die identisch oder unterschiedlich zu dem an der gegenüberliegenden Stirnseite gelegenen Rückführungs-Teilstück 20 ausgeführt sein kann. Alternativ dazu kann an der in die positive X-Richtung weisenden Stirnseite (nicht gezeigt) der erfindungsgemäßen Aktuatorvorrichtung AV ein Aktuator gelegen sein.

Die Figur 3 zeigt eine weitere Ausführungsform der erfindungsgemäßen Aktuatorvorrichtung AV, die gegenüber der in den Figuren 1 und 2 gezeigten Ausführungsform in dem Rückführungskörper 21 aufweist: zumindest eine erste innere Rückführungs-Elektrode RE1, RE3, die sich in der positiven Z-Richtung von der Vorderseite 1 bis zu einem Abstand c2 zu der Rückseite 2 hin erstreckt und zumindest eine zweite innere Rückführungs-Elektrode RE2, RE4, die sich in der negativen Z-Richtung von der Rückseite 2 bis zu einem Abstand c1 zur Vorderseite 1 hin erstreckt. Bei den Ausführungsformen der erfindungsgemäßen Aktuatorvorrichtung AV können die Rückführungs-Elektroden generell vorgesehen sein.

Bei der in der Figur 4 gezeigten Ausführungsform der erfindungsgemäßen Aktuatorvorrichtung AV ist an der Oberseite jedes Aktuatorkörpers 11a, 12a, 13a eine in der Y-Richtung verlaufende Nut 151, 152, 153 eingebracht. Weiterhin ist jeder Aktuator 11, 12, 13 mit einer elektrisch leitfähigen Schicht beschichtet, wobei die jeweilige Nut 151, 152, 153 tiefer ist als die Dicke der jeweiligen Schicht, so dass jeder Aktuator 11, 12, 13 eine in der negativen Z-Richtung seitlich der Nut gelegene Schicht (Bezugszeichen 153-1 für den Aktuator 13) und eine in der negativen Z-Richtung seitlich der Nut gelegene Schicht aufweist (Bezugszeichen 153-2 für den Aktuator 13). Die beiden jeweils in Bezug auf eine Nut eines Aktuators 11, 12, 13 gegenüber liegenden Schichten sind somit elektrisch getrennt. Zur Veranschaulichung ist in der Figur 4 für den Aktuator 13 die Dicke d153-2a der Schicht 153-2 und die Tiefe t153 der Nut 153 eingezeichnet. Die in der negativen Z-Richtung seitlich der Nut gelegene Schicht (Bezugszeichen 153-1 für den Aktuator 13) ist verbunden mit der Aktuatoranschluss-Beschichtung 31a, 32a, 33a und insbesondere der Betätigungsstück-Anschlussschicht 31c, 32c, 33c. Weiterhin ist die in der positiven Z-Richtung seitlich der Nut gelegene Schicht (Bezugszeichen 153-2 für den Aktuator 13) verbunden mit der Rückseiten-Schicht 4.

Diese Realisierung mit Schichten zusammen mit einer Nut am jeweiligen Aktuator hat den Vorteil, dass bei entsprechender Betätigung zur Auslenkung desselben auch der zwischen der Elektrode E4 und der Oberseite der Aktuatorkörper 11 a, 12,a, 13a gelegene Bereich zur Auslenkung des jeweiligen Aktuators beitragen kann.

Bei der in der Figur 4 gezeigten Ausführungsform der erfindungsgemäßen Aktuatorvorrichtung AV kann optional vorgesehen sein, dass auch an der Oberseite 21 a des Rückführungskörpers 21 eine in der Y-Richtung verlaufende Nut 120 eingebracht ist. Weiterhin ist der Rückführungskörper 21 mit einer elektrisch leitfähigen Schicht beschichtet, wobei die Nut 120 tiefer ist als die Dicke der jeweiligen Schicht, so dass der Rückführungskörper 21 eine in der negativen Z-Richtung seitlich der Nut gelegene Schicht (Bezugszeichen 153-1 für den Aktuator 13) und eine in der negativen Z-Richtung seitlich der Nut gelegene Schicht aufweist (Bezugszeichen 153-2 für den Aktuator 13). Die beiden jeweils in Bezug auf eine Nut eines Rückführungskörpers 21 gegenüber liegenden Schichten sind somit elektrisch getrennt. Zur Veranschaulichung ist in der Figur 4 für den Aktuator 13 die Dicke d153-2a der Schicht 153-2 und die Tiefe t153 der Nut 153 eingezeichnet. Die in der negativen Z-Richtung seitlich der Nut gelegene Schicht (Bezugszeichen 153-1 für den Aktuator 13) ist verbunden mit der Aktuatoranschluss-Beschichtung 31a, 32a, 33a und insbesondere der Betätigungsstück-Anschlussschicht 31 c, 32c, 33c. Weiterhin ist die in der positiven Z-Richtung seitlich der Nut gelegene Schicht (Bezugszeichen 153-2 für den Aktuator 13) verbunden mit der Rückseiten-Schicht 4.

Die Nuten des jeweiligen Aktuatorkörpers 11 a, 12a, 13a sind in Bezug auf eine Mittellinie M0, die die entlang der X-Koordinate verlaufende Mittellinie (t1=t2) der in Z-Richtung verlaufenden Längserstreckung des jeweiligen Aktuatorkörpers 11a, 12a, 13a ist (in den dargestellten Ausführungsformen haben die Aktuatorkörper 11a, 12a, 13a in der Z-Richtung dieselbe Länge, so dass die Mittellinie M0 für alle Aktuatorkörper 11a, 12a, 13a identisch ist), die seitlich, also entweder näher an der Vorderseite 1 (Figur 5) oder näher an der Rückseite 2 (Figur 4) angeordnet. Insbesondere kann vorgesehen sein, dass die Mittellinie der in die Y-Richtung weisenden Oberfläche 11f, 12f, 13f um mehr als 50% des Betrags von t1 bzw. t2 seitlich der Mittelinie M0 gelegen ist. Je nachdem, ob die jeweilige Nut eines Aktuators 11, 12, 13 näher an der Vorderseite 1 oder näher an der Rückseite 2 gelegen ist, ergibt sich eine spezifisches Wirkung für die Verformung des jeweiligen Aktuatoren 11, 12, 13.

Die an Hand der Figuren 4 und 5 beschriebenen Merkmale mit den Nuten an der Oberseite SU der Aktuatoren 11, 12, 13 und optional an der Oberseite 21 a des Rückführungskörpers 21 können nach der Erfindung auch in Kombination mit anderen hierin beschriebenen und insbesondere gezeigten Ausführungsformen der Erfindung vorgesehen sein.

Bei der Lage der Nut bei Ausführungsformen der Aktuatorvorrichtung AV gemäß Figur 5 ist keine zusätzliche Aktivierung der Aktuatorkörper-Schicht zwischen der Schicht 151-1 a, 152-1 a, 153-1 a und der dieser jeweils nächstgelegenen inneren Elektrode (Bezugszeichen E4) gegeben, wenn die jeweils nächstgelegene innere Elektrode (Bezugszeichen E4), an der Rückseitenschicht 4 angeschlossen ist und die jeweilige Schicht 151-1 a, 152-1 a, 153-1 a sich in einem gerringeren Abstand als a1 von der jeweiligen Schicht 31 c, 32c, 33c aus erstreckt und sich somit die jeweilige Schicht 151-1 a, 152-1 a, 153-1 a die nächstgelegene innere Elektrode (Bezugszeichen E4) nicht überlappt, so dass sich kein Überlappungsbereich der Elektrode E4 und der jeweiligen Schicht 151-1 a, 152-1 a, 153-1 a bei gegensätzlichen Polungen der jeweilige Schicht 151-1 a, 152-1 a, 153-1 a gegenüber der dieser jeweils nächstgelegenen inneren Elektrode (Bezugszeichen E4) ergibt.

Zwischen der Schicht 151-1 a, 152-1 a, 153-1 a und der dieser jeweils nächstgelegenen inneren Elektrode (Bezugszeichen E4) ist eine zusätzliche Aktivierung der Aktuatorkörper-Schicht dann gegeben, wenn die jeweils nächstgelegene innere Elektrode (Bezugszeichen E4), an der Rückseitenschicht 4 angeschlossen ist und die jeweilige Schicht 151-1a, 152-1a, 153-1a von der jeweiligen Schicht 31c, 32c, 33c aus gesehen die nächstgelegene innere Elektrode (Bezugszeichen E4) überlappt, da sich in dem sich dadurch ergebenden Überlappungsbereich eine gegensätzliche Polung der jeweilige Schicht 151-1a, 152-1 a, 153-1 a gegenüber und der dieser jeweils nächstgelegenen inneren Elektrode (Bezugszeichen E4) ergibt.

Die Figur 6 zeigt eine perspektivische Darstellung eines Teils einer weiteren Ausführungsform der erfindungsgemäßen Aktuatorvorrichtung AV. Bei dieser Ausführungsform ist eine bezüglich der negativen Y-Richtung stufenartige Dickenvergrößerung 60 der Rückseiten-Schicht 4 an der Rückseite 2 und der Rückführungskörper-Seitenschicht 24 an der Stirnseite SF vorgesehen. Die Stufe an der Rückseite 2 ist mit dem Bezugszeichen 61 und die Stufe an der Stirnseite SF mit dem Bezugszeichen 62 bezeichnet. Die Stufenflanke 61a bzw. 62a kann dabei auch schräg zur XZ-Ebene verlaufen. Unter Stufe 60 wird in diesem Zusammenhang eine Dickenreduktion um eine Differenz d4c bzw. d24c verstanden, die in einem in Y-Richtung verlaufenden Abschnitt auftritt, der dem Betrag nach geringer ist als der Betrag von d4c bzw. d24c. In der dargestellten Ausführungsform ist ein an der Unterseite SL anschließender Randabschnitt von der Höhe h60 dicker ausgeführt als im Bereich in der Y-Richtung gesehen oberhalb desselben gelegener Bereich der Rückseiten-Schicht 4 an der Rückseite 2 und dem Stirnseiten-Schichtabschnitt 24.

Durch die Dickenveränderung kann die elektrische Leistung, die durch die Rückseiten-Schicht 4 an der Rückseite 2 bzw. dem Stirnseiten-Schichtabschnitt oder der Rückführungskörper-Seitenschicht 24 geführt werden kann, auf einfache Weise eingestellt und den Erfordernissen an die jeweilige Aktuatorvorrichtung AV angepasst werden. Ein weiterer Vorteil ist, dass bei einer speziellen Realisierung der Rückführungskörper-Seitenschicht oder des Stirnseiten-Schichtabschnitts 24 bzw. der Rückseiten-Schicht 4 durch das Vorsehen einer entsprechend großen Dicke d24c bzw. d4c im unteren Bereich der Rückführungskörper-Seitenschicht 24 bzw. der Rückseiten-Schicht 4 die Aktuatorvorrichtung AV ohne innere Rückführungs-Elektroden (z.B. RE1, RE2, RE3, RE4) in dem Rückführungskörper 21 ausgeführt werden kann.

Nach einer Variante dieser Ausführungsform der Aktuatorvorrichtung AV kann die Dickenveränderung nur an der Rückführungskörper-Seitenschicht oder dem Stirnseiten-Schichtabschnitt 24 und nicht an der Rückseiten-Schicht 4 ausgebildet sein.

Generell kann dabei vorgesehen sein, dass die durchschnittliche Dicke (z.B. d4b bzw. d24b) der Rückführungskörper-Seitenschicht 24 bzw. der Rückseiten-Schicht 4 im unteren Bereich, die sich jeweils über die Erstreckung der Rückführungskörper-Seitenschicht 24 bzw. der Rückseiten-Schicht 4 in Y-Richtung ergibt, um den Faktor 1,5 größer ist als die durchschnittliche Dicke (z.B. d4b bzw. d24b) der Rückführungskörper-Seitenschicht 24 bzw. der Rückseiten-Schicht 4 im Bereich oberhalb der Stufe 61 bzw. 62, die sich jeweils über die Erstreckung der Rückführungskörper-Seitenschicht 24 bzw. der Rückseiten-Schicht 4 in Y-Richtung ergibt.

Die Figur 8 zeigt eine weitere Ausführungsform der erfindungsgemäßen Aktuatorvorrichtung AV, die gegenüber der in den Figuren 6 und 7 gezeigten Ausführungsform in dem Rückführungskörper 21 aufweist: zumindest eine erste innere Rückführungs-Elektrode RE1, RE3, die sich in der positiven Z-Richtung von der Vorderseite 1 bis zu einem Abstand c2 zu der Rückseite 2 hin erstreckt und zumindest eine zweite innere Rückführungs-Elektrode RE2, RE4, die sich in der negativen Z-Richtung von der Rückseite 2 bis zu einem Abstand c1 zur Vorderseite 1 hin erstreckt.

Die in den Figuren 9 und 10 gezeigte Ausführungsform der Aktuatorvorrichtung AV weist ein Grundkörper-Endstück 29 auf. Dieses Grundkörper-Endstück 29 kann zusätzlich bei den hierin genannten Ausführungsformen der Aktuatorvorrichtung AV vorgesehen sein. Das Grundkörper-Endstück 29 erstreckt sich von der Unterseite SL und einem mittleren Abschnitt des Rückführungsabschnitts 26 weg in die negative X-Richtung. Von der Unterseite SL aus gesehen erstreckt sich das Grundkörper-Endstück 29 in der Y-Richtung in einer Höhe h29a und bildet dabei eine in die negative X-Richtung weisende Oberfläche 29a und eine von dieser auf die Rückführungsabschnitt-Oberfläche 26a zu verlaufende und eine Tiefe t29a bildende Oberseite 29c. An dieser Stelle ist eine Schichtdicke d24e gegeben, die gleich oder ungleich und insbesondere größer als die Dicke d24a sein kann. Auf der Rückseite 2 der Aktuatorvorrichtung AV weist das Grundkörper-Endstück 29 eine Oberfläche 29d auf. Die Oberflächen 29a, 29c, 29d sind bei der Ausführungsform der Aktuatorvorrichtung AV nach der Figur 9 nicht beschichtet. Die Aktuatorvorrichtung AV kann auch auf der entgegen gesetzt zu der Stirnseite SF1 gelegenen weiteren Stirnseite ebenfalls ein solches Grundkörper-Endstück 29 aufweisen (nicht gezeigt). Die in den Figuren 9 und 10 gezeigte Ausführungsform der erfindungsgemäßen Aktuatorvorrichtung AV ist ohne innere Rückführungs-Elektroden (z.B. RE1, RE2, RE3, RE4 gemäß Figur 3) in dem Rückführungskörper 21 im Rückführungsabschnitt 26 realisiert.

Ein Vorteil des Grundkörper-Endstücks 29 der in den Figuren 9 und 10 gezeigten Ausführungsform der Aktuatorvorrichtung AV ist, dass mit dem Grundkörper-Endstück 29 eine Anpassung der Aktuatorvorrichtung AV zum Einbau derselben in ein Anwendungssystem auf einfach Weise erfolgen kann.

Die Figur 11 zeigt eine weitere Ausführungsform der erfindungsgemäßen Aktuatorvorrichtung AV, die gegenüber der in den Figuren 9 und 10 gezeigten Ausführungsform in dem Rückführungskörper 21 aufweist: zumindest eine erste innere Rückführungs-Elektrode RE1, RE3, die sich in der positiven Z-Richtung von der Vorderseite 1 bis zu einem Abstand c2 zu der Rückseite 2 hin erstreckt und zumindest eine zweite innere Rückführungs-Elektrode RE2, RE4, die sich in der negativen Z-Richtung von der Rückseite 2 bis zu einem Abstand c1 zur Vorderseite 1 hin erstreckt. Durch die Rückführungs-Elektrode RE1, RE2, RE3, RE4 zusammen mit der Rückführungskörper-Seitenschicht bzw. dem Stirnseiten-Schichtabschnitt 24 besteht die Möglichkeit einer Anpassung der Aktuatorvorrichtung AV zur Rückführung einer elektrischen Mindestleistung auf die Rückseiteseite 2 von der Vorderseite 1 aus.

Die in den Figuren 12 und 13 gezeigte Ausführungsform der Aktuatorvorrichtung AV weist ebenfalls das Grundkörper-Endstück 29 auf. Diese Ausführungsform der erfindungsgemäßen Aktuatorvorrichtung AV ist ohne innere Rückführungs-Elektroden (z.B. RE1, RE2, RE3, RE4 gemäß Figur 3) in dem Rückführungskörper 21 im Rückführungsabschnitt 26 realisiert. Auf der Oberfläche 29c[FOST1] des Grundkörper-Endstücks 29 ist eine elektrisch leitende Schicht 29e mit einer in die Y-Richtung weisenden Oberfläche 29f aufgebracht, durch die die Möglichkeit der Rückführung von zusätzlicher elektrischer Leistung auf die Rückseite 2 besteht.

Die Figur 14 zeigt eine weitere Ausführungsform der erfindungsgemäßen Aktuatorvorrichtung AV, die gegenüber der in den Figuren 12 und 13 gezeigten Ausführungsform in dem Rückführungskörper 21 aufweist: zumindest eine erste innere Rückführungs-Elektrode RE1, RE3, die sich in der positiven Z-Richtung von der Vorderseite 1 bis zu einem Abstand c2 zu der Rückseite 2 hin erstreckt und zumindest eine zweite innere Rückführungs-Elektrode RE2, RE4, die sich in der negativen Z-Richtung von der Rückseite 2 bis zu einem Abstand c1 zur Vorderseite 1 hin erstreckt. Durch die Rückführungs-Elektroden RE1, RE2, RE3, RE4 zusammen mit der Rückführungskörper-Seitenschicht 24 besteht die Möglichkeit der Rückführung von zusätzlicher elektrischer Leistung auf die Rückseite 2 sowie einer Anpassung der Aktuatorvorrichtung AV zur Rückführung einer elektrischen Mindestleistung auf die Rückseite.

Die Figuren 15 und 16 zeigen eine weitere Ausführungsform der erfindungsgemäßen Aktuatorvorrichtung AV, bei der auch die Oberfläche 29d des Grundkörper-Endstücks 29 durch einen elektrisch leitenden Schichtabschnitt 22d des Rückseiten-Schichtabschnitts 22 beschichtet ist. Die Aktuatorvorrichtung AV kann auch auf der entgegen gesetzt zu der Stirnseite SF1 gelegenen weiteren Stirnseite ebenfalls ein solches Grundkörper-Endstück 29 aufweisen (nicht gezeigt). Diese Ausführungsform der erfindungsgemäßen Aktuatorvorrichtung AV ist ohne innere Rückführungs-Elektroden (z.B. RE1, RE2, RE3, RE4 gemäß Figur 3) in dem Rückführungskörper 21 bzw. dessen Rückführungsabschnitt 26 realisiert.

Die Figur 17 zeigt eine weitere Ausführungsform der erfindungsgemäßen Aktuatorvorrichtung AV, die gegenüber der in den Figuren 15 und 16 gezeigten Ausführungsform in dem Rückführungskörper 21 aufweist: zumindest eine erste innere Rückführungs-Elektrode RE1, RE3, die sich in der positiven Z-Richtung von der Vorderseite 1 bis zu einem Abstand c2 zu der Rückseite 2 hin erstreckt und zumindest eine zweite innere Rückführungs-Elektrode RE2, RE4, die sich in der negativen Z-Richtung von der Rückseite 2 bis zu einem Abstand c1 zur Vorderseite 1 hin erstreckt. Durch die Rückführungs-Elektroden RE1, RE2, RE3, RE4 zusammen mit der Rückführungskörper-Seitenschicht 24 besteht die Möglichkeit der Rückführung von zusätzlicher elektrischer Leistung auf die Rückseite 2 sowie einer Anpassung der Aktuatorvorrichtung AV zur Rückführung einer elektrischen Mindestleistung auf die Rückseite.

Die in der Figur 18 gezeigte Ausführungsform der Aktuatorvorrichtung AV weist neben dem Grundkörper-Endstück 29 oder dem ersten Grundkörper-Endstück 29 ein weiteres oder zweites Grundkörper-Endstück 28 auf. Auf der Oberfläche 28c des Grundkörper-Endstücks 28 ist eine elektrisch leitende Schicht 28e mit einer in die Y-Richtung weisenden Oberfläche 28f aufgebracht, durch die die Möglichkeit der Rückführung von zusätzlicher elektrischer Leistung auf die Rückseite 2 besteht. Die Aktuatorvorrichtung AV kann auch auf der entgegen gesetzt zu der Stirnseite SF1 gelegenen weiteren Stirnseite ebenfalls ein solches Grundkörper-Endstück wie das Grundkörper-Endstück 29 aufweisen (nicht gezeigt). Diese Ausführungsform der erfindungsgemäßen Aktuatorvorrichtung AV ist ohne innere Rückführungs-Elektroden (z.B. RE1, RE2, RE3, RE4 gemäß Figur 3) in dem Rückführungskörper 21 bzw. in dessen Rückführungsabschnitt 26 realisiert.

Nach der Ausführungsform der erfindungsgemäßen Aktuatorvorrichtung gemäß Figur 19 ist der Rückführungsabschnitt 26 ohne einen sich in der Y-Richtung von diesem aus erstreckenden Stützabschnitt 25 gestaltet und erstreckt sich von der Unterseite SL bis in eine Höhe h26 (vgl. Figur 1), die gleich der Höhe h43 ist, so dass der Rückführungskörper 21 und - bei der gegebenen Ausführungsform - der Rückführungsabschnitt 26 in der Y-Richtung gesehen dieselbe Höhe haben wie die in der X-Richtung gesehen neben dieser gelegenene Oberfläche 40. Bei dieser Ausführungsform hat somit der Rückführungsabschnitt 26 keine Stützfunktion. Das Rückführungs-Anschlussstück 23 kann als Bestandteil des Rückführungsabschnitts 26 verstanden werden. Bei dieser Ausführungsform ist die in die Y-Richtung weisende Oberfläche 21 a des Rückführungskörpers 21 mit der Außenschicht 26c mit der Dicke d26c, die auch die Rückführungsanschlussbeschichtung 23a bildet, beschichtet, die sowohl mit dem Rückseitenschichtabschnitt 22 an der Rückseite 2 und einem Stirnseitenschichtabschnitt 24 an der Stirnseite SF elektrisch verbunden und insbesondere einstückig ausgeführt ist. Dies erlaubt einen besonders effektiven Stromfluss bei einer besonders einfachen und besonders günstigen Herstellungsweise der erfindungsgemäßen Aktuatorvorrichtung AV und eine besonders vorteilhafte Lösung, mit der eine relativ große elektrische Leistung auf die Rückseite 2 rückgeführt werden kann.

Die Figuren 20 und 21 zeigen weitere Ausführungsformen der erfindungsgemäßen Aktuatorvorrichtung AV, die gegenüber der in der Figuren 1 und 2 gezeigten Ausführungsform jeweils Nuten 151, 152, 153 an der Oberseite der Aktuatoren 11, 12, 13 und optional an der Oberseite 21a der Rückführungskörper 21, wie sie mit ihrer Funktion an Hand der Figuren 4 und 5 beschrieben worden sind, haben.

Die Ausführungsform der erfindungsgemäßen Aktuatorvorrichtung gemäß Figur 22 basiert auf der in der Figur 19 dargestellten Ausführungsform, wobei die Rückführungsabschnitt-Oberfläche 26a an der ersten Stirnseite SF1 nicht mit einem elektrisch leitfähigen Material beschichtet ist, so dass gegenüber der Ausführungsform nach der Figur 10 kein Stirnseitenschichtabschnitt 24 vorgesehen ist. Dadurch kann die Rückführungsabschnitt-Oberfläche 26a an Anschlussstellen oder Befestigungsvorrichtungen eines Anwendungssystems angepasst werden, so dass eine verbesserte mechanische Integrationsmöglichkeiten der erfindungsgemäßen Aktuatorvorrichtung AV gegeben ist.

Die Figuren 23 und 24 zeigen weitere Ausführungsformen der erfindungsgemäßen Aktuatorvorrichtung AV basierend auf der in der Figur 22 gezeigten Ausführungsform, die gegenüber der in der Figuren 1 und 2 gezeigten Ausführungsform jeweils Nuten 151, 152, 153 an der Oberseite der Aktuatoren 11, 12, 13 und optional an der Oberseite 21a des Rückführungskörpers 21 haben, und deren Funktion an Hand der Figuren 4 und 5 beschrieben worden ist.

Die in der Figur 25 gezeigte weitere Ausführungsform der erfindungsgemäßen Aktuatorvorrichtung AV weist einen Rückführungsabschnitt 26 auf, der einteilig mit dem Rückführungs-Anschlussstück 23 gebildet ist und sich gegenüber der in der Figur 19 dargestellten Ausführungsform der Aktuatorvorrichtung AV in Z-Richtung gesehen über die gesamte Tiefe der Aktuatorvorrichtung AV erstreckt und sich von der Ausnehmungsoberfläche 40 an der Rückseite 2 mit der Höhe h25 und an der Vorderseite 1 mit der Höhe h21a erhebt, so dass der Rückführungsabschnitt 26 den Rückführungskörper 21 bildet. Bei dieser Ausführungsform erstreckt sich die Rückführungskörperanschlussbeschichtung 23a von der Rückseite 2 bis zur Vorderseite 1 und ist mit der Rückseiten-Schicht 4 verbunden.

Die Figuren 26 und 27 zeigen jeweils eine weitere Ausführungsform der erfindungsgemäßen Aktuatorvorrichtung AV, die eine an der Oberseite jedes Aktuatorkörpers 11a, 12a, 13a in der Y-Richtung verlaufende Nut 151, 152, 153 aufweist. Weiterhin ist jeder Aktuator 11, 12, 13 mit einer elektrisch leitfähigen Schicht beschichtet, wobei die jeweilige Nut 151, 152, 153 tiefer ist als die Dicke der jeweiligen Schicht, so dass jeder Aktuator 11, 12, 13 eine in der negativen Z-Richtung seitlich der Nut gelegene Schicht (Bezugszeichen 153-1 für den Aktuator 13) und eine in der negativen Z-Richtung seitlich der Nut gelegene Schicht aufweist (Bezugszeichen 153-2 für den Aktuator 13). Die beiden jeweils in Bezug auf eine Nut eines Aktuators 11, 12, 13 gegenüber liegenden Schichten sind somit elektrisch getrennt.

Die in der Figur 28 gezeigte weitere Ausführungsform der erfindungsgemäßen Aktuatorvorrichtung AV basiert auf der in der Figur 25 gezeigten Ausführungsform, gegenüber der bei der Ausführungsform der Figur 28 die in die negative X-Richtung weisenden Rückführungsabschnitt-Oberfläche 26a nicht beschichtet ist.

Die Figuren 29 und 30 zeigen jeweils eine weitere Ausführungsform der erfindungsgemäßen Aktuatorvorrichtung AV, die gegenüber der in den Figuren 25 und 26 gezeigten Ausführungsform eine an der Oberseite jedes Aktuatorkörpers 11a, 12a, 13a in der Y-Richtung verlaufende Nut 151, 152, 153 aufweist. Weiterhin ist jeder Aktuator 11, 12, 13 mit einer elektrisch leitfähigen Schicht beschichtet, wobei die jeweilige Nut 151, 152, 153 tiefer ist als die Dicke der jeweiligen Schicht, so dass jeder Aktuator 11, 12, 13 eine in der negativen Z-Richtung seitlich der Nut gelegene Schicht (Bezugszeichen 153-1 für den Aktuator 13) und eine in der negativen Z-Richtung seitlich der Nut gelegene Schicht aufweist (Bezugszeichen 153-2 für den Aktuator 13). Die beiden jeweils in Bezug auf eine Nut eines Aktuators 11, 12, 13 gegenüber liegenden Schichten sind somit elektrisch getrennt.

Nach der Ausführungsform der erfindungsgemäßen Aktuatorvorrichtung gemäß Figur 31 ist an der Rückseite 2 eine Sammel-Elektrode 70 angeordnet, die elektrisch mit der Rückseiten-Schicht 4 verbunden ist und insbesondere in diese übergeht. Auf diese Weise wird der Stromfluss an der Rückseite 2 unterstützt, da diese nicht mehr-wie nach den Ausführungsformen der Figuren 1 bis 30 - nur durch die Rückseiten-Schicht 4, sondern auch durch die Sammel-Elektrode 70 fließt. Dies ist insbesondere zur Unterstützung des Stromflusses im Bereich der Ausnehmungen S2, S3 vorteilhaft.

Bei der Ausführungsform der Figur 31 ist das Rückführungs-Teilstück 20 gemäß Figur 1 und bei der Ausführungsform der Figur 31 ist das Rückführungs-Teilstück 20 gemäß Figur 19 gebildet. Figur 32 eine perspektivische Darstellung eines Teils einer weiteren auf der Ausführungsform der Figur 31 basierenden Ausführungsform der erfindungsgemäßen Aktuatorvorrichtung in der Darstellungsweise der Figur 31, bei der gegenüber der in der Figur 32 dargestellten Ausführungsform das Rückführung-Teilstück 20 keinen Stützabschnitt aufweist,

Alternativ oder zusätzlich kann bei den Ausführungsformen der Figuren 31 und 32 insbesondere aus demselben technischen Grund vorgesehen sein, dass die Rückseiten-Schicht 4 in der Z-Richtung gesehen an dem Basiskörper 10a des Grundkörpers 10 an der Rückseite 2 eine größere Dicke d4b hat als in den Bereichen 10b, den die Aktuatoren 11, 12, 13 an der Rückseite 2 der Aktuatorvorrichtung AV ausbilden (Figur 4).

Nach der Ausführungsform der erfindungsgemäßen Aktuatorvorrichtung AV gemäß Figur 33 ist in dem Basiskörper 10a zumindest eine Schwindungsanpassungs-Elektrode oder sind Schwindungsanpassungs-Elektroden 80, 90 eingebracht. Diese dienen dazu, einen Schwindungsprozess insbesondere bei der Herstellung des Grundkörpers 10 aus einem piezoelektrischen oder elektrostriktiven Material in einem Sinterprozess zu erreichen, bei dem der Grundkörper 10 eine weitgehend einheitliche Schwindung erfährt. Die Schwindungsanpassungs-Elektroden 80, 90 können in der Aktuatorvorrichtung AV in jeder der in den Figuren 1 bis 32 gezeigten Ausführungsformen derselben zusätzlich angeordnet sein und sind beispielartig in der in den Figuren 1 und 2 gezeigten Ausführungsform angeordnet.

Generell sind die Schwindungsanpassungs-Elektroden 80, 90 im Basiskörper 10a gelegen. Bei diesen Ausführungsformen ist der Basiskörper 10a derjenige Teil des Grundkörpers 10, der in der Y-Richtung gesehen unterhalb der Ausnehmungs-Oberflächen 40, 41, 42 gelegen ist. Im Bereich der Aktuatoren 11, 12, 13 ist der Basiskörper 10a in der Y-Richtung gesehen begrenzt durch die Verbindungsebene, in denen die Kantenlinien (z.B. für den Aktuator 11 die Kantenlinien K11-1 und K11-2) des jeweiligen Aktuators mit dem jeweiligen Anschlussstück (z.B. des Aktuators 11 mit dem Anschlussstück 11 b) liegen. Im Bereich des Rückführungskörpers 21 ist der Basiskörper in der positiven Y-Richtung begrenzt durch die XZ-Ebene, in der die Kantenlinie 40a oder zumindest der in der Y-Richtung gesehen höchste Punkt der Kantenlinie 40a gelegen ist. Diese Definition des Basiskörpers 10a kann generell für den Basiskörper 10a einzelner oder aller Ausführungsformen der erfindungsgemäßen Aktuatorvorrichtung AV gelten.

Somit kann der Basiskörper 10a generell als der Teil des Grundkörpers 10 verstanden werden, von dem aus sich die den Aufbaukörper 10b bildenden Aktuatoren mit den Anschlussstücken der Aktuatoren 11 b, 12b, 13c sowie gegebenenfalls das Rückführungs-Anschlussstück 23 des Rückführungs-Teilstücks 20 und gegebenenfalls der Stützabschnitt 25 erstrecken. In den Figuren 19 bis 21 sind Ausführungsformen der erfindungsgemäßen Aktuatorvorrichtung AV gezeigt, bei denen sich von dem Basiskörper 10a mit dem Aktuatorbereich 9 und dem Rückführungsabschnitt 26 kein Anschlussstück 23 (Figuren 19 bis 24) oder Stützabschnitt 25 (Figuren 1 bis 18 und Figuren 25 bis 30) erstreckt. Alternativ dazu kann der Rückführungsabschnitt 26 als Bereich definiert sein, der von der Unterseite SL bis zur Verlängerung der flächigen Erstreckung der Ausnehmungs-Oberfläche 40 reicht. Die Ausführungsformen der erfindungsgemäßen Aktuatorvorrichtung AV können auch derart gestaltet sein, dass die Ausnehmungs-Oberflächen 40, 41, 42 auf einer Ebene oder Ausnehmungs-Ebene liegen, die auch als die Grenze verstanden werden kann, bis zu der der Basiskörper 10a reicht.

Generell weist also die Aktuatorvorrichtung AV einen Basiskörper 10a auf, von dem aus sich die Aktuatoren 11, 12, 13 erstrecken.

Die Schwindungsanpassungs-Elektroden 80, 90 sind plattenförmig ausgeführt und erstrecken sich jeweils entlang der ZX-Ebene, wobei insbesondere ein maximaler Abweichungswinkel einer Schwindungsanpassungs-Elektrode von der ZX-Ebene um 15 Grad vorgesehen sein kann. Die Schwindungsanpassungs-Elektroden 80, 90 werden bei Herstellung der Ausgangsmaterialien und insbesondere des Basiskörpers 10a zur Bildung einer jeweiligen Aktuatorvorrichtung AV angeordnet.

Die Schwindungsanpassungs-Elektroden 80, 90 sind insbesondere vorgesehen, wenn die Aktuatorvorrichtung AV aus einem ersten Vorrichtungs-Bauteil, der zumindest teilweise den Basiskörper 10a und nicht die Aktuatoren 11, 12, 13 aufweist, und einem ersten Vorrichtungs-Bauteil, das die Aktuatoren 11, 12, 13 aufweist, als jeweils separate Bauteile zusammengesetzt ist, wie dies beispielsweise in den Figuren 40 bis 50 gezeigt und an Hand dieser Figuren hierin beschrieben ist.

Die Schwindungsanpassungs-Elektroden 80, 90 können oder die zumindest eine Schwindungsanpassungs-Elektrode kann in verschiedener Weise gestaltet und in der Aktuatorvorrichtung AV gelegen sein. Vorzugsweise sind die Schwindungsanpassungs-Elektroden 80, 90 an den Stirnseiten SF1, SF2 angeordnet. Zusätzlich kann vorgesehen sein, dass zumindest eine Schwindungsanpassungs-Elektrode mit Randabschnitten an der Rückführungsabschnitt-Oberfläche 26a anliegt. Auf diese Weise wird gerade an den Randabschnitten der erfindungsgemäßen Aktuatorvorrichtung AV, an denen Seitenflächen gelegen sind und insbesondere die Rückführungsabschnitt-Oberfläche 26a gelegen ist, eine Schwindung des Basiskörpers 10a in dessen Randbereichen und somit ein Verzug oder eine Krümmung des Basiskörpers 10a entlang der X-Achse (um die Z-Achse) im Herstellungsprozess verhindert. Weiterhin kann vorgesehen sein, dass die zumindest eine Schwindungsanpassungs-Elektrode an der Rückseiten-Schicht 4 anliegt. Auf diese Weise ist eine solche derart angeordnete Schwindungsanpassungs-Elektrode auch im elektrischen Kontakt mit der Rückseiten-Schicht 4.

Es kann generell vorgesehen sein, dass die zumindest eine Schwindungsanpassungs-Elektrode 80, 90 an der Rückführungs-Verbindungsschicht 5 anliegt. Insbesondere kann generell vorgesehen sein, dass die zumindest eine Schwindungsanpassungs-Elektrode 80, 90 an einer oder mehreren Seitenflächen der Aktuatorvorrichtung AV anliegt, z.B. zumindest an der Rückführungsabschnitt-Oberfläche 26a und zugleich an der Rückseite 2 und dabei insbesondere an dem Rückseitenabschnitt 26r.

Generell kann weiterhin vorgesehen sein, dass sich die zumindest eine Schwindungsanpassungs-Elektrode 80, 90 in der Z-Richtung von der Rückseite 2 zur Vorderseite 1 erstreckt. Es kann auch vorgesehen sein, dass die jeweilige Schwindungsanpassungs-Elektrode an einer der beiden Seiten, also an der Rückseite 2 oder der Vorderseite 1 anliegt. Die Schwindungsanpassungs-Elektrode 80, 90 kann dabei mit einem Randabschnitt in einem Abstand zu der Rückführungsabschnitt-Oberfläche 26a verlaufen. Zum einen kann dabei vorgesehen sein, dass sich die Schwindungsanpassungs-Elektrode von der Rückseite 2 und an dieser anliegend bis zur Vorderseite 1 und dabei an dieser anliegend erstreckt. Zum anderen kann vorgesehen sein, dass sich die jeweilige Schwindungsanpassungs-Elektrode von der Rückseite 2 und dabei von dieser beabstandet bis zur Vorderseite 1 und dabei von dieser beabstandet erstreckt. Der Abstand zwischen der jeweiligen Schwindungsanpassungs-Elektrode und der Rückseite 2 oder der Vorderseite 1 kann insbesondere bis zu 20% der Längenerstreckung der Rückführungsabschnitt-Oberfläche 26a in der Z-Richtung betragen.

Generell kann die Anordnung der Schwindungsanpassungs-Elektrode oder die Anordnungen der Schwindungsanpassungs-Elektroden an den Rückführungsabschnitt-Oberflächen 26a beider Stirnseiten SF1, SF2 oder nur an einer der beiden Stirnseiten SF1, SF2 vorliegen.

Auch kann zumindest eine Lage von jeweils mehreren Schwindungsanpassungs-Elektroden vorgesehen sein. Eie Lage meint in diesem Zusammenhang, dass mehrere Schwindungsanpassungs-Elektroden auf einer XZ-Ebene mit einer Abweichung von 15% der Längenerstreckung der Rückführungsabschnitts-Oberfläche 26a in der Z-Richtung gelegen ist. Die in der Figur 33 dargestellte Ausführungsform der erfindungsgemäßen Aktuatorvorrichtung AV weist an der ersten Stirnseite SF1 eine erste Lage 80 und eine zweite Lage 90 von Schwindungsanpassungs-Elektroden auf. Dieselbe oder eine andere Konstellation von Schwindungsanpassungs-Elektroden kann ebenso an der zweiten Stirnseite SF2 derselben Aktuatorvorrichtung AV angeordnet sein. Grundsätzlich kann vorgesehen sein, dass im Basiskörper 10a nur eine Lage oder mehr als zwei Laqen von Schwindungsanpassungs-Elektroden gelegen ist bzw. sind.

Die in der Figur 33 dargestellte erste Lage 80 und zweite Lage 90 von Schwindungsanpassungs-Elektroden weist die Schwindungsanpassungs-Elektroden 81, 82 auf, die mit einem Randabschnitt 81 a bzw. 82a in der Rückseite 4 gelegen sind, also aus dem Basiskörper 10a austreten. Weiterhin weist die in der Figur 33 dargestellte erste Lage 80 und zweite Lage 90 von Schwindungsanpassungs-Elektroden jeweils eine Schwindungsanpassungs-Elektrode 83, 93 auf, die mit einem Randabschnitt 83b bzw. 93b in der Rückseite 4 und mit einem Randabschnitt 83a bzw. 93a in der Rückführungsabschnitt-Oberfläche 26a gelegen ist. Auch weist die in der Figur 33 dargestellte erste Lage 80 und zweite Lage 90 von Schwindungsanpassungs-Elektroden jeweils zwei Schwindungsanpassungs-Elektroden 84, 85 bzw. 94, 95 auf, die mit einem Randabschnitt 84a, 85a bzw. 94a, 95a in der Rückführungsabschnitt-Oberfläche 26a gelegen ist.

Bei der dargestellten Ausführungsform wie generell kann vorgesehen sein, dass einzelne Schwindungsanpassungs-Elektroden verschiedener Lagen, also z.B. die Schwindungsanpassungs-Elektroden 81 und 91, in der Y-Richtung übereinander angeordnet sind. Dabei kann auch vorgesehen sein, dass die jeweils übereinander gelegenen Schwindungsanpassungs-Elektroden identische Form haben.Bei den in den Figuren dargestellten Bemaßungsparametern können bei den erfindungsgemäß vorgesehenen Anwendungsfällen insbesondere die folgenden Abmessungen vorgesehen sein:
- b20: 0,05 mm bis 5 mm,
- h1: 0,5 mm bis 3 mm,
- h2: 0,1 mm bis 1,5 mm,
- h0: 1 mm bis 2,5 mm,
- d1, d2, d3: bei Dünnschicht (PVD)-Verfahren 0,5 µm bis 1,5 µm, bei chemisch-galvanischer Herstellung 2 µm bis 7 µm, bei Herstellung durch Siebdruckverfahren 10 µm bis 100 µm;
- h20: 1 mm bis 2,5 mm,
- b1: 0,05 mm bis 2,5 mm,
- b2: 0,05 mm bis 2,5 mm, insbesondere mit b1 = b2,
- a1: 0,1 mm bis 1 mm,
- a2: 0,1 mm bis 1 mm, insbesondere mit a1 = a2,
- DS1: 0,02 mm bis 1 mm,
- DS2: 0,02 mm bis 1 mm, insbesondere mit DS1 = DS2.

Grundsätzlich ist es nach der Erfindung nicht zwingend, dass der Rückführungskörper 21 an einer der Stirnseiten der Aktuatorvorrichtung AV angeordnet ist, sondern er kann auch zwischen zwei Aktuatoren 11, 12, 13 angeordnet sein.

Generell kann die erfindungsgemäße Aktuatorvorrichtung auch mehrere Rückführungskörper 21 aufweisen. Insbesondere kann dabei vorgesehen sein, dass an jeder der entgegen gesetzt zueinander gelegenen Stirnseiten der Aktuatorvorrichtung AV ein Rückführungskörper 21 angeordnet ist, so dass die Aktuatoren 11, 12, 13 zwischen diesen gelegen sind.

Der Rückführungskörper 21 kann aus einem piezoelektrischen oder elektrostriktiven Material gebildet und insbesondere einstückig mit dem Basiskörper 10a und den Aktuatoren 11, 12, 13 gebildet sein. Bei der Ausführungsform, bei der der Basiskörper 10a und die sich von diesem aus erstreckenden Aktuatoren 11, 12, 13 aus unterschiedlichen Materialien hergestellt sind und der Basiskörper 10a aus einem Material hergestellt ist, das nicht piezoelektrisch oder elektrostriktiv ist, kann vorgesehen sein, dass der Rückführungskörper 21 ebenfalls aus einem Material hergestellt ist, das nicht piezoelektrisch oder elektrostriktiv ist. Nach einer weiteren Ausführungsform kann dabei zusätzlich vorgesehen sein, dass der Rückführungskörper 21 und der Basiskörper 10a einstückig hergestellt sind.

Der Basiskörper 10a und die sich von diesem aus erstreckenden Aktuatoren 11, 12, 13 sind nach einer Ausführungsform der Aktuatorvorrichtung AV einstückig, also aus einem Stück hergestellt und dabei aus einem piezoelektrisch oder elektrostriktiven Material gebildet. Bei dieser Ausführungsform kann das aus dem Basiskörper 10a und den sich von diesem aus erstreckenden Aktuatoren 11, 12, 13 gebildete Bauteil dadurch hergestellt werden, dass zunächst ein Ausgangskörper aus einem piezoelektrisch oder elektrostriktiven Material gefertigt wird, der quaderförmig gebildet sein kann, und anschließend durch Ausbildung von Ausnehmungen S1, S2, S3 die Aktuatoren 11, 12, 13 gebildet werden. Dabei kann vorgesehen sein, dass die Ausnehmungen S1, S2, S3 durch entsprechenden Abtragungsvorgang wie beispielsweise Schleifen, Sägen oder Ausfräsen des Ausgangskörpers hergestellt werden.

Nach einem erfindungsgemäßen Verfahren zur Herstellung des Grundkörpers 10 nach einer Ausführungsform gemäß der Figuren 1 bis 33 wird ein monolithischer Block 100 als erstes Zwischenprodukt aus Schichten aus einem piezoelektrischen oder elektrostriktiven Material, die in der Dickenrichtung Y aufeinandergeschichtet sind, hergestellt (Figur 34). Der monolithische Block hat in der Höhenrichtung Y eine Höhe von zumindest h0 oder h20. In dem monolithischen Block sind die Elektroden E1, E2, E3, E4 jeweils als sich flächig entlang der XZ-Ebene erstreckende Schichten zwischen Schichten aus einem piezoelektrischen oder elektrostriktiven Material enthalten. In einem weiteren Schritt wird eine Gesamtbeschichtung (nicht gezeigt) vorgenommen, d.h. je nach der Ausführungsform eine Beschichtung von Außenflächen des monolithischen Blocks, wobei das Beschichtungsmaterial elektrisch leitfähig ist.

Nach einer ersten Ausführungsform des Verfahrens wird der monolithische Block 100 derart hergestellt, dass aus diesem die Aktuatorkörper 11a, 12a, 13a sowie der Rückführungskörper 21, auf denen durch eine nachfolgende Beschichtung zur Bildung der Aktuatoren 11, 12, 13 bzw. des zumindest einen Rückführungs-Teilstücks 20 erfolgen soll, herausgebildet werden kann (Figur 34). Durch Ausformen und insbesondere durch Sägen, Schleifen oder Fräsen der Ausnehmungen S0, S1, S2, S3 werden aus dem monolithischen Block der Grundkörper 10 mit dem Basiskörper 10a, den Aktuatorkörpern 11 a, 12a, 13a und dem Rückführungskörper 21 mit dem Stützabschnitt 25 gebildet (Figur 35), wobei der Rückführungskörper 21 aus demselben Material wie die Aktuatorkörper 11a, 12a, 13a gebildet ist. Weiterhin kann der Rückführungskörper 21 insbesondere aus demselben Material wie die Aktuatorkörper 11a, 12a, 13a und wie der Basiskörper 10a gebildet sein. Dieser Verfahrensablauf ist insbesondere vorteilhaft, wenn im Rückführungskörper 21 bzw. in dessen Stützabschnitt 25 dieselben Elektroden in Anzahl, Form und Lage enthalten sein sollen wie in den Aktuatoren 11, 12, 13 des herzustellenden Grundkörpers 10 (z.B. Ausführungsform gemäß der Figur 3). Dabei können zusätzlich zwei weitere Verfahrensschritte zur Herstellung einer Oberseiten-Nut (z.B. Ausführungsform gemäß Figur 4) vorgesehen sein. Anschließend wird zunächst eine Oberseiten-Beschichtung erzeugt. Diese kann bei einem Schritt zur Herstellung der Gesamtbeschichtung erfolgen. Die Gesamtbeschichtung umfasst bei der Ausführungsform nach Figur 1 die erste Anschlussschicht 31 a, 32a, 33a, die Rückführungs-Anschlussbeschichtung 23a, die Rückseiten-Schicht 4 sowie die Rückführungs-Verbindungsschicht 5. Anschließend erfolgt die Herstellung der Oberflächen-Nuten.

Alternativ kann die Herstellung der Oberflächen-Nuten nach Ausbildung des monolithischen Blocks und vor der Ausbildung der Ausnehmungen S0, S1, S2, S3 erfolgen. Dabei muss jedoch bei der Herstellung der Gesamtbeschichtung eine Abdeckung von Oberflächenbereichen erfolgen, die nach der jeweiligen Ausführungsform der erfindungsgemäßen Aktuatorvorrichtung AV nicht zu beschichten sind.

Alternativ dazu kann vorgesehen sein, dass der monolithische Block 200 derart hergestellt wird, dass aus diesem der Basiskörper und die Aktuatorkörper 11a, 12a, 13a, nicht jedoch der Rückführungskörper 21 herausgebildet werden können bzw. herausgebildet werden (Figur 36). In diesem Fall kann insbesondere vorgesehen sein, dass zunächst aus dem monolithischen Block durch Ausformen und insbesondere durch Aussägen, Schleifen oder Sägen die Ausnehmungen S0, S1, S2 hergestellt werden und an ein Teilstück 10c des Basiskörpers 10a, an dem die Ausnehmung 40 auszubilden ist, ein Zusatzblock Z-21 zur Ausbildung des Rückführungskörpers 21 an den hergestellten monolithischen Block angeklebt wird (Figur 37). Auf diese Weise ist der Grundkörper 10 mit dem Basiskörper, den Aktuatorkörpern 11a, 12a, 13a und dem Rückführungskörper 21 (hier einen Stützabschnitt 25 aufweisend) hergestellt. Dieser Verfahrensablauf ist insbesondere vorteilhaft, wenn im Rückführungskörper 21 keine oder nicht dieselben Elektroden in Anzahl, Form und Lage oder zusätzlich z.B. Schwindungsanpassungs-Elektroden enthalten sein sollen wie in den Aktuatoren 11, 12, 13 des herzustellenden Grundkörpers 10.

Nach einer hierzu alternativen Ausführungsform der Herstellung der Aktuatorvorrichtung AV wird ein Materialblock 301 und insbesondere ein erster Teilkörper oder ein monolithischer Block 301 aus einem piezoelektrischen oder elektrostriktiven Material mit darin eingebetteten Elektroden E1, E2, E3, E4 als separater Körper des Grundkörpers 10 hergestellt (Figur 38).

In einem darauf folgenden Verfahrensschritt wird der erste Teilkörper 301 mit seiner Oberfläche 301 b über eine Verbindungsschicht 303 mit der Oberfläche 302a eines zweiten Teilkörpers 302 verbunden, wobei es sich bei der Verbindungsschicht vorzugsweise um eine Klebeschicht handelt. Alternative Verbindungsarten mit einer entsprechenden Verbindungsschicht 303 sind denkbar, z.B. Löten oder Schweißen (Figur 39). Der zweite Teilkörper 302 kann dabei sowohl aus einem piezoelektrischen oder elektrostriktiven, als auch aus einem nicht-piezoelektrischen oder nichtelektrostriktiven Material bestehen. Der zweite Teilkörper kann insbesondere Al₂O₃ aufweisen oder aus Al₂O₃ bestehen. Es kann vorgesehen sein, dass -wie in Figur 39 dargestellt - der erste Teilkörper 301 in Z-Richtung eine andere, z.B. geringere Ausdehnung aufweist als der zweite Teilkörper 302. Ebenso kann vorgesehen sein, dass erster Teilkörper und zweiter Teilkörper in Z-Richtung gesehen die gleichen Dimensionen aufweisen.

Im weiteren Verfahrensablauf kann vorgesehen sein, dass durch Ausformen und insbesondere durch Sägen, Schleifen oder Fräsen der Ausnehmungen S0, S1, S2 der Grundkörper 10 mit dem Basiskörper 10a, den Aktuatorkörpern 11a, 12a, 13a und dem Rückführungskörper 21 mit dem Stützabschnitt 25 gebildet wird. Hierbei reichen die Ausnehmungen S0, S1, S2 bis hin zur Verbindungsschicht 303. Es kann auch vorgesehen sein, dass im Bereich der Ausnehmungen S0, S1, S2 durch den Ausformungsprozess die Verbindungsschicht 303 entfernt wird, so dass die Ausnehmungen bis zum zweiten Teilkörper 302 reichen.

In einem alternativen Verfahren kann der Teilkörper 301 gemäß Figur 38 in einem Verfahrensschritt in einzelne Abschnitte zerteilt werden, um so die Aktuatorkörper 11 a, 12a, 13a bzw. den Stützabschnitt 25 als separate Körper herzustellen, die dann in einem weiteren Verfahrensschritt auf dem den Basiskörper 10a bildenden zweiten Teilkörper 302 einzeln angeordnet und mit diesem stoffschlüssig verbunden und vorzugsweise aufgeklebt werden (Figur 40).

Bei einer Ausführungsform des erfindungsgemäßen Verfahrens gemäß Figur 41 kann vorgesehen sein, dass zur Ausbildung eines Zwischenprodukts 320 die Ausnehmungen S0, S1, S2 dabei derart ausgebildet werden, dass sich diese von der Oberfläche 301 b des ersten Teilkörpers 301 aus gesehen nur bis zu einem Abstand DA1, DA2, DA3 in positiver Y-Richtung oberhalb der Verbindungsschicht 303 erstrecken, so dass die Ausnehmungen S0, S1, S2 die Verbindungsschicht 303 nicht durchschneiden.

Bei einer weiteren Ausführungsform des erfindungsgemäßen Verfahrens gemäß Figur 42 kann vorgesehen sein, dass zur Ausbildung eines dazu alternativen Zwischenprodukts 330 die Ausnehmungen S0, S1, S2 dabei derart ausgebildet werden, dass sich diese von der Oberfläche 302a des zweiten Teilkörpers 302 aus gesehen bis zu einem Abstand DB1, DB2, DB3 in den zweiten Teilkörper 302 hinein erstrecken, so dass die Ausnehmungen S0, S1, S2 die Verbindungsschicht 303 durchschneiden. Auf diese Weise bilden sich Übergangsabschnitte U1, U2, U3, U21 an dem Basiskörper 302 bzw. 10a aus, an die sich in der Dickenrichtung Y gesehen jeweils ein Aktuatorkörper 11 a, 12a, 13a anschließt. Somit bilden die Aktuatorkörper 11a, 12a, 13a in einem unteren Bereich, der an den jeweiligen entstandenen Oberflächen 41, 42, 43 der Ausnehmungen S1, S2, S3 angrenzt, keine in der Längsrichtung X gesehen gegenüberliegenden Abschnitte mit einem piezoelektrischen oder elektrostriktiven Material aus.

Weiterhin kann vorgesehen sein, dass zur Ausbildung eines dazu alterrnativen Zwischenprodukts 340 die Ausformungen und z.B. Einfräsungen genau bis in die Verbindungsschicht 303 gehen (Figur 43). In einer in der Figur 43 dargestellten Weiterführung dieses Verfahrens ist ein Endstück oder sind zwei Endstücke an einander entgegen gesetzten Stirnseiten des Bauteils 341 jeweils ein Endstück 342 kraftschlüssig verbunden, das zur Ausbildung eines Rückführungskörpers 21 nach einer Ausführungsform der Erfindung geeignet ist.

Die Zwischenprodukte 301, 302 können auch derart geformt und miteinander verklebt und die Ausformungen können derart erfolgen, dass
▪ ein Zwischenprodukt 350 (Figur 44) erzeugt wird, mit dem eine Aktuatorvorrichtung AV in der in den Figuren 19 bis 24 dargestellten Ausführungsformen herstellbar ist,
▪ ein Zwischenprodukt 360 (Figur 45) erzeugt wird, mit dem eine Aktuatorvorrichtung AV in der in den Figuren 25 oder 26 dargestellten Ausführungsformen herstellbar ist,
▪ ein Zwischenprodukt 370 (Figur 46) erzeugt wird, mit dem eine Aktuatorvorrichtung AV in der in der Figur 27 dargestellten Ausführungsformen herstellbar ist.

Weiterhin kann vorgesehen sein, dass zur Ausbildung einer Ausführungsform der erfindungsgemäßen Aktuatorvorrichtung AV mit einem Grundkörper-Endstück 29 nach den Figuren 9 bis 17 oder mit zwei Endstücken Grundkörper-Endstücken 28 und 29 insbesondere nach der Figur 18 ein Zwischenprodukt 400 durch kraftschlüssiges Verbinden nach einem hierin genannten Verfahren von einem ersten Ausgangsprodukt 401 mit Elektroden E1, E2, E3, E4 wie z.B. auch bei dem Bauteil 301 der Figur 38 und einem zweiten Ausgangsprodukt 402 hergestellt wird. Die Ausgangsprodukte 401, 402 können derart miteinander verklebt und die Ausformungen können derart erfolgen, dass
▪ ein Zwischenprodukt 410 (Figur 48) erzeugt wird, mit dem eine Aktuatorvorrichtung AV in der in der Figur 18 dargestellten Ausführungsform herstellbar ist,
▪ eine Ausführungsform der erfindungsgemäßen Aktuatorvorrichtung AV, bei der zusätzlich Nuten 120, 151, 152, 153 geformt sind (vgl. Figur 4), die näher an der Rückseite 2 gelegen sind (Figur 49);
▪ eine Ausführungsform der erfindungsgemäßen Aktuatorvorrichtung AV, bei der zusätzlich Nuten 120, 151, 152, 153 geformt sind (vgl. Figur 5), die näher an der Vorderseite 1 gelegen sind (Figur 50).

## Patentansprüche

1. Aktuatorvorrichtung (AV), aufweisend:
- einen Grundkörper (10), aufweisend einen Basiskörper (10a) und einen Aufbaukörper (10b), wobei sich der Grundkörper (10) in einer Längsrichtung (X), einer quer zur Längsrichtung (X) verlaufenden Tiefenrichtung (Z) und einer quer zu der Längsrichtung (X) und quer zu der Tiefenrichtung (Z) gerichteten Dickenrichtung (Y), in deren Richtung die Aktuatorvorrichtung (AV) eine Oberseite (SU) zur Anlage einer Anwendungskomponente definiert, erstreckt und der eine Vorderseite (1), eine in Bezug auf die Längsrichtung (X) der Aktuatorvorrichtung (AV) entgegengesetzt zu der Vorderseite (1) gelegene Rückseite (2) sowie entgegen gesetzt zueinander gelegene und jeweils zwischen der Vorderseite (1) und der Rückseite (2) gelegene Stirnseiten (SF1, SF2) hat,
- eine Mehrzahl von den Aufbaukörper (10b) bildenden Aktuatoren (11, 12, 13), die jeweils aus einem piezoelektrischen oder elektrostriktiven Material gebildet sind und sich jeweils in der Dickenrichtung (Y) von dem Basiskörper (10a) aus erstrecken, wobei die Aktuatoren in der Längsrichtung (X) der Aktuatorvorrichtung (AV) hintereinander angeordnet sind und zwischen jeweils zwei benachbarten Aktuatoren (11, 12, 13) eine Ausnehmung (S0, S1, S2, S3) ausgebildet ist, wobei die Aktuatoren (11, 12, 13) jeweils zumindest zwei innere Betätigungs-Elektroden (E1, E2, E3, E4) aufweisen, von denen sich zumindest eine erste innere Betätigungs-Elektrode (E1, E3) in positiver Tiefenrichtung (Z) von der Vorderseite (1) bis zu einem Abstand (a2) zu der Oberfläche (2a) an der Rückseite (2) hin erstreckt und von denen sich zumindest eine zweite innere Betätigungs-Elektrode (E2, E4) in negativer Tiefenrichtung (Z) von der Rückseite (2) bis zu einem Abstand (a1) zur Oberfläche (11c, 12c, 13c) an der Vorderseite (1) hin erstreckt, wobei die zumindest eine erste innere Betätigungs-Elektrode (E1, E3) jedes Aktuators (11, 12, 13) zur elektrischen Verbindung mit einem ersten Anschlusspol einer Betätigungsvorrichtung vorgesehen ist,
- Aktuator-Anschlussbeschichtungen (31, 32, 33), die jeweils auf einer der an der Vorderseite (1) gelegenen Oberflächen (11c, 12c, 13c) der Aktuatoren (11, 12, 13) angeordnet sind und die jeweils mit der zumindest einen ersten inneren Betätigungs-Elektrode (E1, E3) der Aktuatoren (11, 12, 13) verbunden sind,
- zumindest einen Rückführungskörper (21), der in der Längsrichtung (X) der Aktuatorvorrichtung (AV) an einer Stirnseite (SF1, SF2) an einem Ende einer Reihe der Aktuatoren (11, 12, 13) gelegen ist und der einen an der Rückseite (2) gelegenen Rückseitenbereich (26r), eine an der jeweiligen Stirnseite (SF1, SF2) gelegene Rückführungsabschnitt-Oberfläche (26a) sowie eine an der Oberseite (SU) gelegene Oberfläche (21 a) aufweist,
- eine Rückseiten-Schicht (4), die aus elektrisch leitfähigem Material gebildet ist und sich flächig an der Rückseite (2) der Aktuatorvorrichtung (AV) über den Grundkörper (10) und den Rückseitenbereich (26r) des Rückführungskörpers (21) erstreckt sowie elektrisch mit der zumindest einen zweiten inneren Betätigungs-Elektrode (E2, E4) der Aktuatoren (11, 12, 13) verbunden ist,
- eine äußere Rückführungs-Verbindungsschicht (5), die elektrisch mit der Rückseiten-Schicht (4) verbunden und aus einem oder beiden der folgenden Alternativen gebildet ist:
(a) einer Rückführungskörper-Seitenschicht (24), die auf einer an der jeweiligen Stirnseite (SF1, SF2) gelegenen Rückführungsabschnitt-Oberfläche (26a) angeordnet ist,
(b) einer Außenschicht (26c), die auf der an der Oberseite (SU) gelegenen Oberfläche (21a) angeordnet ist,
- eine Rückführungs-Anschlussbeschichtung (23a) an der Vorderseite (1) der Aktuatorvorrichtung (AV) zur elektrischen Verbindung mit einem zweiten Anschlusspol der Betätigungsvorrichtung, wobei die RückführungsAnschlussbeschichtung (23a) elektrisch mit der äußeren Rückführungs-Verbindungsschicht (5) verbunden ist,
wobei der Abstand (a2) der jeweiligen ersten inneren Betätigungs-Elektrode (E1, E3) zu der Oberfläche (2a) an der Rückseite (2) und der Abstand (a1) der jeweiligen zweiten inneren Betätigungs-Elektrode (E2, E4) zur Vorderseite (1) derart vorgesehen ist, dass zur Ausübung eines piezoelektrischen oder inversen piezoelektrischen Effekts der Aktuatoren (11, 12, 13) an die Aktuator-Anschlussbeschichtung (31, 32, 33) und die Rückführungs-Anschlussbeschichtung (23a) jeweils zueinander entgegen gesetzte Pole einer Betätigungsvorrichtung anschließbar sind.

2. Aktuatorvorrichtung (AV) nach dem Anspruch 1, wobei die Aktuatorvorrichtung (AV) eine Aktuator-Anschlussbeschichtung (31a, 32a, 33a) aufweist, die mit der jeweiligen ersten inneren Betätigungs-Elektrode (E1, E3) der Aktuatoren (11, 12, 13) der Mehrzahl von Aktuatoren elektrisch verbunden ist und an die jeweils ein erster elektrischer Pol einer Mehrzahl von elektrischen Polen der Betätigungs-Vorrichtung zur unabhängigen Ansteuerung der einzelnen Aktuatoren (11, 12, 13) anschließbar ist.

3. Aktuatorvorrichtung (AV) nach einem der vorstehenden Ansprüche, wobei die äußere Rückführungs-Verbindungsschicht (5) aus der auf der Rückführungsabschnitt-Oberfläche (26a) angeordneten Rückführungskörper-Seitenschicht (24) gebildet ist und wobei in dem Rückführungskörper (21) innere Rückführungs-Elektroden (RE1, RE2, RE3, RE4) angeordnet sind, von denen sich zumindest eine erste innere Rückführungs-Elektrode (RE1, RE3) in positiver Tiefenrichtung (Z) von der Vorderseite (1) bis zu einem Abstand zu der Rückseite (2) hin erstreckt und von denen sich zumindest eine zweite innere Rückführungs-Elektrode (RE2, RE4) in negativer Tiefenrichtung (Z) von der Rückseite (2) bis zu einem Abstand zur Vorderseite (1) hin erstreckt.

4. Aktuatorvorrichtung (AV) nach dem Anspruch 3, wobei die in dem Rückführungskörper (21) angeordneten inneren Rückführungs-Elektroden (RE1, RE2, RE3, RE4) in Anzahl, Form und Lage wie die in den Aktuatoren (11, 12, 13) angeordneten inneren Betätigungs-Elektroden (E1, E2, E3, E4) ausgeführt sind.

5. Aktuatorvorrichtung (AV) nach einem der vorstehenden Ansprüche, wobei die Rückseiten-Schicht (4) im Bereich des Basiskörpers (10a) des Grundkörpers (10) eine größere Dicke (dv) in der Tiefenrichtung (Z) hat als im Bereich des Aufbaukörpers (10b).

6. Aktuatorvorrichtung (AV) nach einem der vorstehenden Ansprüche, wobei der Grundkörper (10) mit dem Basiskörper (10a) und dem Aufbaukörper (10b), der aus den die Aktuatoren (11, 12, 13) bildenden Aktuatorkörper (11a, 12a, 13a)gebildet ist, einen monolithischen Körper bildet.

7. Aktuatorvorrichtung (AV) nach einem der Ansprüche 1 bis 5, wobei der Basiskörper (10a) und der Aufbaukörper (10b) des Grundkörpers (10) jeweils als eigener Teilkörper gebildet ist.

8. Aktuatorvorrichtung (AV) nach dem Anspruch 7, wobei der Basiskörper (10a) und der Aufbaukörper (10b) aus jeweils unterschiedlichen Materialien hergestellt sind und der Basiskörper (10a) aus einem Material hergestellt ist, das nicht piezoelektrisch oder elektrostriktiv ist.

9. Aktuatorvorrichtung (AV) nach dem Anspruch 7 oder 8, wobei der Basiskörper (10a) und der Aufbaukörper (10b) miteinander verklebt sind.

10. Aktuatorvorrichtung (AV) nach einem der vorstehenden Ansprüche, wobei die Rückseiten-Schicht (4) und die Rückführungs-Verbindungsschicht (5) zusammen eine einstückige Schicht bilden.

11. Aktuatorvorrichtung (AV) nach einem der vorstehenden Ansprüche, wobei im Basiskörper (10a) zumindest eine plattenförmige Schwindungsanpassungs-Elektrode (80, 90) gelegen ist, wobei zumindest eine Schwindungsanpassungs-Elektrode (80, 90) derart im Basisteil (10a) gelegen ist, dass ein Randabschnitt derselben in jeder von zwei Rückführungsabschnitt-Oberflächen (26a, 26a-2) liegt, um ein lokales Schwindungsverhalten des Basiskörpers (10a) bei Herstellung desselben auszugleichen.

12. Aktuatorvorrichtung (AV) nach dem Anspruch 11, wobei die an der Rückführungsabschnitt-Oberfläche (26a, 26a-2) anliegende Schwindungsanpassungs-Elektrode (80, 90) in der Tiefenrichtung (Z) gesehen sich von der Rückseite (2) bis in den Bereich des Anschlussstücks (23) erstreckt.

13. Aktuatorvorrichtung (AV) nach einem der Ansprüche 11 oder 12, wobei die Rückführungsabschnitt-Oberfläche (26a) mit einem Stirnseiten-Schichtabschnitt (24) beschichtet ist.

## Claims

1. Actuator device (AV), comprising:
- a main body (10), comprising a base body (10a) and a buildup body (10b), wherein the main body (10) extends in a longitudinal direction (X), in a depth direction (Z) which runs cross to the longitudinal direction (X), and in a thickness direction (Y) which runs across to the longitudinal direction (X) and across to the depth direction (Z), in which thickness direction (Y), the actuator device (AV) defines an upper side (SU) for attaching an application component, and wherein the main body (10) has a front side (1), a back side (2) lying contrary to the front side (1) with regard to the longitudinal direction (X), and front faces (SF1, SF2) which lie contrary to each other and which lie between the front side (1) and the back side (2),
- a plurality of actuators (11, 12, 13) forming the buildup body (10b), each of which actuators (11, 12, 13) being formed of a piezoelectric or electrostrictive material and each of which actuators (11, 12, 13) extending from the base body (10a) in the thickness direction (Y), wherein the actuators (11, 12, 13) are arranged behind each other in the longitudinal direction (X) and a recess (S0, S1, S2, S3) is formed between each of two adjacent actuators (11, 12, 13), wherein the actuators (11, 12, 13) each comprise at least two inner actuation electrodes (E1, E2, E3, E4), at least one first inner actuation electrode (E1, E3) of the at least two inner actuation electrodes (E1, E2, E3, E4) extends in positive depth direction (Z) from the front side (1) to a distance (a2) to the surface (2a) on the back side (2), and at least one second inner actuation electrode (E2, E4) of the at least two inner actuation electrodes (E1, E2, E3, E4) extends in negative depth direction (Z) from the back side (2) to a distance (a1) to the surface (11c, 12c, 13c) on the front side (1), wherein the at least one first inner actuation electrode (E1, E3) of each actuator (11, 12, 13) is provided for electrical connection with a first connection pole of an actuating device,
- actuator connection coatings (31, 32, 33), each of which actuator connection coatings (31, 32, 33) being arranged on one of the surfaces (11 c, 12c, 13c) which lie on the front side (1), and each of which actuator connection coatings (31, 32, 33) being connected to the at least one first inner actuation electrode (E1, E3) of the actuators (11, 12, 13),
- at least one feedback body (21) which lies on an front face (SF1, SF2) at an end of a row of actuators (11, 12, 13) in the longitudinal direction (X) of the actuator device (AV) and which comprises a back side area (26r) lying on the back side (2), a feedback portion surface (26a) lying on the respective front face (SF1, SF2), and a surface (21 a) lying on the upper side (SU),
- a back side layer (4), which is formed of an electrically conducting material, and which extends in a planar fashion on the back side (2) of the actuator device (AV) over the main body (10) and the back side area (26r) of the feedback body (21), and which is electrically connected to the at least one second inner actuation electrode (E2, E4) of the actuators (11, 12, 13),
- an outer feedback connection layer (5) which is electrically connected to the back side layer (4) and which is formed of one or both of the following alternatives:
(a) a feedback body side layer (24) which is arranged on a feedback portion surface (26a) lying at the respective front face (SF1, SF2),
(b) an outer layer (26c) which is arranged on the surface (21 a) lying at the upper side (SU),
- a feedback connection coating (23a) at the front side (1) of the actuator device (AV) for electrically connection to a second connection pole of the actuating device, wherein the feedback connection coating (23a) is electrically connected to the outer feedback connection layer (5),
wherein the distance (a2) between the respective first inner actuation electrode (E1, E3) and the surface (2a) at the back side (2) and the distance (a1) between the respective second inner actuation electrode (E2, E4) and the front side (1) are provided such that opposite poles of an actuating device are connectable to the actuator connection coatings (31, 32, 33) and the feedback connection coating (23a), respectively, for exertion of a piezoelectric effect or an inverse piezoelectric effect of the actuators (11, 12, 13).

2. Actuator device (AV) according to claim 1, wherein the actuator device (AV) comprises an actuator connection coating (31 a, 32a, 33a) which is electrically connected to the respective first inner actuation electrode (E1, E3) of the actuators (11, 12, 13) of the plurality of actuators, and to each of which actuator connection coating (31 a, 32a, 33a) a first electrical pole of a plurality of electrical poles of the actuating device is connectable for independent control of the actuators (11, 12, 13).

3. Actuator device (AV) according to one of the preceding claims, wherein the outer feedback connection layer (5) is formed of feedback body side layer (24) being arranged on the feedback portion surface (26a), and wherein in the feedback body (21) inner feedback-electrodes (RE1, RE2, RE3, RE4) are arranged, at least one first inner feedback-electrode (RE1, RE3) of which inner feedback-electrodes (RE1, RE2, RE3, RE4) extending in positive depth direction (Z) from the front side (1) to a distance to the back side (2), and at least one second inner feedback-electrode (RE2, RE4) of which inner feedback-electrodes (RE1, RE2, RE3, RE4) extending in negative depth direction (Z) from the back side (2) to a distance to the front side (1).

4. Actuator device (AV) according to claim 3, wherein the inner feedback-electrodes (RE1, RE2, RE3, RE4) arranged in the feedback body (21) with regard to number, form and position, are realized in the same fashion as the inner actuation electrodes (E1, E2, E3, E4) of the actuators (11, 12, 13).

5. Actuator device (AV) according to one of the preceding claims, wherein the back side layer (4) in the depth direction (Z) comprises a greater thickness (dv) in the area of the base body (10a) of the main body (10) than in the area of the buildup body (10b).

6. Actuator device (AV) according to one of the preceding claims, wherein the main body (10) with the base body (10a) and with the buildup body (10b), which is formed from the actuator bodies (11a, 12a, 13a) forming the actuators (11, 12, 13), forms a monolithic body.

7. Actuator device (AV) according to one of the claims 1 to 5, wherein the base body (10a) and the buildup body (10b) of the main body (10) each are formed as a distinct partial-body.

8. Actuator device (AV) according to claim 7, wherein the base body (10a) and the buildup body (10b) each are produced from different materials, and wherein the base body (10a) is produced from a material which is not piezoelectric or electrostrictive.

9. Actuator device (AV) according to claim 7 or 8, wherein the base body (10a) and the buildup body (10b) are adhesively bonded to each other.

10. Actuator device (AV) according to one of the preceding claims, wherein back side layer (4) and the feedback connection layer (5) together form a layer formed as one piece.

11. Actuator device (AV) according to one of the preceding claims, wherein at least one shrinkage adaption electrode (80, 90) is located in the base body (10a), wherein at least one shrinkage adaption electrode (80, 90) is located in the base body (10a) in such a fashion that an edge portion of said shrinkage adaption electrode (80, 90) is located in each of two feedback portion surfaces (26a, 26a-2) in order to compensate a local shrinkage behavior of the base body (10a) during manufacturing of said base body (10a).

12. Actuator device (AV) according to claim 11, wherein the shrinkage adaption electrode (80, 90) lying adjacent to the feedback portion surface (26a, 26a-2) extends from the back side (2) into the area of the connection part (23) when viewed in the depth direction (Z).

13. Actuator device (AV) according to claim 11 or 12, wherein the feedback portion surface (26a) is coated with an front face layer portion (24).

## Revendications

1. Dispositif actionneur (AV) présentant:
- un corps principal (10) présentant un corps de base (10a) et un corps de montage (10b), le corps principal (10) s'étendant dans un sens de la longueur (X), un sens de la profondeur (Z) s'étendant transversalement au sens de la longueur (X), et un sens de l'épaisseur (Y) orienté transversalement au sens de la longueur (X) et transversalement au sens de la profondeur (Z), dans le sens duquel le dispositif actionneur (AV) définit une face supérieure (SU) pour la mise en contact d'un composant d'application, et lequel possède une face avant (1), une face arrière (2) située en opposition à la face avant (1) compte tenu du sens de la longueur (X) du dispositif actionneur (AV) ainsi que des faces frontales (SF1, SF2) situées en opposition les unes par rapport aux autres et respectivement entre la face avant (1) et la face arrière (2),
- une pluralité d'actionneurs (11, 12, 13) formant le corps de montage (10b), lesquels sont respectivement formés par un matériau piézoélectrique ou électrostrictif et s'étendent respectivement dans le sens de l'épaisseur (Y) à partir du corps de base (10a), les actionneurs étant disposés de telle manière les uns derrière les autres dans le sens de la longueur (X) du dispositif actionneur (AV) et un évidement (S0, S1, S2, S3) étant respectivement formé entre deux actionneurs voisins, les actionneurs (11, 12, 13) présentant respectivement au moins deux électrodes d'actionnement internes (E1, E2, E3, E4), au moins une première électrode d'actionnement interne (E1, E3) d'entre elles s'étendant dans le sens de la profondeur positive (Z) depuis la face avant (1) jusqu'à une distance (a2) par rapport à la surface (2a) au niveau de la face arrière (2) et au moins une deuxième électrode d'actionnement interne (E2, E4) d'entre elles s'étendant dans les sens de la profondeur négative (Z) depuis la face arrière (2) jusqu'à une distance (a1) par rapport à la surface (11 c, 12c, 13c) au niveau de la face avant (1), cette au moins une première électrode d'actionnement interne (E1, E3) de chaque actionneur (11, 12, 13) étant prévue pour la connexion électrique avec une borne polaire de raccordement d'un dispositif d'actionnement,
- des revêtements de raccordement d'actionneur (31, 32, 33) qui sont respectivement disposés sur une des surfaces (11 c, 12c, 13c) situées sur la face avant (1) des actionneurs (11, 12, 13) et lesquelles sont respectivement reliées à cette au moins une première électrode d'actionnement interne (E1, E3) des actionneurs (11, 12, 13),
- au moins un corps de rétroaction (21), lequel est situé dans le sens de la longueur (X) du dispositif actionneur (AV) sur une face frontale (SF1, SF2) à une extrémité d'une rangée d'actionneurs (11, 12, 13) et lequel présente une zone de face arrière (26r) située sur la face arrière (2), une surface de partie de rétroaction (26a) située sur la face frontale (SF1, SF2) respective ainsi qu'une surface (21 a) située sur la face supérieure (SU),
- une couche de face arrière (4), laquelle est formée en un matériau électroconducteur et laquelle s'étend en nappe sur la face arrière (2) du dispositif actionneur (AV) au-dessus du corps principal (10) et de la zone de face arrière (26r) du corps de rétroaction (21) et laquelle est connectée électriquement à cette au moins une deuxième électrode d'actionnement interne (E2, E4) des actionneurs (11, 12, 13),
- une couche de liaison de rétroaction (5), laquelle est connectée électriquement à la couche de face arrière (4) et est réalisée grâce à l'une des deux alternatives suivantes, ou aux deux d'entre elles :
(a) une couche latérale de corps de rétroaction (24), laquelle est disposée sur une surface de partie de rétroaction (26a) située au niveau de la face frontale (SF1, SF2) respective,
(b) une couche extérieure (26c), laquelle est disposée sur la surface (21 a) située au niveau de la face supérieure (SU),
- un revêtement de raccordement de rétroaction (23a) sur la face avant (1) du dispositif actionneur (AV) pour la connexion électrique à une deuxième borne polaire de raccordement du dispositif d'actionnement, le revêtement de raccordement de rétroaction (23a) étant connecté électriquement à la couche de liaison de rétroaction (5) extérieure,
la distance (a2) entre la première électrode d'actionnement interne (E1, E3) respective et la surface (2a) au niveau de la face arrière (2) et la distance (a1) entre la deuxième électrode d'actionnement interne (E2, E4) respective et la face avant (1) étant prévues de manière à ce que, pour l'exercice d'un effet piézoélectrique ou d'un effet piézoélectrique inversé des actionneurs (11, 12, 13), des pôles opposés entre eux d'un dispositif actionneur peuvent être respectivement raccordés au revêtement de raccordement d'actionneur (31, 32, 33) et au revêtement de raccordement de rétroaction (23a).

2. Dispositif actionneur (AV) selon la revendication 1, dans lequel le dispositif actionneur (AV) présente un revêtement de raccordement d'actionneur (31 a, 32a, 33a), lequel est connecté électriquement à la première électrode d'actionnement interne (E1, E3) respective des actionneurs (11, 12, 13) de la pluralité des actionneurs et auquel il est possible de raccorder respectivement un premier pôle électrique d'une pluralité de pôles électriques du dispositif actionneur pour la commande indépendante des actionneurs (11, 12, 13) individuels.

3. Dispositif actionneur (AV) selon l'une des revendications précédentes, dans lequel la couche de liaison de rétroaction (5) est formée par la couche latérale de corps de rétroaction (24) disposée sur la surface de partie de rétroaction (26a), et dans lequel des électrodes de rétroaction internes (RE1, RE2, RE3, RE4) sont disposées dans le corps de rétroaction (21), au moins une première électrode de rétroaction interne (RE1, RE3) d'entre elles s'étendant dans le sens de la profondeur positive (Z) depuis la face avant (1) jusqu'à une distance par rapport à la face arrière (2) et au moins une deuxième électrode de rétroaction interne (RE2, RE4) d'entre elles s'étendant dans le sens de la profondeur négative (Z) depuis la face arrière (2) jusqu'à une distance par rapport à la face avant (1).

4. Dispositif actionneur (AV) selon la revendication 3, dans lequel les électrodes de rétroaction internes (RE1, RE2, RE3, RE4) disposées dans le corps de rétroaction (21) sont réalisées, concernant le nombre, la forme et la position, de la même façon que les électrodes d'actionnement internes (E1, E2, E3, E4) disposées dans les actionneurs (11, 12, 13).

5. Dispositif actionneur (AV) selon l'une des revendications précédentes, dans lequel la couche de face arrière (4) dans la zone du corps de base (10a) du corps principal (10) présente une plus grande épaisseur (dv) dans le sens de la profondeur (Z) que dans la zone du corps de montage (10b).

6. Dispositif actionneur (AV) selon l'une des revendications précédentes, dans lequel le corps principal (10) forme un corps monolithique avec le corps de base (10a) et le corps de montage (10b), qui est formé par les corps d'actionneur (11a, 12a, 13a) formant les actionneurs (11, 12, 13).

7. Dispositif actionneur (AV) selon l'une des revendications 1 à 5, dans lequel le corps de base (10a) et le corps de montage (10b) du corps principal (10) sont respectivement réalisés en tant que corps partiel propre.

8. Dispositif actionneur (AV) selon la revendication 7, dans lequel le corps de base (10a) et le corps de montage (10b) sont fabriqués en des matériaux respectivement différents et le corps de base (10a) étant fabriqué en un matériau qui n'est pas piézoélectrique ou électrostrictif.

9. Dispositif actionneur (AV) selon la revendication 7 ou 8, dans lequel le corps de base (10a) et le corps de montage (10b) sont collés ensemble.

10. Dispositif actionneur (AV) selon l'une des revendications précédentes, dans lequel la couche de face arrière (4) et la couche de liaison de rétroaction (5) forment ensemble une couche d'un seul tenant.

11. Dispositif actionneur (AV) selon l'une des revendications précédentes, dans lequel au moins une électrode d'adaptation de contraction lamellaire (80, 90) est située dans le corps de base (10a), dans lequel au moins une électrode d'adaptation de contraction (80, 90) est située dans le corps de base (10a) de manière à ce qu'une partie de bord de celle-ci se situe dans chacune des deux surfaces de partie de rétroaction (26a, 26a-2) afin de compenser un comportement local de contraction du corps de base (10a) lors de la fabrication de celui-ci.

12. Dispositif actionneur (AV) selon la revendication 11, dans lequel l'électrode d'adaptation de contraction (80, 90) reposant contre la surface de partie de rétroaction (26a, 26a-2) s'étend depuis la face arrière (2) jusque dans la zone de la pièce de raccordement (23) lorsque vue dans le sens de la profondeur (Z).

13. Dispositif actionneur (AV) selon l'une des revendications 11 ou 12, dans lequel la surface de partie de rétroaction (26a) est revêtue d'une partie de couche de face frontale (24).
